(19) **Europäisches Patentamt European Patent Office Office européen des brevets**

(11) **EP 3 483 616 B1**

(12) **EUROPEAN PATENT SPECIFICATION**

(45) Date of publication and mention of the grant of the patent:
**22.09.2021 Bulletin 2021/38**

(51) Int Cl.:
*G01R 31/08* (2020.01)     *G01R 31/52* (2020.01)
*G01R 31/67* (2020.01)

(21) Application number: **17838335.2**

(86) International application number:
**PCT/CN2017/076988**

(22) Date of filing: **16.03.2017**

(87) International publication number:
**WO 2018/028202 (15.02.2018 Gazette 2018/07)**

(54) **DETECTION CIRCUIT AND DETECTION METHOD**

DETEKTIONSSCHALTUNG UND DETEKTIONSVERFAHREN

CIRCUIT ET PROCÉDÉ DE DÉTECTION

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **09.08.2016 CN 201610654020**

(43) Date of publication of application:
**15.05.2019 Bulletin 2019/20**

(73) Proprietor: **Huawei Technologies Co., Ltd. Longgang District Shenzhen, Guangdong 518129 (CN)**

(72) Inventors:
• **ZHANG, Chen**
  **Shenzhen**
  **Guangdong 518129 (CN)**
• **SHI, Yingchun**
  **Shenzhen**
  **Guangdong 518129 (CN)**
• **XING, Haiding**
  **Shenzhen**
  **Guangdong 518129 (CN)**
• **ZHANG, Guoqing**
  **Shenzhen**
  **Guangdong 518129 (CN)**
• **ZHANG, Jianbin**
  **Shenzhen**
  **Guangdong 518129 (CN)**

(74) Representative: **Gill Jennings & Every LLP The Broadgate Tower 20 Primrose Street London EC2A 2ES (GB)**

(56) References cited:
**CN-A- 1 851 484      CN-A- 1 851 484**
**CN-A- 101 183 144    CN-A- 101 419 265**
**US-A1- 2007 223 155  US-A1- 2011 121 780**
**US-A1- 2012 257 314  US-A1- 2015 226 779**

**Description**

**TECHNICAL FIELD**

The present invention relates to the field of electronic technologies, and in particular, to a detection circuit and a detection method.

**BACKGROUND**

Generally, electrical energy used by a device is provided by a power distribution system, and the power distribution system may include an IT system, a TT system, and a TN system. A voltage of any live wire with respect to the earth in the power distribution system exceeds a safety extra-low voltage (Safety Extra-Low Voltage, SELV). Therefore, when the device is running, if a metal core wire in the live wire comes into contact with a device housing of the device because of, for example, an insulation skin pierced by an overvoltage, aging of an insulation skin, or a damage to an insulation skin, a hazardous voltage is applied to the device housing, thereby causing a huge threat to a user's personal safety. Therefore, in order to allow the user to learn whether the hazardous voltage is applied to the device housing, live detection on the device housing may be performed.

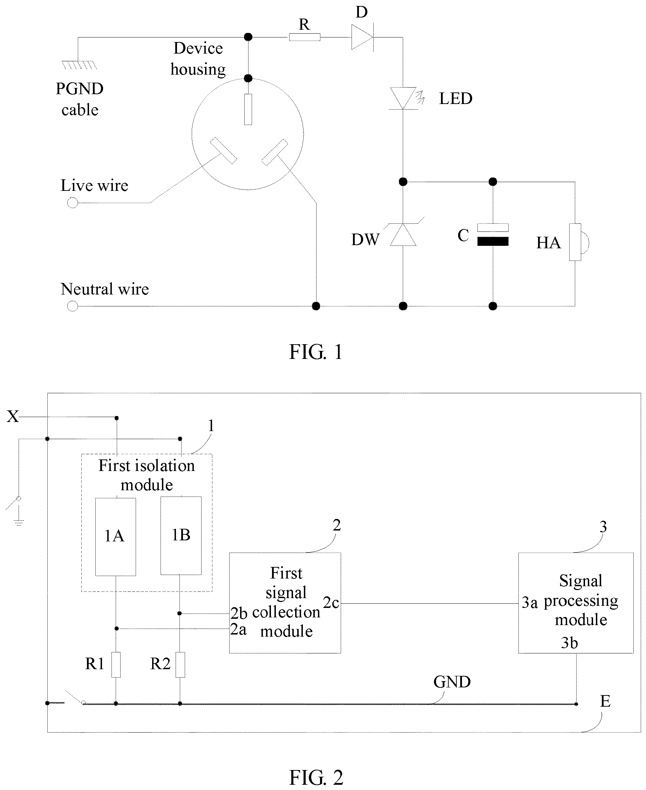

Currently, a detection circuit is provided. As shown in FIG. 1, the detection circuit includes a resistor R, a silicon rectifier diode D, a light emitting diode LED, a Zener diode DW, an electrolytic capacitor C, and a buzzer HA. An end of the resistor R is connected to the device housing of the device, the other end of the resistor R is connected to a positive electrode of the silicon rectifier diode D, a negative electrode of the silicon rectifier diode D is connected to a positive electrode of the light emitting diode LED, a negative electrode of the light emitting diode LED is connected to a negative electrode of the Zener diode DW, a positive electrode of the Zener diode DW is connected to a neutral wire, and the electrolytic capacitor C and the buzzer HA are separately connected in parallel to the Zener diode DW.

When detection is performed by using the detection circuit, if the metal core wire in the live wire is in contact with the device housing and consequently, the device housing is energized, in this case, the live wire, the device housing, the detection circuit, and the neutral wire form a current loop. When a current in the live wire flows through the detection circuit via the device housing, the light emitting diode LED is lit, and the buzzer HA sounds, thereby achieving an energized alarm for the device housing.

In the prior art, at least the following disadvantages exist: When the live wire and the neutral wire connected to the device are inversely connected, if the metal core wire in the live wire is in contact with the device housing and consequently, the device housing is energized, in this case, the current in the live wire flows through the detection circuit via the device housing and then flows back to the live wire. In other words, in this case, the live wire, the device housing, the detection circuit, and the neutral wire cannot form a current loop. Consequently, an energized alarm for the device housing cannot be effectively generated.

Prior art detection circuits are known from US2007/223155A1, US2015/226779A1, and CN1851484A.

**SUMMARY**

To resolve a problem of a related technology, embodiments of the present invention provide a detection circuit and a detection method. The technical solutions are as follows.

According to a first aspect, a detection circuit is provided, where the detection circuit is configured to detect a device, and the detection circuit includes a first isolation module, a first resistor, a second resistor, a first signal collection module, and a signal processing module;

the first isolation module includes a first isolation unit and a second isolation unit, and a resistance value of the first isolation unit is equal to that of the second isolation unit; an end of the first isolation unit is connected to a target wire, and an end of the second isolation unit is connected to a device housing; the first isolation module is configured to isolate the target wire from the device housing, and is configured to isolate a primary circuit from a secondary circuit, where the primary circuit includes the target wire and a power supply of the device, and the secondary circuit includes the first resistor, the second resistor, the first signal collection module, and the signal processing module; and the target wire is configured to supply power to the device, the target wire is a live wire or a neutral wire, and the device housing is a housing of the device;

a first input end of the first signal collection module and an end of the first resistor are separately connected to the other end of the first isolation unit, a second input end of the first signal collection module and an end of the second resistor are separately connected to the other end of the second isolation unit, the other end of the first resistor and the other end of the second resistor are separately connected to a reference ground, an output end of the first signal collection module is connected to an input end of the signal processing module, and a grounding end of the signal processing module is connected to the reference ground;

the first resistor and the second resistor are configured to divide a voltage, and a resistance value of the first resistor is equal to that of the second resistor; the first signal collection module is configured to separately collect a voltage at both ends of the first resistor and a voltage at both ends of the second resistor, determine the collected voltage at both ends of the first resistor as a first voltage, determine the collected voltage at both ends of the second resistor as a second voltage, and multiply a voltage difference between the first voltage and the second voltage by a specified proportion, to obtain a third voltage within a detection range of the signal processing module, and input the third voltage to the signal processing module; and

the signal processing module is configured to: perform reverse processing on the third voltage based on a process of processing a voltage between the target wire and the device housing by the first isolation module, the first resistor, the second resistor, and the first signal collection module, to obtain the voltage between the target wire and the device housing; and when the voltage between the target wire and the device housing satisfies a specified condition, determine that a fault occurs in the device, where the specified condition is used to indicate that the fault occurs in the device, and the fault includes at least one of the following: the live wire and the neutral wire connected to the device are inversely connected, the device housing is not normally grounded, and the device housing is energized.

It should be noted that, the voltage between the target wire and the device housing is obtained based on the third voltage, and the third voltage is obtained by multiplying the voltage difference between the first voltage and the second voltage by the specified proportion. Therefore, the voltage between the target wire and the device housing is actually obtained based on the first voltage and the second voltage. In addition, the first voltage and the second voltage are obtained with respect to the reference ground. Therefore, whether the reference ground is connected or not connected to the device housing does not affect determining the voltage between the target wire and the device housing. In other words, in this embodiment of the present invention, fault detection on the device can be implemented regardless of whether the reference ground is connected or not connected to the device housing.

In this embodiment of the present invention, the first signal collection module may collect the first voltage and the second voltage, and multiply the voltage difference between the first voltage and the second voltage by the specified proportion, to obtain the third voltage within the detection range of the signal processing module. Then the third voltage is input to the signal processing module. The signal processing module may perform reverse processing on the third voltage based on the process of processing a voltage between the target wire and the device housing by the first isolation module, the first resistor, the second resistor, and the first signal collection module, to obtain the voltage between the target wire and the device housing; and when the voltage between the target wire and the device housing satisfies the specified condition, determine that a fault occurs in the device. The target wire may be either a live wire or a neutral wire. Therefore, fault detection can be performed regardless of whether the live wire and the neutral wire connected to the device are correctly connected or inversely connected.

With reference to the first aspect, in a first possible implementation of the first aspect, the detection circuit further includes a signal conditioning module, an input end of the signal conditioning module is connected to the output end of the first signal collection module, and an output end of the signal conditioning module is connected to the input end of the signal processing module; and

the signal conditioning module is configured to condition the third voltage received from the first signal collection module to a voltage within an acceptable range of the signal processing module, and input the conditioned third voltage to the signal processing module.

With reference to the first aspect or the first possible implementation of the first aspect, in a second possible implementation of the first aspect, the first isolation unit includes N resistors in series, and a total resistance value of the N resistors in series is greater than or equal to a specified resistance value, where N is a natural number greater than or equal to 1, and the specified resistance value is a resistance value that satisfies reinforced insulation required by a security standard.

It should be noted that, insulation resistors between the target wire and the device housing include the first resistor, the second resistor, the first isolation unit, and the second isolation unit, and the resistance value of the first isolation unit is equal to that of the second isolation unit. Therefore, when the total resistance value of the N resistors in series included by the first isolation unit is greater than or equal to the specified resistance value, it can be ensured that the insulation resistors between the target wire and the device housing satisfy the reinforced insulation required by the security standard, thereby ensuring electrical safety of a user.

In addition, the primary circuit and the secondary circuit are isolated by the first isolation module, and the resistance value of the first isolation unit is equal to that of the second isolation unit. Therefore, when the total resistance value of the N resistors in series included by the first isolation unit is greater than or equal to the specified resistance value, it can be ensured that isolation between the primary circuit and the secondary circuit satisfies the reinforced insulation required by the security standard, thereby ensuring that an electronic element in the secondary circuit is not damaged by a high voltage in the primary circuit.

With reference to the first aspect or the first possible implementation of the first aspect, in a third possible implementation of the first aspect, the second isolation unit includes M resistors in series, and a total resistance value of the M resistors in series is greater than or equal to the specified resistance value, where M is a natural number greater than or equal to 1, and the specified resistance value is a resistance value that satisfies reinforced insulation required by the security standard.

It should be noted that, insulation resistors between the target wire and the device housing include the first resistor, the second resistor, the first isolation unit, and the second isolation unit, and the resistance value of the first isolation unit is equal to that of the second isolation unit. Therefore, when the total resistance value of the M resistors in series included by the second isolation unit is greater than or equal to the specified resistance value, it can be ensured that the insulation resistors between the target wire and the device housing satisfy the reinforced insulation required by the security standard, thereby ensuring electrical safety of a user.

In addition, the primary circuit and the secondary circuit are isolated by the first isolation module, and the resistance value of the first isolation unit is equal to that of the second isolation unit. Therefore, when the total resistance value of the M resistors in series included by the second isolation unit is greater than or equal to the specified resistance value, it can be ensured that isolation between the primary circuit and the secondary circuit satisfies the reinforced insulation required by the security standard, thereby ensuring that an electronic element in the secondary circuit is not damaged by a high voltage in the primary circuit.

With reference to the first aspect, in a fourth possible implementation of the first aspect, the signal processing module is configured to:

when a power supply mode of the device is a single-phase power supply, and a metal core wire in the live wire is not in contact with the device housing, determine whether the voltage between the target wire and the device housing is less than or equal to a first specified voltage, where the first specified voltage is a voltage between the neutral wire and the device housing when the device housing is normally grounded and the metal core wire in the live wire is not in contact with the device housing; and

when the voltage between the target wire and the device housing is less than or equal to the first specified voltage, determine that the live wire and the neutral wire connected to the device are inversely connected, and determine that the voltage between the target wire and the device housing satisfies the specified condition.

It should be noted that the first specified voltage is close to 0 V (volt). In actual application, the first specified voltage may be a smaller one between a first preset voltage and a second preset voltage. The first preset voltage may be an average of voltages between the neutral wire and the device housing that are measured for a plurality of times when the device housing is normally grounded and the metal core wire in the live wire is not in contact with the device housing. The second preset voltage may be a product of a preset value and a supply voltage of a device, and the preset value may be set in advance. For example, the preset value may be greater than 0.01 and less than 0.1. This is not specifically limited in this embodiment of the present invention. In addition, because the first specified voltage may be set based on the first preset voltage and the second preset voltage, the first specified voltage may be flexibly selected based on different electricity scenarios in this embodiment of the present invention, to ensure that the first specified voltage satisfies a detection requirement.

In this embodiment of the present invention, the signal processing module may rapidly and accurately determine, based on the first specified voltage, whether the live wire and the neutral wire connected to the device are inversely connected. This determining process is relatively simple, and determining efficiency is relatively high.

With reference to the first aspect, in a fifth possible implementation of the first aspect, the signal processing module is configured to:

when the power supply mode of the device is a single-phase power supply, and a metal core wire in the live wire is not in contact with the device housing, determine whether the voltage between the target wire and the device housing is greater than a first specified voltage and less than a second specified voltage, where the second specified voltage is equal to a supply voltage of the device minus the first specified voltage, and the first specified voltage is less than the second specified voltage; and

when the voltage between the target wire and the device housing is greater than the first specified voltage and less than the second specified voltage, determine that the device housing is not normally grounded, and determine that the voltage between the target wire and the device housing satisfies the specified condition.

In this embodiment of the present invention, it can be rapidly and accurately determined, based on the first specified voltage and the second specified voltage, whether the device housing is not normally grounded. This determining process is relatively simple, and determining efficiency is relatively high.

With reference to the first aspect, in a sixth possible implementation of the first aspect, the signal processing module is configured to:

when the power supply mode of the device is a single-phase power supply, and the target wire is the live wire, determine whether the voltage between the target wire and the device housing is a first contacting voltage, where the first contacting voltage is a voltage between the target wire and the device housing when a metal core wire in the target wire is in contact with the device housing; and when the voltage between the target wire and the device housing is the first contacting voltage, determine that the device housing is energized, and determine that the voltage between the target wire and the device housing satisfies the specified condition; or

when a power supply mode of the device is a single-phase power supply, and the target wire is the neutral wire, determine whether the voltage between the target wire and the device housing is a second contacting voltage, where the second contacting voltage is a voltage between the target wire and the device housing when a metal core wire in the live wire different from the target wire is in contact with the device housing; and when the voltage between the target wire and the device housing is the second contacting voltage, determine that the device housing is energized, and determine that the voltage between the target wire and the device housing satisfies the specified condition.

In this embodiment of the present invention, when the power supply mode of the device is the single-phase power supply, if the target wire is the live wire, it can be determined, based on the first contacting voltage, whether the device housing is energized; or if the target wire is the neutral wire, it can be determined, based on the second contacting voltage, whether the device housing is energized, so that live detection on the device housing can be accurately implemented. This detection operation is simple and easy, and detection efficiency is relatively high.

With reference to the sixth possible implementation of the first aspect, in a seventh possible implementation of the first aspect, the signal processing module is further configured to:

when the metal core wire in the live wire is not in contact with the device housing, if the voltage between the target wire and the device housing is less than or equal to the first specified voltage, determine that the target wire is the neutral wire; or

when the metal core wire in the live wire is not in contact with the device housing, if the voltage between the target wire and the device housing is greater than or equal to a second specified voltage, determine that the target wire is the live wire.

It should be noted that the foregoing process of determining whether the target wire is the live wire or the neutral wire is a process of determining whether the live wire and the neutral wire connected to the device are correctly connected or inversely connected. In other words, when the target wire is the live wire, it may be determined that the live wire and the neutral wire connected to the device are correctly connected; or when the target wire is the neutral wire, it may be determined that the live wire and the neutral wire connected to the device are inversely connected.

In this embodiment of the present invention, it can be rapidly and accurately determined, based on the first specified voltage and the second specified voltage, whether the target wire is the live wire or the neutral wire. This determining process is relatively simple, and determining efficiency is relatively high.

With reference to the first aspect, in an eighth possible implementation of the first aspect, the signal processing module is configured to:

when a power supply mode of the device is a dual-live-wire power supply, determine whether the voltage between the target wire and the device housing is a first contacting voltage or a second contacting voltage; and

when the voltage between the target wire and the device housing is the first contacting voltage or the second contacting voltage, determine that the device housing is energized, and determine that the voltage between the target wire and the device housing satisfies the specified condition.

In this embodiment of the present invention, when the power supply mode of the device is the dual-live-wire power supply, it can be determined, based on the first contacting voltage and the second contacting voltage, whether the device housing is energized, so that live detection on the device housing can be accurately implemented. This detection operation is simple and easy, and detection efficiency is relatively high.

With reference to the first aspect, in a ninth possible implementation of the first aspect, the signal processing module is configured to:

when a power supply mode of the device is a three-phase power supply, determine whether the voltage between the target wire and the device housing is a first contacting voltage or a third contacting voltage, where the third contacting voltage is a voltage between the target wire and the device housing when a metal core wire in any live wire different from the target wire is in contact with the device housing; and

when the voltage between the target wire and the device housing is the first contacting voltage or the third contacting voltage, determine that the device housing is energized, and determine that the voltage between the target wire and the device housing satisfies the specified condition.

In this embodiment of the present invention, when the power supply mode of the device is the three-phase power supply, it can be determined, based on the first contacting voltage and the third contacting voltage, whether the device housing is energized, so that live detection on the device housing can be accurately implemented. This detection operation is simple and easy, and detection efficiency is relatively high.

With reference to the first aspect, in a tenth possible implementation of the first aspect, the signal processing module is further configured to:

when the power supply mode of the device is a single-phase power supply, and a metal core wire in the live wire is not in contact with the device housing, determine whether the voltage between the target wire and the device housing is less than or equal to the first specified voltage, or greater than or equal to a second specified voltage; and

when the voltage between the target wire and the device housing is less than or equal to the first specified voltage, or greater than or equal to the second specified voltage, determine that the device housing is normally grounded.

In this embodiment of the present invention, it can rapidly and accurately determined, based on the first specified voltage and the second specified voltage, whether the device housing is normally grounded. This determining process is relatively simple, and determining efficiency is relatively high.

With reference to the first aspect, in another possible implementation of the first aspect, the signal collection module includes a first operational amplifier, a second operational amplifier, a third operational amplifier, a third resistor, a fourth resistor, a fifth resistor, and a sixth resistor;

a non-inverting input end of the first operational amplifier and an end of the first resistor are separately connected to the other end of the first isolation unit, and an inverting input end of the first operational amplifier and an end of the third resistor are separately connected to an output end of the first operational amplifier;

a non-inverting input end of the second operational amplifier and an end of the second resistor are separately connected to the other end of the second isolation unit, and an inverting input end of the second operational amplifier and an end of the fourth resistor are separately connected to an output end of the second operational amplifier; and

a non-inverting input end of the third operational amplifier is connected to the other end of the third resistor, the non-inverting input end of the third operational amplifier is further connected to an end of the fifth resistor, the other end of the fifth resistor is connected to the reference ground, an inverting input end of the third operational amplifier is connected to the other end of the fourth resistor, an inverting input end of the third operational amplifier is further connected to an end of the sixth resistor, and the other end of the sixth resistor and an input end of a signal conditioning module are separately connected to an output end of the third operational amplifier.

In this embodiment of the present invention, the first operational amplifier, the second operational amplifier, and the third operational amplifier form a differential amplification circuit. Specifically, the first operational amplifier is configured to collect the voltage at both ends of the first resistor, the second operational amplifier is configured to collect the voltage at both ends of the second resistor, and the third operational amplifier is configured to determine the third voltage based on the voltage difference between the first voltage and the second voltage.

With reference to the first aspect, in another possible implementation of the first aspect, the signal conditioning module includes a seventh resistor, an eighth resistor, a conditioning power supply, a first diode, and a second diode; and an end of the seventh resistor is connected to the output end of the first signal collection module, an end of the eighth resistor, a positive electrode of the first diode, a negative electrode of the second diode, and the input end of the signal processing module are separately connected to the other end of the seventh resistor, the other end of the eighth resistor and a negative electrode of the first diode are separately connected to the conditioning power supply, and a positive electrode of the second diode is connected to the reference ground.

In this embodiment of the present invention, the signal conditioning module may increase the third voltage by a conditioning voltage of $\dfrac{r_8}{r_7 + r_8}$ times by using the conditioning power supply, the seventh resistor, and the eighth resistor, and may further restrain an increased third voltage within a range between $U_{cc}+U_d$ and $-U_d$ by using the conditioning power supply, the first diode, and the second diode after the third voltage is increased by the conditioning

voltage of $\dfrac{r_8}{r_7 + r_8}$ times, to condition the third voltage to a voltage within an acceptable range of the signal processing module, thereby ensuring that an electronic element in the signal processing module is not damaged by an overvoltage or a negative voltage.

$r_7$ is a resistance value of the seventh resistor, $r_8$ is a resistance value of the eighth resistor, $U_{cc}$ is a conditioning voltage, the conditioning voltage is an output voltage of the conditioning power supply, Ud is a breakover voltage of the first diode or the second diode, and the breakover voltage of the first diode is equal to that of the second diode.

With reference to the first aspect, in another possible implementation of the first aspect, the signal processing module includes an analog-to-digital converter and a controller; and

an input end of the analog-to-digital converter is connected to the output end of the signal conditioning module, an output end of the analog-to-digital converter is connected to an input end of the controller, and a grounding end of the module converter and a grounding end of the controller are separately connected to the reference ground.

In this embodiment of the present invention, the analog-to-digital converter is configured to convert a received analog parameter of the third voltage into a digital parameter, and send the digital parameter of the third voltage to the controller. The controller is configured to determine the voltage between the target wire and the device housing based on the third voltage.

According to a second aspect, a detection circuit is provided, where the detection circuit is configured to detect a device, and the detection circuit includes a second isolation module, a tenth resistor, a second signal collection module, and a signal processing module; and

an end of the second isolation module is connected to a target wire, an input end of the second signal collection module and an end of the tenth resistor are separately connected to the other end of the second isolation module, the other end of the tenth resistor is connected to a reference ground, the reference ground is connected to a device housing, an output end of the second signal collection module is connected to an input end of the signal processing module, and a grounding end of the signal processing module is connected to the reference ground; and

the target wire is configured to supply power to the device, the target wire is a live wire or a neutral wire, and the device housing is a housing of the device; the tenth resistor is configured to divide a voltage, the second isolation module is configured to isolate the target wire from the device housing, and is configured to isolate a primary circuit from a secondary circuit, where the primary circuit includes the target wire and a power supply of the device, and the secondary circuit includes the tenth resistor, the second signal collection module, and the signal processing module; and the second signal collection module is configured to collect a voltage at both ends of the tenth resistor, determine the collected voltage at both ends of the tenth resistor as a fourth voltage, and input the fourth voltage to the signal processing module; and

the signal processing module is configured to: perform reverse processing on the fourth voltage based on a process of processing a voltage between the target wire and the device housing by the second isolation module, the tenth resistor, and the second signal collection module, to obtain the voltage between the target wire and the device housing; and when the voltage between the target wire and the device housing satisfies a specified condition, determine that a fault occurs in the device, where the specified condition is used to indicate that the fault occurs in the device, and the fault includes at least one of the following: the live wire and the neutral wire connected to the device are inversely connected, the device housing is not normally grounded, and the device housing is energized.

In this embodiment of the present invention, the second signal collection module may collect the fourth voltage, and input the fourth voltage to the signal processing module. The signal processing module may perform reverse processing on the fourth voltage based on the process of processing a voltage between the target wire and the device housing by the second isolation module, the tenth resistor, and the second signal collection module, to obtain the voltage between the target wire and the device housing; and when the voltage between the target wire and the device housing satisfies the specified condition, determine that a fault occurs in the device. The target wire may be either a live wire or a neutral wire. Therefore, fault detection can be performed regardless of whether the live wire and the neutral wire connected to the device are correctly connected or inversely connected.

With reference to the second aspect, the detection circuit further includes a signal conditioning module, an input end of the signal conditioning module is connected to the output end of the second signal collection module, and an output end of the signal conditioning module is connected to the input end of the signal processing module; and

the signal conditioning module is configured to condition the fourth voltage received by the second signal collection module to a voltage within an acceptable range of the signal processing module, and input the conditioned fourth voltage to the signal processing module.

With reference to the second aspect or the first possible implementation of the second aspect, in a second possible implementation of the second aspect, the second isolation module includes N resistors in series, and a total resistance value of the N resistors in series is greater than or equal to a specified resistance value, where N is a natural number greater than or equal to 1, and the specified resistance value is a resistance value that satisfies reinforced insulation required by a security standard.

It should be noted that, insulation resistors between the target wire and the device housing include the tenth resistor and the second isolation module. Therefore, when the total resistance value of the N resistors in series included by the second isolation module is greater than or equal to the specified resistance value, it can be ensured that the insulation resistors between the target wire and the device housing satisfy the reinforced insulation required by the security standard, thereby ensuring electrical safety of a user.

In addition, because the primary circuit and the secondary circuit are isolated by the second isolation module, when the total resistance value of the M resistors in series included by the second isolation unit is greater than or equal to the specified resistance value, it can be ensured that isolation between the primary circuit and the secondary circuit satisfies the reinforced insulation required by the security standard, thereby ensuring that an electronic element in the secondary circuit is not damaged by a high voltage in the primary circuit.

With reference to the second aspect, in a third possible implementation of the second aspect, the signal processing module is configured to:

when a power supply mode of the device is a single-phase power supply, and a metal core wire in the live wire is not in contact with the device housing, determine whether the voltage between the target wire and the device housing is less than or equal to a first specified voltage, where the first specified voltage is a voltage between the neutral wire and the device housing when the device housing is normally grounded and the metal core wire in the live wire is not in contact with the device housing; and

when the voltage between the target wire and the device housing is less than or equal to the first specified voltage, determine that the live wire and the neutral wire connected to the device are inversely connected, and determine that the voltage between the target wire and the device housing satisfies the specified condition.

With reference to the second aspect, in a fourth possible implementation of the second aspect, the signal processing module is configured to:

when a power supply mode of the device is a single-phase power supply, and a metal core wire in the live wire is not in contact with the device housing, determine whether the voltage between the target wire and the device housing is greater than a first specified voltage and less than a second specified voltage, where the second specified voltage is equal to a supply voltage of the device minus the first specified voltage, and the first specified voltage is less than the second specified voltage; and

when the voltage between the target wire and the device housing is greater than the first specified voltage and less than the second specified voltage, determine that the device housing is not normally grounded, and determine that the voltage between the target wire and the device housing satisfies the specified condition.

With reference to the second aspect, in a fifth possible implementation of the second aspect, the signal processing module is configured to:

when a power supply mode of the device is a single-phase power supply, and the target wire is the live wire, determine whether the voltage between the target wire and the device housing is a first contacting voltage, where the first contacting voltage is a voltage between the target wire and the device housing when the metal core wire in the target wire is in contact with the device housing; and when the voltage between the target wire and the device housing is the first contacting voltage, determine that the device housing is energized, and determine that the voltage between the target wire and the device housing satisfies the specified condition; or

when a power supply mode of the device is a single-phase power supply, and the target wire is the neutral wire, determine whether the voltage between the target wire and the device housing is a second contacting voltage, where the second contacting voltage is a voltage between the target wire and the device housing when the metal core wire in the live wire different from the target wire is in contact with the device housing; and when the voltage between the target wire and the device housing is the second contacting voltage, determine that the device housing is energized, and determine that the voltage between the target wire and the device housing satisfies the specified condition.

With reference to the fifth possible implementation of the second aspect, in a sixth possible implementation of the second aspect, the signal processing module is further configured to:

when the metal core wire in the live wire is not in contact with the device housing, if the voltage between the target wire and the device housing is less than or equal to a first specified voltage, determine that the target wire is the neutral wire; or

when the metal core wire in the live wire is not in contact with the device housing, if the voltage between the target wire and the device housing is greater than or equal to a second specified voltage, determine that the target wire is the live wire.

With reference to the second aspect, in a seventh possible implementation of the second aspect, the signal processing module is configured to:

when a power supply mode of the device is a dual-live-wire power supply, determine whether the voltage between the target wire and the device housing is a first contacting voltage or a second contacting voltage; and
when the voltage between the target wire and the device housing is the first contacting voltage or the second contacting voltage, determine that the device housing is energized, and determine that the voltage between the target wire and the device housing satisfies the specified condition.

With reference to the second aspect, in an eighth possible implementation of the second aspect, the signal processing module is configured to:

when a power supply mode of the device is a three-phase power supply, determine whether the voltage between the target wire and the device housing is a first contacting voltage or a third contacting voltage, where the third contacting voltage is a voltage between the target wire and the device housing when a metal core wire in any live wire different from the target wire is in contact with the device housing; and
when the voltage between the target wire and the device housing is the first contacting voltage or the third contacting voltage, determine that the device housing is energized, and determine that the voltage between the target wire and the device housing satisfies the specified condition.

With reference to the second aspect, in a ninth possible implementation of the second aspect, the signal processing module is further configured to:

when a power supply mode of the device is a single-phase power supply, and a metal core wire in the live wire is not in contact with the device housing, determine whether the voltage between the target wire and the device housing is less than or equal to a first specified voltage, or greater than or equal to a second specified voltage; and
when the voltage between the target wire and the device housing is less than or equal to the first specified voltage, or greater than or equal to the second specified voltage, determine that the device housing is normally grounded.

With reference to the second aspect, in another possible implementation of the second aspect, the second signal collection module includes a fourth operational amplifier.
A non-inverting input end of the fourth operational amplifier and an end of the tenth resistor are separately connected to the other end of the second isolation module, and an inverting input end of the fourth operational amplifier and an output end of the fourth operational amplifier are separately connected to an input end of the signal conditioning module. The fourth operational amplifier is configured to collect the voltage at both ends of the tenth resistor.
With reference to the second aspect, in another possible implementation of the second aspect, the signal conditioning module includes a seventh resistor, an eighth resistor, a conditioning power supply, a first diode, and a second diode; and
an end of the seventh resistor is connected to the output end of the second signal collection module, an end of the eighth resistor, a positive electrode of the first diode, a negative electrode of the second diode, and the input end of the signal processing module are separately connected to the other end of the seventh resistor, the other end of the eighth resistor and a negative electrode of the first diode are separately connected to the conditioning power supply, and a positive electrode of the second diode is connected to the reference ground.
With reference to the second aspect, in another possible implementation of the second aspect, the signal processing module includes an analog-to-digital converter and a controller; and
an input end of the analog-to-digital converter is connected to an output end of the signal conditioning module, an output end of the analog-to-digital converter is connected to an input end of the controller, and a grounding end of the module converter and a grounding end of the controller are separately connected to the reference ground.
According to a third aspect, a detection method is provided, where the method is configured to detect a device, and the method includes:

determining a voltage between a target wire and a device housing, where the target wire is configured to supply power to the device, the target wire is a live wire or a neutral wire, and the device housing is a housing of the device; determining whether the voltage between the target wire and the device housing satisfies a specified condition, where the specified condition is used to indicate that a fault occurs in the device, and the fault includes at least one of the following: the live wire and the neutral wire connected to the device are inversely connected, the device housing is not normally grounded, and the device housing is energized; and when the voltage between the target wire and the device housing satisfies the specified condition, determining that the fault occurs in the device.

In this embodiment of the present invention, the voltage between the target wire and the device housing is determined, and it is determined whether the voltage between the target wire and the device housing satisfies the specified condition. When the voltage between the target wire and the device housing satisfies the specified condition, it is determined that the fault occurs in the device. The target wire may be either a live wire or a neutral wire. Therefore, fault detection can be performed regardless of whether the live wire and the neutral wire connected to the device are correctly connected or inversely connected.

With reference to the third aspect, in a first possible implementation of the third aspect, the determining whether the voltage between the target wire and the device housing satisfies a specified condition includes:

when a power supply mode of the device is a single-phase power supply, and a metal core wire in the live wire is not in contact with the device housing, determining whether the voltage between the target wire and the device housing is less than or equal to a first specified voltage, where the first specified voltage is a voltage between the neutral wire and the device housing when the device housing is normally grounded and the metal core wire in the live wire is not in contact with the device housing; and

when the voltage between the target wire and the device housing is less than or equal to the first specified voltage, determining that the live wire and the neutral wire connected to the device are inversely connected, and determining that the voltage between the target wire and the device housing satisfies the specified condition.

With reference to the third aspect, in a second implementation of the third aspect as claimed, the determining whether the voltage between the target wire and the device housing satisfies a specified condition includes:

when the power supply mode of the device is a single-phase power supply, and a metal core wire in the live wire is not in contact with the device housing, determining whether the voltage between the target wire and the device housing is greater than a first specified voltage and less than a second specified voltage, where the second specified voltage is equal to a supply voltage of the device minus the first specified voltage, and the first specified voltage is less than the second specified voltage; and

when the voltage between the target wire and the device housing is greater than the first specified voltage and less than the second specified voltage, determining that the device housing is not normally grounded, and determining that the voltage between the target wire and the device housing satisfies the specified condition.

With reference to the third aspect, in a third possible implementation of the third aspect, the determining whether the voltage between the target wire and the device housing satisfies a specified condition includes:

when a power supply mode of the device is a single-phase power supply, and the target wire is the live wire, determining whether the voltage between the target wire and the device housing is a first contacting voltage, where the first contacting voltage is a voltage between the target wire and the device housing when the metal core wire in the target wire is in contact with the device housing; and when the voltage between the target wire and the device housing is the first contacting voltage, determining that the device housing is energized, and determining that the voltage between the target wire and the device housing satisfies the specified condition; or

when a power supply mode of the device is a single-phase power supply, and the target wire is the neutral wire, determining whether the voltage between the target wire and the device housing is a second contacting voltage, where the second contacting voltage is a voltage between the target wire and the device housing when the metal core wire in the live wire different from the target wire is in contact with the device housing; and when the voltage between the target wire and the device housing is the second contacting voltage, determining that the device housing is energized, and determining that the voltage between the target wire and the device housing satisfies the specified condition.

With reference to the third possible implementation of the third aspect, in a fourth possible implementation of the third aspect, before the determining whether the voltage between the target wire and the device housing satisfies a specified condition, the method further includes:

when the metal core wire in the live wire is not in contact with the device housing, if the voltage between the target wire and the device housing is less than or equal to the first specified voltage, determining that the target wire is the neutral wire; or

when the metal core wire in the live wire is not in contact with the device housing, if the voltage between the target wire and the device housing is greater than or equal to the second specified voltage, determining that the target wire is the live wire.

With reference to the third aspect, in a fifth possible implementation of the third aspect, the determining whether the voltage between the target wire and the device housing satisfies a specified condition includes:

when a power supply mode of the device is a dual-live-wire power supply, determining whether the voltage between the target wire and the device housing is a first contacting voltage or a second contacting voltage; and

when the voltage between the target wire and the device housing is the first contacting voltage or the second contacting voltage, determining that the device housing is energized, and determining that the voltage between the target wire and the device housing satisfies the specified condition.

With reference to the third aspect, in a sixth possible implementation of the third aspect, the determining whether the voltage between the target wire and the device housing satisfies a specified condition includes:

when a power supply mode of the device is a three-phase power supply, determining whether the voltage between the target wire and the device housing is a first contacting voltage or a third contacting voltage, where the third contacting voltage is a voltage between the target wire and the device housing when a metal core wire in any live wire different from the target wire is in contact with the device housing; and

when the voltage between the target wire and the device housing is the first contacting voltage or the third contacting voltage, determining that the device housing is energized, and determining that the voltage between the target wire and the device housing satisfies the specified condition.

With reference to any one of the third aspect, or the first to the sixth possible implementations of the third aspect, in a seventh possible implementation of the third aspect, the method further includes:

when the power supply mode of the device is the single-phase power supply, and the metal core wire in the live wire is not in contact with the device housing, determining whether the voltage between the target wire and the device housing is less than or equal to the first specified voltage, or greater than or equal to the second specified voltage; and

when the voltage between the target wire and the device housing is less than or equal to the first specified voltage, or greater than or equal to the second specified voltage, determining that the device housing is normally grounded.

Beneficial effects brought by the technical solutions provided in the embodiments of the present invention are as follows: In the embodiments of the present invention, the first signal collection module may collect the first voltage and the second voltage, and multiply the voltage difference between the first voltage and the second voltage by the specified proportion, to obtain the third voltage within the detection range of the signal processing module, and then input the third voltage to the signal processing module. The signal processing module may perform reverse processing on the third voltage based on a process of processing a voltage between the target wire and the device housing by the first isolation module, the first resistor, the second resistor, and the first signal collection module, to obtain the voltage between the target wire and the device housing; and when the voltage between the target wire and the device housing satisfies the specified condition, determine that a fault occurs in a device. The target wire may be either a live wire or a neutral wire. Therefore, fault detection on the device can be performed regardless of whether the live wire and the neutral wire connected to the device are correctly connected or inversely connected. In addition, the specified condition is used to indicate that the fault occurs in the device, and the fault includes at least one of the following: the live wire and the neutral wire connected to the device are inversely connected, the device housing is not normally grounded, and the device housing is energized. Therefore, detection on three types of faults can be simultaneously performed in the embodiments of the present invention, and a fault detection capability is relatively strong.

## BRIEF DESCRIPTION OF DRAWINGS

To describe the technical solutions in the embodiments of the present invention more clearly, the following briefly describes the accompanying drawings required for describing the embodiments. Apparently, the accompanying drawings in the following description show merely some embodiments of the present invention, and a person of ordinary skill in the art may still derive other drawings from these accompanying drawings without creative efforts.

FIG. 1 is a schematic structural diagram of a detection circuit according to related technologies;

FIG. 2 is a schematic structural diagram of a first detection circuit according to an embodiment of the present invention;

FIG. 3 is a schematic structural diagram of a second detection circuit according to an embodiment of the present invention;

FIG. 4 is a schematic structural diagram of a third detection circuit according to an embodiment of the present invention;

FIG. 5 is a schematic structural diagram of a fourth detection circuit according to an embodiment of the present invention;

FIG. 6 is a schematic structural diagram of a fifth detection circuit according to an embodiment of the present invention;

FIG. 7 is a schematic structural diagram of a sixth detection circuit according to an embodiment of the present invention;

FIG. 8 is a schematic structural diagram of a seventh detection circuit according to an embodiment of the present invention;

FIG. 9 is a schematic structural diagram of an eighth detection circuit;

FIG. 10 is a schematic structural diagram of a ninth detection circuit according to an embodiment of the present invention;

FIG. 11 is a schematic structural diagram of a tenth detection circuit according to an embodiment of the present invention;

FIG. 12 is a schematic structural diagram of an eleventh detection circuit according to an embodiment of the present invention;

FIG. 13 is a schematic structural diagram of a twelfth detection circuit according to an embodiment of the present invention;

FIG. 14 is a schematic structural diagram of a thirteenth detection circuit according to an embodiment of the present invention; and

FIG. 15 is a flowchart of a detection method according to an embodiment of the present invention.

**Reference numerals:**

Related technologies:

R: resistor; D: silicon rectifier diode; LED: light emitting diode; DW: Zener diode; C: electrolytic capacitor; HA: buzzer.

Embodiments of the present invention:

X: target wire; E: device housing; GND: reference ground; R1: first resistor; R2: second resistor;

1: first isolation module; 1A: first isolation unit; 1B: second isolation unit;

2: signal collection module; 2a: first input end of a signal collection module; 2b: second input end of a signal collection module; 2c: output end of a signal collection module; OPA 1: first operational amplifier; OPA 2: second operational amplifier; OPA 3: third operational amplifier; R3: third resistor; R4: fourth resistor; R5: fifth resistor; R6: sixth resistor;

3: signal processing module; 3a: input end of a signal processing module; 3b: grounding end of a signal processing module; AD: analog-to-digital converter; aa: input end of an analog-to-digital converter; ab: output end of an analog-to-digital converter; ac: grounding end of an analog-to-digital converter; MCU: controller; ma: input end of a controller; mb: grounding end of a controller;

4: signal conditioning module; 4a: input end of a signal conditioning module; 4b: output end of a signal conditioning module; R7: seventh resistor; R8: eighth resistor; D1: first diode; D2: second diode;

R10: tenth resistor; 5: second isolation module; 6: second signal collection module; 6a: input end of a second signal collection module; 6b: output end of a second signal collection module; OPA 4: fourth operational amplifier.

## DESCRIPTION OF EMBODIMENTS

To make the objectives, technical solutions, and advantages of the present invention clearer, the following further describes the implementations of the present invention in detail with reference to the accompanying drawings.

FIG. 2 is a schematic structural diagram of a detection circuit according to an embodiment of the present invention. The detection circuit is configured to detect a device. Referring to FIG. 2, the detection circuit includes a first isolation module 1, a first resistor R1, a second resistor R2, a first signal collection module 2, and a signal processing module 3.

The first isolation module 1 includes a first isolation unit 1A and a second isolation unit 1B, and a resistance value of the first isolation unit 1A is equal to that of the second isolation unit 1B. An end of the first isolation unit 1A is connected to a target wire X, and an end of the second isolation unit 1B is connected to a device housing E. A first input end 2a of the first signal collection module 2 and an end of the first resistor R1 are separately connected to the other end of the first isolation unit 1A, a second input end 2b of the first signal collection module 2 and an end of the second resistor R2 are separately connected to the other end of the second isolation unit 1B, and the other end of the first resistor R1 and the other end of the second resistor R2 are separately connected to a reference ground GND. An output end 2c of the first signal collection module 2 is connected to an input end 3a of the signal processing module 3, and a grounding end 3b of the signal processing module 3 is connected to the reference ground GND.

The first isolation module 1 is configured to isolate the target wire X from the device housing E, and is configured to isolate a primary circuit from a secondary circuit. The primary circuit includes the target wire X and a power supply of the device, and the secondary circuit includes the first resistor R1, the second resistor R2, the first signal collection module 2, and the signal processing module 3. The target wire X is configured to supply power to the device, the target wire X is a live wire or a neutral wire, and the device housing E is a housing of the device.

The first resistor R1 and the second resistor R2 are configured to divide a voltage, and a resistance value of the first resistor R1 is equal to that of the second resistor R2. The first signal collection module 2 is configured to: separately collect a voltage at both ends of the first resistor R1 and a voltage at both ends of the second resistor R2, determine the collected voltage at both ends of the first resistor R1 as a first voltage, determine the collected voltage at both ends of the second resistor R2 as a second voltage, and multiply a voltage difference between the first voltage and the second voltage by a specified proportion, to obtain a third voltage within a detection range of the signal processing module 3, and input the third voltage to the signal processing module 3.

The signal processing module 3 is configured to: perform reverse processing on the third voltage based on a process of processing a voltage between the target wire X and the device housing E by the first isolation module 1, the first resistor R1, the second resistor R2, and the first signal collection module 2, to obtain the voltage between the target wire X and the device housing E; and when the voltage between the target wire X and the device housing E satisfies a specified condition, determine that a fault occurs in the device. The specified condition is used to indicate that the fault occurs in the device, and the fault includes at least one of the following: the live wire and the neutral wire connected to the device are inversely connected, the device housing is not normally grounded, and the device housing is energized.

It should be noted that the first voltage is equal to $U_{X-GND} \cdot \dfrac{r_1}{r_1 + r_{1A}}$, where $U_{X\text{-}GND}$ is a voltage between the target wire X and the reference ground GND, $r_1$ is the resistance value of the first resistor R1, and $r_{1A}$ is the resistance value of the first isolation unit 1A. In other words, the first voltage is a voltage obtained after the voltage $U_{X\text{-}GND}$ between the target wire X and the reference ground GND is scaled down by a first proportion, where the first proportion is $\dfrac{r_1}{r_1 + r_{1A}}$.

In addition, the second voltage is equal to $U_{E-GND} \cdot \dfrac{r_2}{r_2 + r_{1B}}$, where $U_{E\_GND}$ is a voltage between the device housing E and the reference ground GND, $r_2$ is the resistance value of the second resistor R2, and $r_{1B}$ is the resistance value of the second isolation unit 1B. In other words, the second voltage is a voltage obtained after the voltage $U_{E\text{-}GND}$ between the device housing E and the reference ground GND is scaled down by a second proportion, where the second proportion is $\dfrac{r_2}{r_2 + r_{1B}}$.

Further, because the resistance value $r_1$ of the first resistor R1 is equal to the resistance value $r_2$ of the second resistor R2, and the resistance value $r_{1A}$ of the first isolation unit 1A is equal to the resistance value $r_{1B}$ of the second isolation unit 1B, the first proportion $\dfrac{r_1}{r_1 + r_{1A}}$ is equal to the second proportion $\dfrac{r_2}{r_2 + r_{1B}}$. The first voltage is the voltage obtained after the voltage between the target wire X and the reference ground GND is scaled down by the first proportion, the second voltage is the voltage obtained after the voltage between the device housing E and the reference ground GND is scaled down by the second proportion, and the first proportion is equal to the second proportion. Therefore, the voltage difference between the first voltage and the second voltage is a voltage obtained after the voltage between the target wire X and the device housing E is scaled down by the first proportion or the second proportion.

It should be noted that, the voltage between the target wire X and the device housing E is obtained based on the third voltage, and the third voltage is obtained by multiplying the voltage difference between the first voltage and the second voltage by the specified proportion. Therefore, the voltage between the target wire X and the device housing E is actually obtained based on the first voltage and the second voltage. Further, because the first voltage and the second voltage are obtained with respect to the reference ground GND, whether the reference ground GND is connected or not connected to the device housing E does not affect determining the voltage between the target wire X and the device housing E. In other words, in this embodiment of the present invention, fault detection on the device can be implemented regardless of whether the reference ground GND is connected or not connected to the device housing E.

After obtaining the voltage between the target wire X and the device housing E, the signal processing module 3 may determine whether the voltage between the target wire X and the device housing E satisfies the specified condition, to determine whether the fault occurs in the device. The operation of determining, by the signal processing module 3, whether the voltage between the target wire and the device housing satisfies the specified condition may be performed in the following five manners.

Manner 1: When a power supply mode of the device is a single-phase power supply, and a metal core wire in the live wire is not in contact with the device housing, it is determined whether the voltage between the target wire and the device housing is less than or equal to a first specified voltage; and when the voltage between the target wire and the device housing is less than or equal to the first specified voltage, it is determined that the live wire and the neutral wire connected to the device are inversely connected, and it is determined that the voltage between the target wire and the device housing satisfies the specified condition.

It should be noted that, in this embodiment of the present invention, when the live wire and the neutral wire connected to the device are inversely connected, it may be determined that the voltage between the target wire and the device housing satisfies the specified condition, and in this case, it may be determined that the fault occurring in the device is that the live wire and the neutral wire connected to the device are inversely connected. In this case, a first prompt message may be generated. The first prompt message is used to prompt a user that the live wire and the neutral wire connected to the device are inversely connected, so that the user can learn a connection status of the live wire and the neutral wire in a timely manner. The connection status indicates whether the live wire and the neutral wire are correctly connected or inversely connected.

In addition, the first specified voltage is a voltage between the neutral wire and the device housing when the device housing is normally grounded and the metal core wire in the live wire is not in contact with the device housing. The first specified voltage is close to 0 V. In actual application, the first specified voltage may be a smaller one between a first preset voltage and a second preset voltage. The first preset voltage may be an average of voltages between the neutral wire and the device housing that are measured for a plurality of times when the device housing is normally grounded and the metal core wire in the live wire is not in contact with the device housing. The second preset voltage may be a product of a preset value and a supply voltage of the device, and the preset value may be set in advance. For example, the preset value may be greater than 0.01 and less than 0.1. This is not specifically limited in this embodiment of the present invention. In addition, because the first specified voltage may be set based on the first preset voltage and the second preset voltage, the first specified voltage may be flexibly selected based on different electricity scenarios in this embodiment of the present invention, to ensure that the first specified voltage satisfies a detection requirement.

When the voltage between the target wire and the device housing is less than or equal to the first specified voltage, the voltage between the target wire and the device housing is very low and is close to 0 V. Therefore, when the metal core wire in the live wire is not in contact with the device housing, it may be determined that the target wire is the neutral wire. In other words, it may be determined that the live wire and the neutral wire connected to the device are inversely connected. For example, the first specified voltage is 5 V. Assuming that the voltage between the target wire and the device housing is 3 V, because 3 V is less than 5 V, it may be determined that the live wire and the neutral wire connected to the device are inversely connected.

Manner 2: When a power supply mode of the device is a single-phase power supply, and the metal core wire in the live wire is not in contact with the device housing, it is determined whether the voltage between the target wire and the device housing is greater than a first specified voltage and less than a second specified voltage; and when the voltage between the target wire and the device housing is greater than the first specified voltage and less than the second specified voltage, it is determined that the device housing is not normally grounded, and it is determined that the voltage between the target wire and the device housing satisfies the specified condition.

It should be noted that, in this embodiment of the present invention, when the device housing is not normally grounded, it may be determined that the voltage between the target wire and the device housing satisfies the specified condition, and in this case, it may be determined that the fault occurring in the device is that the device housing is not normally grounded. In this case, a second prompt message may be generated. The second prompt message is used to prompt a user that the device housing is not normally grounded, so that the user can learn a grounding status of the device housing in a timely manner. The grounding status indicates whether the device housing is normally grounded.

In addition, the second specified voltage is equal to the supply voltage minus the first specified voltage, the first specified voltage is less than the second specified voltage, and the second specified voltage is close to the supply voltage.

When the metal core wire in the live wire is not in contact with the device housing, if the device housing is not normally grounded, the voltage between the live wire or the neutral wire and the device housing should be near 1/2 of the supply voltage. Therefore, when the voltage between the target wire and the device housing is greater than the first specified voltage and less than the second specified voltage, it may be determined that the device housing is not normally grounded. For example, the supply voltage is 220 V, the first specified voltage is 5 V, and the second specified voltage is 215 V. Assuming that the voltage between the target wire and the device housing is 210 V, because 210 V is greater than 5 V and less than 215 V, it may be determined that the device housing is not normally grounded.

Further, when the power supply mode of the device is the single-phase power supply, and the metal core wire in the live wire is not in contact with the device housing, it may be further determined whether the voltage between the target wire and the device housing is less than or equal to the first specified voltage, or greater than or equal to the second specified voltage; and when the voltage between the target wire and the device housing is less than or equal to the first specified voltage, or greater than or equal to the second specified voltage, it is determined that the device housing is normally grounded.

When the device housing is normally grounded and the metal core wire in the live wire is not in contact with the device housing, if the target wire is the neutral wire, the voltage between the target wire and the device housing should be less than or equal to the first specified voltage. If the target wire is the live wire, the voltage between the target wire and the device housing should be greater than or equal to the second specified voltage. Therefore, when the voltage between the target wire and the device housing is less than or equal to the first specified voltage, or greater than or equal to the second specified voltage, it may be determined that the device housing is normally grounded. For example, the supply voltage is 220 V, the first specified voltage is 5 V, and the second specified voltage is 215 V. Assuming that the voltage between the target wire and the device housing is 3 V, because 3 V is less than 5 V, it may be determined that the device housing is normally grounded.

Manner 3: When a power supply mode of the device is a single-phase power supply, and the target wire is the live wire, it is determined whether the voltage between the target wire and the device housing is a first contacting voltage, where the first contacting voltage is a voltage between the target wire and the device housing when a metal core wire in the target wire is in contact with the device housing; and when the voltage between the target wire and the device housing is the first contacting voltage, it is determined that the device housing is energized, and it is determined that the voltage between the target wire and the device housing satisfies the specified condition; or when a power supply mode of the device is a single-phase power supply, and the target wire is the neutral wire, it is determined whether the voltage between the target wire and the device housing is a second contacting voltage, where the second contacting voltage is a voltage between the target wire and the device housing when a metal core wire in the live wire different from the target wire is in contact with the device housing; and when the voltage between the target wire and the device housing is the second contacting voltage, it is determined that the device housing is energized, and it is determined that the voltage between the target wire and the device housing satisfies the specified condition.

It should be noted that, in this embodiment of the present invention, when the device housing is energized, it may be determined that the voltage between the target wire and the device housing satisfies the specified condition, and in this case, it may be determined that the fault occurring in the device is that the device housing is energized. In this case, a third prompt message may be generated. The third prompt message is used to prompt a user that the device housing is energized, so that the user can learn an energizing status of the device housing in a timely manner. The energizing status indicates whether the device housing is energized.

In addition, when the power supply mode of the device is the single-phase power supply, and the target wire is the live wire, if the metal core wire in the target wire is in contact with the device housing and consequently, the device housing is energized, an electrical potential of the device housing is close to an electrical potential of the target wire. In this case, the voltage between the target wire and the device housing should be near 0 V. In other words, the first contacting voltage may be greater than or equal to 0 V and less than a third preset voltage, where the third preset voltage may be set in advance. For example, the third preset voltage may be 0.2 V, 0.3 V, or the like. This is not specifically limited in this embodiment of the present invention.

Further, when the power supply mode of the device is the single-phase power supply, and the target wire is the neutral wire, if the live wire different from the target wire is in contact with the device housing and consequently, the device housing is energized, an electrical potential of the device housing is close to that of the live wire. In this case, the voltage between the target wire and the device housing should be near the supply voltage. In other words, the second contacting voltage may be greater than a fourth preset voltage and less than or equal to the supply voltage, where the fourth preset voltage may be set in advance. For example, when the supply voltage is 220 V, the fourth preset voltage may be 119 V, 119.5 V, or the like. This is not specifically limited in this embodiment of the present invention.

For example, the target wire is the live wire, and the first contacting voltage is greater than or equal to 0 V and less than 0.3 V. Assuming that the voltage between the target wire and the device housing is 0.2 V, the voltage between the target wire and the device housing is the first contacting voltage, and it may be determined that the device housing is energized.

For another example, the target wire is the neutral wire, the supply voltage is 220 V, and the second contacting voltage is greater than 119 V and less than or equal to 220 V. Assuming that the voltage between the target wire and the device housing is 119.5 V, the voltage between the target wire and the device housing is the second contacting voltage, and it may be determined that the device housing is energized.

It should be noted that, when the power supply mode of the device is the single-phase power supply, before it is determined whether the voltage between the target wire and the device housing satisfies the specified condition, it may be further determined whether the target wire is the live wire or the neutral wire. An operation of determining whether the target wire is the live wire or the neutral wire may be: When the metal core wire in the live wire is not in contact with the device housing, if the voltage between the target wire and the device housing is less than or equal to the first specified voltage, it is determined that the target wire is the neutral wire. When the metal core wire in the live wire is not in contact with the device housing, if the voltage between the target wire and the device housing is greater than or equal to the second specified voltage, it is determined that the target wire is the live wire.

It should be noted that the foregoing process of determining whether the target wire is the live wire or the neutral wire is a process of determining whether the live wire and the neutral wire connected to the device are correctly connected or inversely connected. In other words, when the target wire is the live wire, it may be determined that the live wire and the neutral wire connected to the device are correctly connected; or when the target wire is the neutral wire, it may be determined that the live wire and the neutral wire connected to the device are inversely connected.

When the voltage between the target wire and the device housing is less than or equal to the first specified voltage, the voltage between the target wire and the device housing is very low and is close to 0 V at a current time. Therefore, when the metal core wire in the live wire is not in contact with the device housing, it may be determined that the target wire is the neutral wire. However, when the voltage between the target wire and the device housing is greater than or equal to the second specified voltage, the voltage between the target wire and the device housing is very large and is close to the supply voltage. Therefore, when the metal core wire in the live wire is not in contact with the device housing, it may be determined that the target wire is the live wire.

For example, the supply voltage is 220 V, the first specified voltage is 5 V, and the second specified voltage is 215 V. Assuming that the voltage between the target wire and the device housing is 3 V, because 3 V is less than 5 V, it may be determined that the target wire is the neutral wire.

For another example, the supply voltage is 220 V, the first specified voltage is 5 V, and the second specified voltage is 215 V. Assuming that the voltage between the target wire and the device housing is 217 V, because 217 V is greater than 215 V, it may be determined that the target wire is the live wire.

When the power supply mode of the device is the single-phase power supply, during fault detection on the device, an operation of performing live detection on the device housing when the target wire is the live wire is different from an operation of performing live detection on the device housing when the target wire is the neutral wire. Therefore, before the live detection on the device housing is performed, it needs to first determine whether the target wire is the live wire or the neutral wire. Further, only when the metal core wire in the live wire is not in contact with the device housing and the device housing is normally grounded, it may be determined whether the target wire is the live wire or the neutral wire. Therefore, in actual application, when the device is initially installed, or initially powered on, or powered on for the first time after power-off, it can be ensured that the metal core wire in the live wire is not in contact with the device housing, and that the device housing is normally grounded, so that when the device is initially installed, or initially powered on, or powered on for the first time after power-off, it may be determined whether the target wire is the live wire or the neutral wire, thereby further ensuring that the live detection on the device housing can be effectively performed subsequently. In addition, because the connection status of the live wire and the neutral wire generally does not change during a running process of the device, whether the target wire is the live wire or the neutral wire may be determined only once when the device is initially installed, or initially powered on, or powered on for the first time after power-off. There is no need to perform determining again during subsequent detection, thereby saving processing resources.

It should be noted that, in actual application, in the foregoing manner 3, when the target wire is the live wire, the operation of determining whether the voltage between the target wire and the device housing is the first contacting voltage may be implemented by using a flag bit. Specifically, when the target wire is the live wire, if it is detected that the voltage between the target wire and the device housing hops, a voltage that is between the target wire and the device housing and prior to the hopping is obtained, and a first flag bit is determined based on the obtained voltage; and a voltage that is between the target wire and the device housing and after the hopping is obtained, and a second flag bit is determined based on the obtained voltage. When the first flag bit and the second flag bit satisfy a first condition, it is determined that the voltage between the target wire and the device housing is the first contacting voltage.

When the voltage that is between the target wire and the device housing and prior to the hopping is obtained, and the first flag bit is determined based on the obtained voltage, if the obtained voltage is a first normal voltage, the first flag bit is set to 0; or if the obtained voltage is the first contacting voltage, the first flag bit is set to 1.

It should be noted that the first normal voltage is a voltage between the target wire and the device housing when the metal core wire in the target wire is not in contact with the device housing. When the device housing is normally grounded, the first normal voltage may be greater than the fourth preset voltage and less than or equal to the supply voltage. When the device housing is not normally grounded, the first normal voltage may be greater than a fifth preset voltage and less than or equal to 1/2 of the supply voltage, where the fifth preset voltage may be set in advance. For example, when the supply voltage is 220 V, and 1/2 of the supply voltage is 110 V, the fifth preset voltage may be 108 V, 109 V, or the like. This is not specifically limited in this embodiment of the present invention.

For example, the target wire is the live wire, the supply voltage is 220 V, the first normal voltage is greater than 119 V and less than or equal to 220 V, or the first normal voltage is greater than 108 V and less than or equal to 110 V, and the first contacting voltage is greater than or equal to 0 V and less than 0.3 V. Assuming that the obtained voltage that is between the target wire and the device housing and prior to the hopping is 119.5 V, the obtained voltage is the first normal voltage. In this case, the first flag bit may be set to 0.

For another example, the target wire is the live wire, the supply voltage is 220 V, the first normal voltage is greater than 119 V and less than or equal to 220 V, or the first normal voltage is greater than 108 V and less than or equal to 110 V, and the first contacting voltage is greater than or equal to 0 V and less than 0.3 V. Assuming that the obtained voltage that is between the target wire and the device housing and prior to the hopping is 0.2 V, the obtained voltage is the first contacting voltage. In this case, the first flag bit may be set to 1.

An operation of obtaining the voltage that is between the target wire and the device housing and after the hopping and determining the second flag bit based on the obtained voltage is the same as the foregoing operation of determining the first flag bit based on the obtained voltage. Details are not described herein again in this embodiment of the present invention.

It should be noted that the first condition is used to indicate that the device housing hops from a de-energized state to an energized state. For example, the first condition may be that the first flag bit is 0 and the second flag bit is 1. When the first flag bit is 0 and the second flag bit is 1, it may be determined that the voltage between the target wire and the device housing hops from the first normal voltage to the first contacting voltage. Therefore, in this case, it may be determined that the voltage between the target wire and the device housing is the first contacting voltage.

It should be noted that, in actual application, in the foregoing manner 3, when the target wire is the neutral wire, the operation of determining whether the voltage between the target wire and the device housing is the second contacting voltage may be implemented by using a flag bit. Specifically, when the target wire is the neutral wire, if it is detected that the voltage between the target wire and the device housing hops, a voltage that is between the target wire and the device housing and prior to the hopping is obtained, and a third flag bit is determined based on the obtained voltage; and a voltage that is between the target wire and the device housing and after the hopping is obtained, and a fourth flag bit is determined based on the obtained voltage. When the third flag bit and the fourth flag bit satisfy a second condition, it is determined that the voltage between the target wire and the device housing is the second contacting voltage.

When the voltage that is between the target wire and the device housing and prior to the hopping is obtained, and the third flag bit is determined based on the obtained voltage, if the obtained voltage is a second normal voltage, the third flag bit is set to 0; or if the obtained voltage is the second contacting voltage, the third flag bit is set to 1.

It should be noted that the second normal voltage is the voltage between the target wire and the device housing when the metal core wire in the live wire different from the target wire is not in contact with the device housing. When the device housing is normally grounded, the second normal voltage may be greater than or equal to 0 V and less than the third preset voltage. When the device housing is not normally grounded, the second normal voltage may be greater than the fifth preset voltage and less than or equal to 1/2 of the supply voltage.

For example, the target wire is the neutral wire, the supply voltage is 220 V, the second normal voltage is greater than or equal to 0 V and less than 0.3 V, or the second normal voltage is greater than 108 V and less than or equal to 110 V, and the second contacting voltage is greater than 119 V and less than or equal to 220 V. Assuming that the obtained voltage that is between the target wire and the device housing and prior to the hopping is 0.2 V, the obtained voltage is the second normal voltage. In this case, the third flag bit may be set to 0.

For another example, the target wire is the neutral wire, the supply voltage is 220 V, the second normal voltage is greater than or equal to 0 V and less than 0.3 V, or the second normal voltage is greater than 108 V and less than or equal to 110 V, and the second contacting voltage is greater than 119 V and less than or equal to 220 V. Assuming that the obtained voltage that is between the target wire and the device housing and prior to the hopping is 119.5 V, the obtained voltage is the second contacting voltage. In this case, the third flag bit may be set to 1.

An operation of obtaining the voltage that is between the target wire and the device housing and after the hopping and determining the fourth flag bit based on the obtained voltage is the same as the foregoing operation of determining the third flag bit based on the obtained voltage. Details are not described herein again in this embodiment of the present invention.

It should be noted that the second condition is used to indicate that the device housing hops from a de-energized state to an energized state. For example, the second condition may be that the third flag bit is 0 and the fourth flag bit is 1. When the third flag bit is 0 and the fourth flag bit is 1, it may be determined that the voltage between the target wire and the device housing hops from the second normal voltage to the second contacting voltage. Therefore, in this case, it may be determined that the voltage between the target wire and the device housing is the second contacting voltage.

Manner 4: When a power supply mode of the device is a dual-live-wire power supply, it is determined whether the voltage between the target wire and the device housing is a first contacting voltage or a second contacting voltage; and when the voltage between the target wire and the device housing is the first contacting voltage or the second contacting voltage, it is determined that the device housing is energized, and it is determined that the voltage between the target wire and the device housing satisfies the specified condition.

It should be noted that, in this embodiment of the present invention, when the device housing is energized, it may be determined that the voltage between the target wire and the device housing satisfies the specified condition, and in this case, it may be determined that the fault occurring in the device is that the device housing is energized. In this case, a third prompt message may be generated. The third prompt message is used to prompt a user that the device housing is energized, so that the user can learn an energizing status of the device housing in a timely manner.

It should be noted that, when the power supply mode of the device is the dual-live-wire power supply, if the metal core wire in the target wire is in contact with the device housing and consequently, the device housing is energized, an electrical potential of the device housing is close to an electrical potential of the target wire. In this case, the voltage between the target wire and the device housing should be near 0 V. In other words, in this case, the voltage between the target wire and the device housing should be the first contacting voltage. If the metal core wire in the live wire different from the target wire is in contact with the device housing and consequently, the device housing is energized, the electrical potential of the device housing is close to an electrical potential of the live wire. In this case, the voltage between the target wire and the device housing should be near the supply voltage. In other words, in this case, the voltage between the target wire and the device housing should be the second contacting voltage. Therefore, when the voltage between the target wire and the device housing is the first contacting voltage or the second contacting voltage, it may be determined that the device housing is energized.

For example, the supply voltage is 220 V, the first contacting voltage is greater than or equal to 0 V and less than 0.3 V, and the second contacting voltage is greater than 119 V and less than or equal to 220 V. Assuming that the voltage between the target wire and the device housing is 0.2 V, it may be determined that the voltage between the target wire and the device housing is the first contacting voltage, and it is determined that the device housing is energized.

It should be further noted that, in actual application, in the foregoing manner 4, the operation of determining whether the voltage between the target wire and the device housing is the first contacting voltage or the second contacting voltage may be implemented by using a flag bit. Specifically, if it is detected that the voltage between the target wire and the device housing hops, a voltage that is between the target wire and the device housing and prior to the hopping is obtained, and a fifth flag bit is determined based on the obtained voltage; and a voltage that is between the target wire and the device housing and after the hopping is obtained, and a sixth flag bit is determined based on the obtained voltage. When the fifth flag bit and the sixth flag bit satisfy a third condition, it is determined that the voltage between the target wire and the device housing is the first contacting voltage or the second contacting voltage.

When the voltage that is between the target wire and the device housing and prior to the hopping is obtained, and the fifth flag bit is determined based on the obtained voltage, if the obtained voltage is a third normal voltage, the fifth flag bit is set to 0; or if the obtained voltage is the first contacting voltage or the second contacting voltage, the fifth flag bit is set to 1.

It should be noted that the third normal voltage is a voltage between the target wire and the device housing when neither the target wire nor the metal core wire in the live wire different from the target wire is in contact with the device housing. The third normal voltage may be greater than the fifth preset voltage and less than or equal to 1/2 of the supply voltage.

For example, the supply voltage is 220 V, the third normal voltage is greater than 108 V and less than or equal to 110 V, the first contacting voltage is greater than or equal to 0 V and less than 0.3 V, and the second contacting voltage is greater than 119 V and less than or equal to 220 V. Assuming that the obtained voltage that is between the target wire and the device housing and prior to the hopping is 109 V, the obtained voltage is the third normal voltage. In this case, the fifth flag bit may be set to 0.

For example, the supply voltage is 220 V, the third normal voltage is greater than 108 V and less than or equal to 110 V, the first contacting voltage is greater than or equal to 0 V and less than 0.3 V, and the second contacting voltage is greater than 119 V and less than or equal to 220 V. Assuming that the obtained voltage that is between the target wire and the device housing and prior to the hopping is 0.2 V, the obtained voltage is the first contacting voltage. In this case, the fifth flag bit may be set to 1.

An operation of obtaining the voltage that is between the target wire and the device housing and after the hopping and determining the sixth flag bit based on the obtained voltage is the same as the foregoing operation of determining the fifth flag bit based on the obtained voltage. Details are not described herein again in this embodiment of the present invention.

It should be noted that the third condition is used to indicate that the device housing hops from a de-energized state to an energized state. For example, the third condition may be that the fifth flag bit is 0 and the sixth flag bit is 1. When the fifth flag bit is 0 and the sixth flag bit is 1, it may be determined that the voltage between the target wire and the device housing hops from the third normal voltage to the first contacting voltage, or hops from the third normal voltage to the second contacting voltage. Therefore, in this case, it may be determined that the voltage between the target wire and the device housing is the first contacting voltage or the second contacting voltage.

Manner 5: When a power supply mode of the device is a three-phase power supply, it is determined whether the voltage between the target wire and the device housing is a first contacting voltage or a third contacting voltage, where the third contacting voltage is a voltage between the target wire and the device housing when a metal core wire in any live wire different from the target wire is in contact with the device housing; and when the voltage between the target wire and the device housing is the first contacting voltage or the third contacting voltage, it is determined that the device housing is energized, and it is determined that the voltage between the target wire and the device housing satisfies the specified condition.

It should be noted that, in this embodiment of the present invention, when the device housing is energized, it may be determined that the voltage between the target wire and the device housing satisfies the specified condition, and in this case, it may be determined that the fault occurring in the device is that the device housing is energized. In this case, a third prompt message may be generated. The third prompt message is used to prompt a user that the device housing is energized, so that the user can learn an energizing status of the device housing in a timely manner.

It should be noted that, when the power supply mode of the device is the three-phase power supply, if the metal core wire in the target wire is in contact with the device housing and consequently, the device housing is energized, an electrical potential of the device housing is close to an electrical potential of the target wire. In this case, the voltage between the target wire and the device housing should be near 0 V. In other words, in this case, the voltage between the target wire and the device housing should be the first contacting voltage.

If the metal core wire in any live wire different from the target wire is in contact with the device housing and consequently, the device housing is energized, the electrical potential of the device housing is close to that of the live wire. In this case, the voltage between the target wire and the device housing should be near $\sqrt{3}$ times of the supply voltage. In other words, the third contacting voltage may be greater than a sixth preset voltage and less than or equal to $\sqrt{3}$ times of the supply voltage, where the sixth preset voltage may be set in advance. For example, when the supply voltage is 220 V, the sixth preset voltage may be 373 V, 374 V, or the like. This is not specifically limited in this embodiment of the present invention.

For example, the supply voltage is 220 V, the first contacting voltage is greater than or equal to 0 V and less than 0.3 V, and the third contacting voltage is greater than 373 V and less than or equal to $\sqrt{3} \times 220$ V. Assuming that the voltage between the target wire and the device housing is 0.2 V, it may be determined that the voltage between the target wire and the device housing is the first contacting voltage, and it is determined that the device housing is energized.

It should be further noted that, in actual application, in the foregoing manner 5, the operation of determining whether the voltage between the target wire and the device housing is the first contacting voltage or the third contacting voltage may be implemented by using a flag bit. Specifically, if it is detected that the voltage between the target wire and the device housing hops, a voltage that is between the target wire and the device housing and prior to the hopping is obtained, and a seventh flag bit is determined based on the obtained voltage; and a voltage that is between the target wire and the device housing and after the hopping is obtained, and an eighth flag bit is determined based on the obtained voltage. When the seventh flag bit and the eighth flag bit satisfy a fourth condition, it is determined that the voltage between the target wire and the device housing is the first contacting voltage or the third contacting voltage.

When the voltage that is between the target wire and the device housing and prior to the hopping is obtained, and the seventh flag bit is determined based on the obtained voltage, if the obtained voltage is a fourth normal voltage, the seventh flag bit is set to 0; or if the obtained voltage is the first contacting voltage or the third contacting voltage, the seventh flag bit is set to 1.

It should be noted that the fourth normal voltage is a voltage between the target wire and the device housing when neither the target wire nor the metal core wire in the live wire different from the target wire is in contact with the device housing.

When the device is normally grounded, the fourth normal voltage may be greater than the fourth preset voltage and less than or equal to the supply voltage. When the device housing is not normally grounded, the fourth normal voltage may be greater than the fifth preset voltage and less than or equal to 1/2 of the supply voltage.

For example, the supply voltage is 220 V, the fourth normal voltage is greater than 119 V and less than or equal to 220 V, or the fourth normal voltage is greater than 108 V and less than or equal to 110 V, the first contacting voltage is greater than or equal to 0 V and less than 0.3 V, and the third contacting voltage is greater than 373 V and less than or equal to $\sqrt{3} \times 220$ V. Assuming that the obtained voltage that is between the target wire and the device housing and prior to the hopping is 119.5 V, the obtained voltage is the fourth normal voltage. In this case, the seventh flag bit may be set to 0.

For example, the supply voltage is 220 V, the fourth normal voltage is greater than 119 V and less than or equal to 220 V, or the fourth normal voltage is greater than 108 V and less than or equal to 110 V, the first contacting voltage is greater than or equal to 0 V and less than 0.3 V, and the third contacting voltage is greater than 373 V and less than or equal to $\sqrt{3} \times 220$ V. Assuming that the obtained voltage that is between the target wire and the device housing and prior to the hopping is 0.2 V, the obtained voltage is the first contacting voltage. In this case, the seventh flag bit may be set to 1.

An operation of obtaining the voltage that is between the target wire and the device housing and after the hopping and determining the eighth flag bit based on the obtained voltage is the same as the foregoing operation of determining the seventh flag bit based on the obtained voltage. Details are not described herein again in this embodiment of the present invention.

It should be noted that the fourth condition is used to indicate that the device housing hops from a de-energized state to an energized state. For example, the fourth condition may be that the seventh flag bit is 0 and the eighth flag bit is 1. When the seventh flag bit is 0 and the eighth flag bit is 1, it may be determined that the voltage between the target wire and the device housing hops from the fourth normal voltage to the first contacting voltage, or hops from the fourth normal voltage to the third contacting voltage. Therefore, in this case, it may be determined that the voltage between the target wire and the device housing is the first contacting voltage or the third contacting voltage.

Further, with reference to a logical determining list shown in Table 1, an overall description is given to fault detection operations in the foregoing manner 3, manner 4, and manner 5. $U_{X-E}$ is the voltage between the target wire and the device housing.

**Table 1**

| Stage $U_{X-E}$ Power supply mode | | Initial | Final | Determining basis | Conclusion |
|---|---|---|---|---|---|
| Single-phase power supply | Correctly connected | First normal voltage | First contacting voltage | First normal voltage → first contacting voltage | A device housing is energized. |
| | Inversely | Second normal | Second contacting | Second normal voltage → second | A device housing is |

| | connected | voltage | voltage | contacting voltage | energized. |
|---|---|---|---|---|---|
| Dual-live-wire power supply | | Third normal voltage | First contacting voltage | Third normal voltage → first contacting voltage | A device housing is energized. |
| | | | Second contacting voltage | Third normal voltage → second contacting voltage | A device housing is energized. |
| Three-phase power supply | | Fourth normal voltage | First contacting voltage | Fourth normal voltage → first contacting voltage | A device housing is energized. |
| | | | Third contacting voltage | Fourth normal voltage → third contacting voltage | A device housing is energized. |

It should be noted that, in this embodiment of the present invention, the logical determining list shown in the foregoing Table 1 is merely used as an example for description. The foregoing Table 1 does not constitute a limitation on this embodiment of the present invention.

As shown in the foregoing Table 1, when the power supply mode of the device is the single-phase power supply, and the live wire and the neutral wire connected to the device are correctly connected, if it is detected that the voltage between the target wire and the device housing hops from the first normal voltage to the first contacting voltage, it may be determined that the device housing is energized. When the power supply mode of the device is the single-phase power supply, and the live wire and the neutral wire connected to the device are inversely connected, if it is detected that the voltage between the target wire and the device housing hops from the second normal voltage to the second contacting voltage, it may be determined that the device housing is energized.

When the power supply mode of the device is the dual-live-wire power supply, if it is detected that the voltage between the target wire and the device housing hops from the third normal voltage to the first contacting voltage, or it is detected that the voltage between the target wire and the device housing hops from the third normal voltage to the second contacting voltage, it may be determined that the device housing is energized.

When the power supply mode of the device is the three-phase power supply, if it is detected that the voltage between the target wire and the device housing hops from the fourth normal voltage to the first contacting voltage, or it is detected that the voltage between the target wire and the device housing hops from the fourth normal voltage to the third contacting voltage, it may be determined that the device housing is energized.

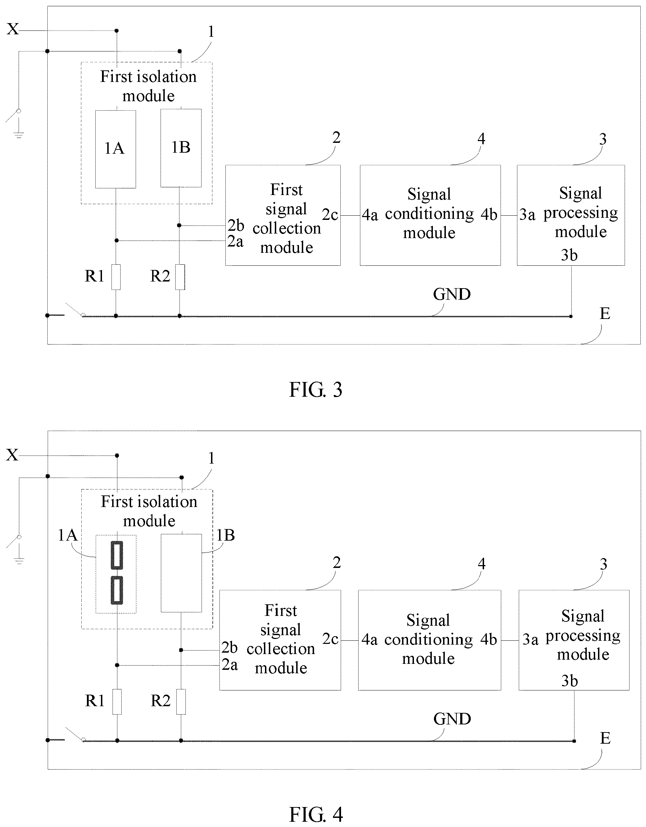

Referring to FIG. 3, the detection circuit further includes a signal conditioning module 4, where an input end 4a of the signal conditioning module 4 is connected to the output end 2c of the first signal collection module 2, and an output end 4b of the signal conditioning module 4 is connected to the input end 3a of a signal processing module 3.

The signal conditioning module 4 is configured to condition the third voltage received from the first signal collection module 2 to a voltage within an acceptable range of the signal processing module 3, and input the conditioned third voltage to the signal processing module 3.

Referring to FIG. 4, the first isolation unit 1A includes N resistors in series, and a total resistance value of the N resistors in series is greater than or equal to a specified resistance value, where N is a natural number greater than or equal to 1, and the specified resistance value is a resistance value that satisfies reinforced insulation required by a security standard.

It should be noted that, the specified resistance value may be set in advance. For example, the specified resistance value may be reinforced insulation 4 Mohms (megohm) required by the security standard IEC 60065, or the like. This is not specifically limited in this embodiment of the present invention.

It should be noted that, insulation resistors between the target wire X and the device housing E include the first resistor R1, the second resistor R2, the first isolation unit 1A, and the second isolation unit 1B, and the resistance value of the first isolation unit 1A is equal to that of the second isolation unit 1B. Therefore, when the total resistance value of the N resistors in series included by the first isolation unit 1A is greater than or equal to the specified resistance value, it can be ensured that the insulation resistors between the target wire X and the device housing E satisfy reinforced insulation required by the security standard, thereby ensuring electrical safety of a user.

In addition, the primary circuit and the secondary circuit are isolated by the first isolation module 1, and the resistance value of the first isolation unit 1A is equal to that of the second isolation unit 1B. Therefore, when the total resistance value of the N resistors in series included by the first isolation unit 1A is greater than or equal to the specified resistance value, it can be ensured that isolation between the primary circuit and the secondary circuit satisfies the reinforced insulation required by the security standard, thereby ensuring that an electronic element in the secondary circuit is not damaged by a high voltage in the primary circuit.

Further, in this embodiment of the present invention, when the total resistance value of the N resistors in series is greater than the specified resistance value, a total resistance value of any (N-1) resistors in the N resistors in series is greater than or equal to the specified resistance value, thereby ensuring that the first isolation unit 1A may still satisfy an isolation requirement when any resistor in the N resistors in series is short circuited.

It should be noted that the first isolation unit 1A in this embodiment of the present invention uses a structure shown in FIG. 4 as an example for description. In actual application, another structure including other electronic elements may also be used to implement a function of the first isolation unit 1A. This is not specifically limited in this embodiment of the present invention.

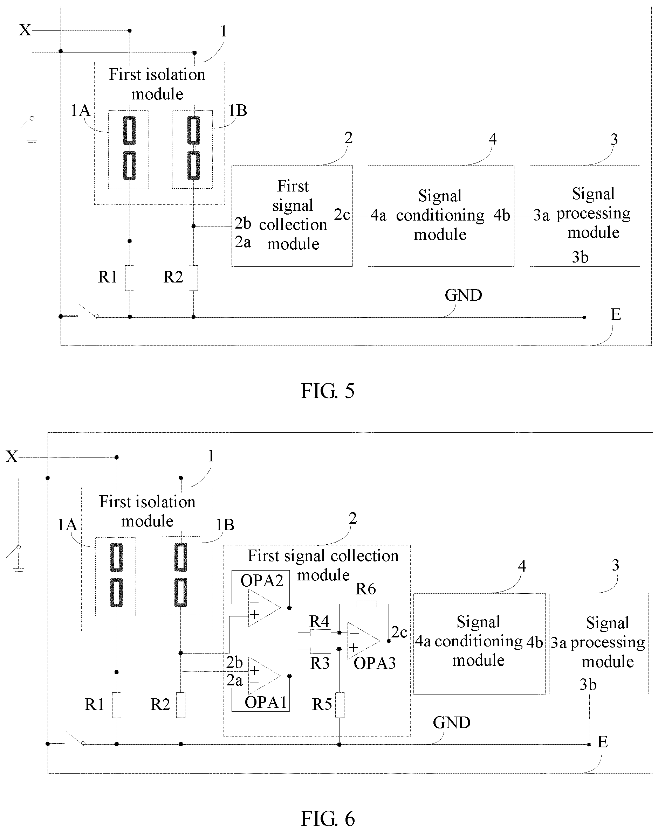

Referring to FIG. 5, the second isolation unit 1B includes M resistors in series, and a total resistance value of the M resistors in series is greater than or equal to a specified resistance value, where M is a natural number greater than or equal to 1, and the specified resistance value is a resistance value that satisfies reinforced insulation required by the security standard.

It should be noted that, the insulation resistors between the target wire X and the device housing E include the first resistor R1, the second resistor R2, the first isolation unit 1A, and the second isolation unit 1B, and a resistance value of the first isolation unit 1A is equal to that of the second isolation unit 1B. Therefore, when the total resistance value of the M resistors in series included by the second isolation unit 1B is greater than or equal to the specified resistance value, it can be ensured that the insulation resistors between the target wire X and the device housing E satisfy the reinforced insulation required by the security standard, thereby ensuring electrical safety of a user.

In addition, the primary circuit and the secondary circuit are isolated by the first isolation module 1, and the resistance value of the first isolation unit 1A is equal to that of the second isolation unit 1B. Therefore, when the total resistance value of the M resistors in series included by the second isolation unit 1B are greater than or equal to the specified resistance value, it can be ensured that isolation between the primary circuit and the secondary circuit satisfies the reinforced insulation required by the security standard, thereby ensuring that an electronic element in the secondary circuit is not damaged by a high voltage in the primary circuit.

Further, in this embodiment of the present invention, when the total resistance value of the M resistors in series is greater than the specified resistance value, a total resistance value of any (M-1) resistors in the M resistors in series is greater than or equal to the specified resistance value, thereby ensuring that the second isolation unit 1B may still satisfy the isolation requirement when any resistor in the M resistors in series is short circuited.

It should be noted that the second isolation unit 1B in this embodiment of the present invention uses a structure shown in FIG. 5 as an example for description. In actual application, another structure including other electronic elements may also be used to implement a function of the second isolation unit 1B. This is not specifically limited in this embodiment of the present invention.

Referring to FIG. 6, the first signal collection module 2 includes: a first operational amplifier OPA 1, a second operational amplifier OPA 2, a third operational amplifier OPA 3, a third resistor R3, a fourth resistor R4, a fifth resistor R5, and a sixth resistor R6.

A non-inverting input end of the first operational amplifier OPA 1 and an end of the first resistor R1 are separately connected to the other end of the first isolation unit 1A, and an inverting input end of the first operational amplifier OPA 1 and an end of the third resistor R3 are separately connected to an output end of the first operational amplifier OPA 1. A non-inverting input end of the second operational amplifier OPA 2 and an end of the second resistor R2 are separately connected to the other end of the second isolation unit 2B, and an inverting input end of the second operational amplifier OPA 2 and an end of the fourth resistor R4 are separately connected to an output end of the second operational amplifier OPA 2. A non-inverting input end of the third operational amplifier OPA 3 is connected to the other end of the third resistor R3, the non-inverting input end of the third operational amplifier OPA 3 is further connected to an end of the fifth resistor R5, and the other end of the fifth resistor R5 is connected to the reference ground GND. An inverting input end of the third operational amplifier OPA 3 is connected to the other end of the fourth resistor R4, an inverting input end of the third operational amplifier OPA 3 is further connected to an end of the sixth resistor R6, and the other end of the sixth resistor R6 and an input end 4a of a signal conditioning module 4 are separately connected to an output end of the third operational amplifier OPA 3.

The first operational amplifier OPA 1, the second operational amplifier OPA 2, and the third operational amplifier OPA 3 form a differential amplification circuit. Specifically, the first operational amplifier OPA 1 is configured to collect the voltage at both ends of the first resistor R1, the second operational amplifier OPA 2 is configured to collect the voltage at both ends of the second resistor R2, and the third operational amplifier OPA 3 is configured to determine the third voltage based on the voltage difference between the first voltage and the second voltage.

When determining the third voltage based on the voltage difference between the first voltage and the second voltage, the third operational amplifier OPA 3 may determine the third voltage by using a formula

$$U_3 = -\frac{r_6}{r_4}(U_1 - U_2)$$

, where $U_3$ is the third voltage, $r_6$ is a resistance value of the sixth resistor, $r_4$ is a resistance value of the fourth resistor, $U_1$ is the first voltage, and $U_2$ is the second voltage.

In other words, the third voltage is a voltage obtained by multiplying the voltage difference between the first voltage and the second voltage by a specified proportion, where the specified proportion is $-\frac{r_6}{r_4}$.

It should be noted that the first signal collection module 2 in this embodiment of the present invention uses a structure shown in FIG. 6 as an example for description. In actual application, a differential amplification circuit including electronic elements may also be used to implement a function of the first signal collection module 2. This is not specifically limited in this embodiment of the present invention.

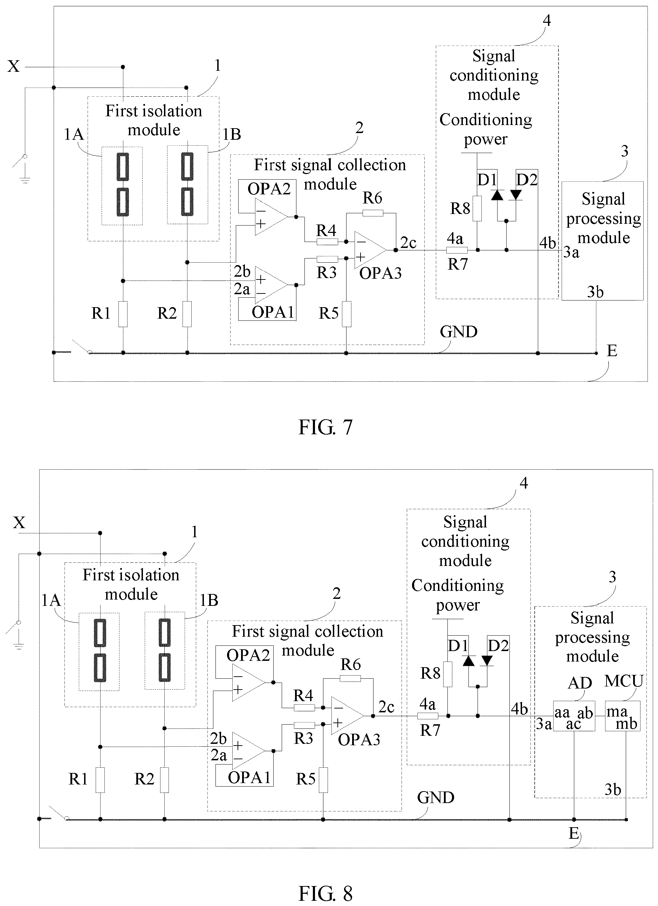

Referring to FIG. 7, the signal conditioning module 4 includes: a seventh resistor R7, an eighth resistor R8, a conditioning power supply, a first diode D1, and a second diode D2.

An end of the seventh resistor R7 is connected to the output end 2c of a first signal collection module 2, and an end of the eighth resistor R8, a positive electrode of the first diode D1, a negative electrode of the second diode D2, and the input end 3a of the signal processing module 3 are separately connected to the other end of the seventh resistor R7. The other end of the eighth resistor R8 and a negative electrode of the first diode D1 are separately connected to the conditioning power supply, and a positive electrode of the second diode D2 is connected to the reference ground GND.

When conditioning the third voltage received from the first signal collection module 2, the signal conditioning module 4 may increase the third voltage by a conditioning voltage of $\frac{r_8}{r_7 + r_8}$ times by using the conditioning power supply, the seventh resistor R7, and the eighth resistor R8; and after increasing the third voltage by the conditioning voltage of $\frac{r_8}{r_7 + r_8}$ times, may further restrain an increased third voltage within a range between $U_{cc}+U_d$ and -Ud by using the conditioning power supply, the first diode D1, and the second diode D2, to condition the third voltage to a voltage within an acceptable range of the signal processing module 3, thereby ensuring that an electronic element in the signal processing module 3 is not damaged by an overvoltage or a negative voltage.

$r_7$ is a resistance value of the seventh resistor R7, $r_8$ is a resistance value of the eighth resistor R8, $U_{cc}$ is a conditioning voltage, the conditioning voltage is an output voltage of the conditioning power supply, Ud is a breakover voltage of the first diode D1 or the second diode D2, and a breakover voltage of the first diode D1 is equal to that of the second diode D2.

It should be noted that the conditioning voltage $U_{cc}$ may be 3.3 V, 5 V, or the like. This is not specifically limited in this embodiment of the present invention. In addition, the breakover voltage $U_d$ of the first diode D1 or the second diode D2 may be 0.5 V, 0.7 V, or the like. This is not specifically limited in this embodiment of the present invention.

It should be further noted that the signal conditioning module 4 in this embodiment of the present invention uses a structure shown in FIG. 7 as an example for description. In actual application, another structure including other electronic elements may also be used to implement a function of the signal conditioning module 4. This is not specifically limited in this embodiment of the present invention.

Referring to FIG. 8, the signal processing module 3 includes: an analog-to-digital converter AD and a controller MCU.

An input end aa of the analog-to-digital converter AD is connected to an output end 4b of the signal conditioning module 4, an output end ab of the analog-to-digital converter AD is connected to an input end ma of the controller MCU, and a grounding end ac of the module converter AD and a grounding end mb of the controller MCU are separately connected to the reference ground GND.

The analog-to-digital converter AD is configured to convert a received analog parameter of a third voltage into a digital parameter, and send the digital parameter of the third voltage to the controller MCU. The controller MCU is configured to determine the voltage between the target wire X and the device housing E based on the third voltage.

When determining the voltage between the target wire X and the device housing E based on the third voltage, the controller MCU may determine the voltage based on a first proportion and a specified proportion if the detection circuit does not include the signal conditioning module 4. Specifically, the third voltage may be multiplied by a reciprocal of the specified proportion and by a reciprocal of the first proportion, to obtain the voltage between the target wire X and the device housing E.

The controller MCU may determine the voltage between the target wire X and the device housing E based on the first proportion, the specified proportion, and a conditioning voltage if the detection circuit includes the signal conditioning module 4. Specifically, the third voltage may first be decreased by a conditioning voltage of $\dfrac{r_8}{r_7 + r_8}$ times, and then a decreased third voltage is multiplied by a reciprocal of the specified proportion and by a reciprocal of the first proportion, to obtain the voltage between the target wire X and the device housing E.

It should be noted that the signal processing module 3 in this embodiment of the present invention uses a structure shown in FIG. 8 as an example for description. In actual application, another structure including other electronic elements may also be used to implement a function of the signal processing module 3. For example, the signal processing module 3 may include only a controller, and an analog-to-digital conversion module and the like may be integrated in the controller. This is not specifically limited in this embodiment of the present invention.

It should be noted that, a problem of temperature drift easily occurs when a semiconductor device is being used. The temperature drift is a change of a parameter of the semiconductor device caused by a temperature change. The temperature drift occurring in the semiconductor device results in inaccuracy of an output voltage of the semiconductor device. Therefore, when the temperature drift occurs in semiconductor devices, such as a first resistor R1, a second resistor R2, a first operational amplifier OPA 1, and a second operational amplifier OPA 2, included in the detection circuit, the output voltage of the semiconductor device needs to be corrected, to ensure accuracy of the output voltage of the semiconductor device. During correction of the output voltage of the semiconductor device, a manner of temperature compensation may be used for correction. Certainly, in actual application, another manner may alternatively be used for correction. This is not specifically limited in this embodiment of the present invention. For a specific operation of correction in the manner of temperature compensation, refer to related technologies. Details are not described herein in this embodiment of the present invention.

In addition, the semiconductor device is also easily subject to contamination due to a severe environment during use, and the contamination affects resistivity of the semiconductor device. Therefore, to prevent the semiconductor devices, such as the first resistor R1, the second resistor R2, the first operational amplifier OPA 1, and the second operational amplifier OPA 2, included in the detection circuit from being contaminated, the semiconductor device needs to be isolated from the environment. When the semiconductor device is isolated from the environment, a manner of coating or potting may be used for isolation. Certainly, in actual application, another manner may alternatively be used for isolation. This is not specifically limited in this embodiment of the present invention. For a specific operation of isolation in the manner of coating or potting, refer to related technologies. Details are not described herein in this embodiment of the present invention.

In this embodiment of the present invention, the first signal collection module may collect the first voltage and the second voltage, and multiply the voltage difference between the first voltage and the second voltage by the specified proportion, to obtain the third voltage within the detection range of the signal processing module. Then the third voltage is input to the signal processing module. The signal processing module may perform reverse processing on the third voltage based on a process of processing a voltage between the target wire and the device housing by the first isolation module, the first resistor, the second resistor, and the first signal collection module, to obtain the voltage between the target wire and the device housing. When the voltage between the target wire and the device housing satisfies the specified condition, it is determined that a fault occurs in the device. The target wire may be either a live wire or a neutral wire. Therefore, fault detection on the device can be performed regardless of whether the live wire and the neutral wire connected to the device are correctly connected or inversely connected. In addition, the specified condition is used to indicate that the fault occurs in the device, and the fault includes at least one of the following: the live wire and the neutral wire connected to the device are inversely connected, the device housing is not normally grounded, and the device housing is energized. Therefore, detection on three types of faults can be simultaneously performed in this embodiment of the present invention, and a fault detection capability is relatively strong.

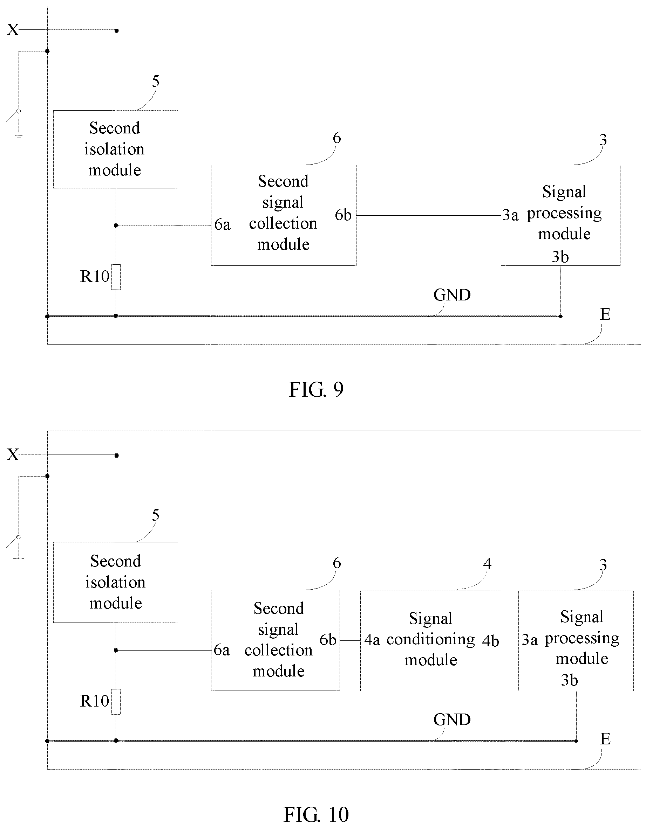

FIG. 9 is a schematic structural diagram of a detection circuit configured to detect a device. Referring to FIG. 9, the detection circuit includes a second isolation module 5, a tenth resistor R10, a second signal collection module 6, and a signal processing module 3.

An end of the second isolation module 5 is connected to a target wire X, an input end 6a of the second signal collection module 6 and an end of the tenth resistor R10 are separately connected to the other end of the second isolation module 5, the other end of the tenth resistor R10 is connected to a reference ground GND, the reference ground GND is connected to a device housing E, an output end 6b of the second signal collection module 6 is connected to an input end 3a of the signal processing module 3, and a grounding end 3b of the signal processing module 3 is connected to the reference ground GND.

The target wire X is configured to supply power to the device, the target wire X is a live wire or a neutral wire, and the device housing E is a housing of the device. The tenth resistor R10 is configured to divide a voltage, and the second isolation module 5 is configured to isolate the target wire X from the device housing E, and is configured to isolate a primary circuit from a secondary circuit. The primary circuit includes the target wire X and a power supply of the device, and the secondary circuit includes the tenth resistor R10, the second signal collection module 6, and the signal processing module 3. The second signal collection module 6 is configured to collect a voltage at both ends of the tenth resistor R10, determine the collected voltage at both ends of the tenth resistor R10 as a fourth voltage, and input the fourth voltage to the signal processing module 3.

The signal processing module 3 is configured to perform reverse processing on the fourth voltage based on a process of processing a voltage between the target wire X and the device housing E by the second isolation module 5, the tenth resistor R10, and the second signal collection module 6, to obtain the voltage between the target wire X and the device housing E. When the voltage between the target wire X and the device housing E satisfies a specified condition, it is determined that a fault occurs in the device. The specified condition is used to indicate that the fault occurs in the device, and the fault includes at least one of the following: the live wire and the neutral wire connected to the device are inversely connected, the device housing is not normally grounded, and the device housing is energized.

$$U_{X-E} \cdot \frac{r_{10}}{r_{10} + r_5}$$

It should be noted that the fourth voltage is equal to , where $U_{X-E}$ is the voltage between the target wire X and the device housing E, $r_{10}$ is a resistance value of the tenth resistor R10, and $r_5$ is a resistance value of the second isolation module 5.

In other words, the fourth voltage is a voltage obtained after the voltage $U_{X-E}$ between the target wire X and the device housing E is scaled down by a third proportion, where the third proportion is $\frac{r_{10}}{r_{10} + r_5}$.

After obtaining the voltage between the target wire X and the device housing E, the signal processing module 3 may determine whether the voltage between the target wire X and the device housing E satisfies the specified condition, to determine whether the fault occurs in the device. The operation of determining, by the signal processing module 3, whether the voltage between the target wire X and the device housing E satisfies the specified condition is the same as the determining operation in the foregoing detection circuit embodiments. Details are not described herein again in this embodiment of the present invention.

Referring to FIG. 10, the detection circuit further includes a signal conditioning module 4, where an input end 4a of the signal conditioning module 4 is connected to the output end 6b of the second signal collection module 6, and an output end 4b of the signal conditioning module 4 is connected to the input end 3a of a signal processing module 3.

The signal conditioning module 4 is configured to condition the fourth voltage received from the second signal collection module 6 to a voltage within an acceptable range of the signal processing module 3, and input the conditioned fourth voltage to the signal processing module 3.

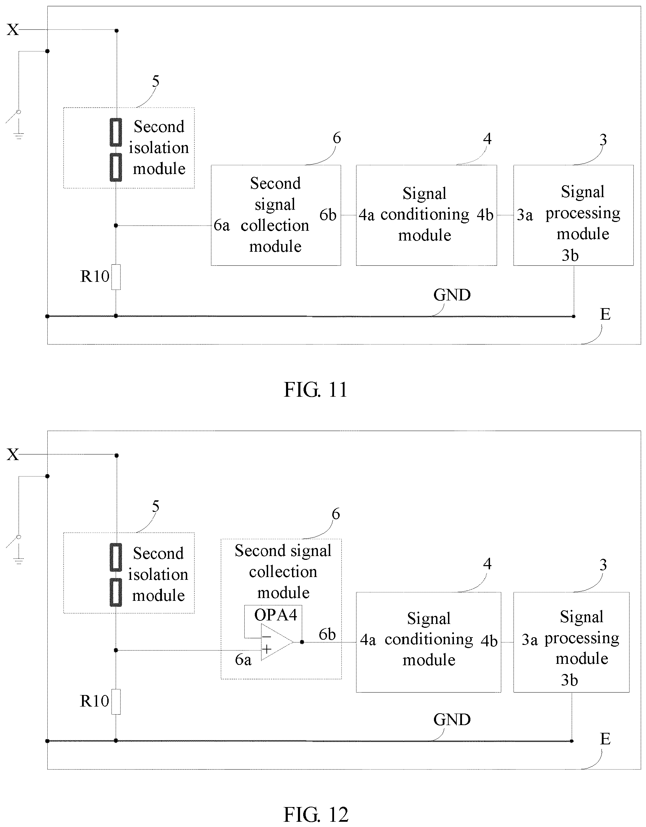

Referring to FIG. 11, the second isolation module 5 includes N resistors in series, and a total resistance value of the N resistors in series is greater than or equal to a specified resistance value, where N is a natural number greater than or equal to 1, and the specified resistance value is a resistance value that satisfies reinforced insulation required by the security standard.

It should be noted that, the specified resistance value may be set in advance. For example, the specified resistance value may be reinforced insulation 4 Mohms required by the security standard IEC 60065, or the like. This is not specifically limited in this embodiment of the present invention.

It should be noted that, insulation resistors between the target wire X and the device housing E include the tenth resistor R10 and the second isolation module 5. Therefore, when the total resistance value of the N resistors in series included by the second isolation module 5 is greater than or equal to the specified resistance value, it can be ensured that the insulation resistors between the target wire X and the device housing E satisfy the reinforced insulation required by the security standard, thereby ensuring electrical safety of a user.

In addition, because the primary circuit and the secondary circuit are isolated by the second isolation module 5, when the total resistance value of the N resistors in series included by the second isolation unit 5 is greater than or equal to the specified resistance value, it can be ensured that isolation between the primary circuit and the secondary circuit satisfies the reinforced insulation required by the security standard, thereby ensuring that an electronic element in the secondary circuit is not damaged by a high voltage in the primary circuit.

Further, in this embodiment of the present invention, when the total resistance value of the N resistors in series is greater than the specified resistance value, a total resistance value of any (N-1) resistors in the N resistors in series is greater than or equal to the specified resistance value, thereby ensuring that the second isolation module 5 may still satisfy an isolation requirement when any resistor in the N resistors in series is short circuited.

It should be noted that the second isolation module 5 in this embodiment of the present invention uses a structure shown in FIG. 11 as an example for description. In actual application, another structure including other electronic elements may also be used to implement a function of the second isolation module 5. This is not specifically limited in this embodiment of the present invention.

Referring to FIG. 12, the second signal collection module 6 includes a fourth operational amplifier OPA 4. A non-inverting input end of the fourth operational amplifier OPA 4 and an end of the tenth resistor R10 are separately connected to the other end of the second isolation module 5, and an inverting input end of the fourth operational amplifier OPA 4 and an output end of the fourth operational amplifier OPA 4 are separately connected to an input end 4a of the signal conditioning module 4. The fourth operational amplifier OPA 4 is configured to collect the voltage at both ends of the tenth resistor R10.

It should be noted that the second signal collection module 6 in this embodiment of the present invention uses a structure shown in FIG. 12 as an example for description. In actual application, another structure including other electronic elements may also be used to implement a function of the second signal collection module 6. This is not specifically limited in this embodiment of the present invention.

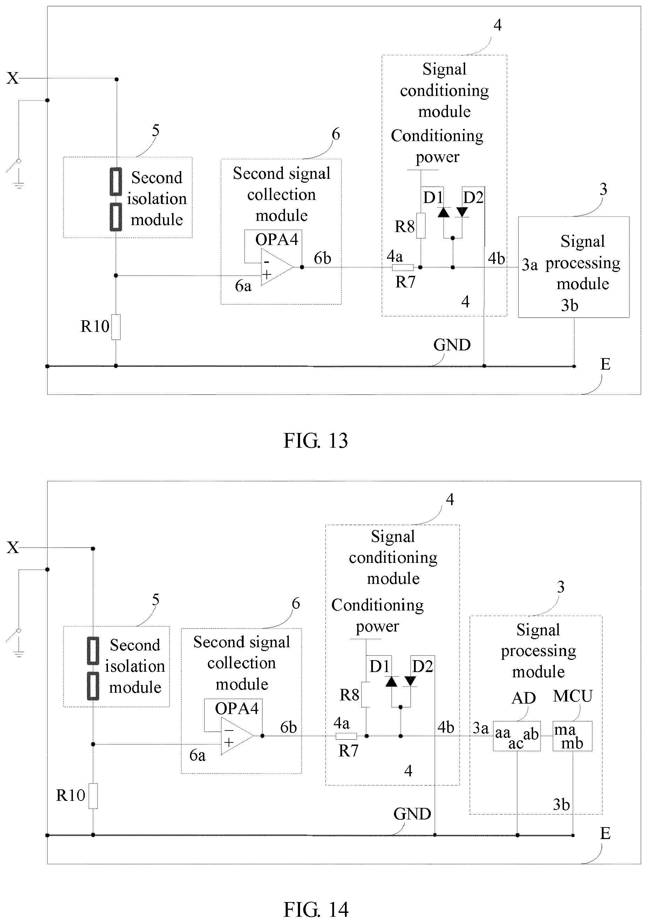

Referring to FIG. 13, the signal conditioning module 4 includes: a seventh resistor R7, an eighth resistor R8, a conditioning power supply, a first diode D1, and a second diode D2.

An end of the seventh resistor R7 is connected to the output end 6b of the second signal collection module 6, and an end of the eighth resistor R8, a positive electrode of the first diode D1, a negative electrode of the second diode D2, and the input end 3a of the signal processing module 3 are separately connected to the other end of the seventh resistor R7. The other end of the eighth resistor R8 and a negative electrode of the first diode D1 are separately connected to the conditioning power supply, and a positive electrode of the second diode D2 is connected to a reference ground GND.

When conditioning the fourth voltage received from the second signal collection module 6, the signal conditioning module 4 may increase the fourth voltage by a conditioning voltage of $\dfrac{r_8}{r_7 + r_8}$ times by using the conditioning power supply, the seventh resistor R7, and the eighth resistor R8; and after increasing the fourth voltage by the conditioning voltage of $\dfrac{r_8}{r_7 + r_8}$ times, may further restrain an increased fourth voltage within a range between $U_{cc}+U_d$ and -Ud by using the conditioning power supply, the first diode D1, and the second diode D2, to condition the fourth voltage to a voltage within an acceptable range of the signal processing module 3, thereby ensuring that an electronic element in the signal processing module 3 is not damaged by an overvoltage or a negative voltage.

$r_7$ is a resistance value of the seventh resistor R7, $r_8$ is a resistance value of the eighth resistor R8, $U_{cc}$ is a conditioning voltage, and the conditioning voltage is an output voltage of the conditioning power supply, Ud is a breakover voltage of the first diode D1 or the second diode D2, and a breakover voltage of the first diode D1 is equal to that of the second diode D2.

It should be noted that the conditioning voltage $U_{cc}$ may be 3.3 V, 5 V, or the like. This is not specifically limited in this embodiment of the present invention. In addition, the breakover voltage $U_d$ of the first diode D1 or the second diode D2 may be 0.5 V, 0.7 V, or the like. This is not specifically limited in this embodiment of the present invention.

It should be further noted that the signal conditioning module 4 in this embodiment of the present invention uses a structure shown in FIG. 13 as an example for description. In actual application, another structure including other electronic elements may also be used to implement a function of the signal conditioning module 4. This is not specifically limited in this embodiment of the present invention.

Referring to FIG. 14, the signal processing module 3 includes: an analog-to-digital converter AD and a controller MCU.

An input end aa of the analog-to-digital converter AD is connected to an output end 4b of the signal conditioning module 4, an output end ab of the analog-to-digital converter AD is connected to an input end ma of the controller MCU, and a grounding end ac of the module converter AD and a grounding end mb of the controller MCU are separately connected to the reference ground GND.

The analog-to-digital converter AD is configured to convert a received analog parameter of a fourth voltage into a digital parameter, and send the digital parameter of the fourth voltage to the controller MCU. The controller MCU is configured to determine a voltage between a target wire X and a device housing E based on the fourth voltage.

When determining the voltage between the target wire X and the device housing E based on the fourth voltage, the controller MCU may determine the voltage based on a third proportion if the detection circuit does not include the signal conditioning module 4. Specifically, the fourth voltage may be multiplied by a reciprocal of the third proportion, to obtain the voltage between the target wire X and the device housing E.

The voltage between the target wire X and the device housing E may be determined based on the third proportion and a conditioning voltage if the detection circuit includes the signal conditioning module 4. Specifically, the fourth voltage may first be decreased by the conditioning voltage of $\dfrac{r_8}{r_7 + r_8}$ times, and then a decreased fourth voltage is multiplied by a reciprocal of the third proportion, to obtain the voltage between the target wire X and the device housing E.

It should be noted that the signal processing module 3 in this embodiment of the present invention uses a structure shown in FIG. 14 as an example for description. In actual application, another structure including other electronic elements may also be used to implement a function of the signal processing module 3. For example, the signal processing module 3 may include only a controller, and an analog-to-digital conversion module and the like may be integrated in the controller. This is not specifically limited in this embodiment of the present invention.

It should be noted that, a problem of temperature drift easily occurs when a semiconductor device is being used. The temperature drift is a change of a parameter of the semiconductor device caused by a temperature change. The temperature drift occurring in the semiconductor device results in inaccuracy of an output voltage of the semiconductor device. Therefore, when the temperature drift occurs in semiconductor devices, such as a tenth resistor R10 and a fourth operational amplifier OPA 4, included in the detection circuit, the output voltage of the semiconductor device needs to be corrected, to ensure accuracy of the output voltage of the semiconductor device. During correction of the output voltage of the semiconductor device, a manner of temperature compensation may be used for correction. Certainly, in actual application, another manner may alternatively be used for correction. This is not specifically limited in this embodiment of the present invention. For a specific operation of correction in the manner of temperature compensation, refer to related technologies. Details are not described herein in this embodiment of the present invention.

In addition, the semiconductor device is also easily subject to contamination due to a severe environment during use, and the contamination affects resistivity of the semiconductor device. Therefore, to prevent the semiconductor devices, such as the tenth resistor R10 and the fourth operational amplifier OPA 4 included in the detection circuit, from being contaminated, the semiconductor device needs to be isolated from the environment. When the semiconductor device is isolated from the environment, a manner of coating or potting may be used for isolation. Certainly, in actual application, another manner may alternatively be used for isolation. This is not specifically limited in this embodiment of the present invention. For a specific operation of isolation in the manner of coating or potting, refer to related technologies. Details are not described herein in this embodiment of the present invention.

In this embodiment of the present invention, the second signal collection module may collect the fourth voltage, and input the fourth voltage to the signal processing module. The signal processing module may perform reverse processing on the fourth voltage based on a process of processing a voltage between the target wire and the device housing by the second isolation module, the tenth resistor, and the second signal collection module, to obtain the voltage between the target wire and the device housing. When the voltage between the target wire and the device housing satisfies a specified condition, it is determined that a fault occurs in the device. The target wire may be either a live wire or a neutral wire. Therefore, fault detection on the device can be performed regardless of whether the live wire and the neutral wire connected to the device are correctly connected or inversely connected. In addition, the specified condition is used to indicate that the fault occurs in the device, and the fault includes at least one of the following: the live wire and the neutral wire connected to the device are inversely connected, the device housing is not normally grounded, and the device housing is energized. Therefore, detection on three types of faults can be simultaneously performed in this embodiment of the present invention, and a fault detection capability is relatively strong.

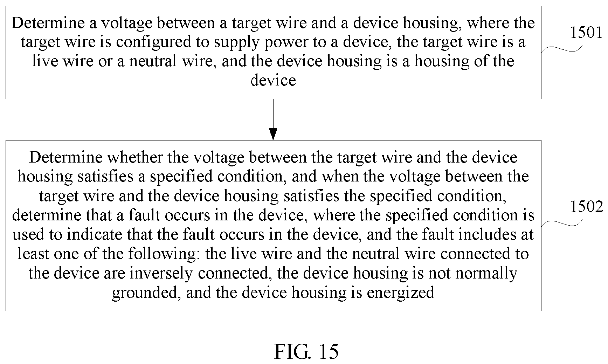

FIG. 15 shows a detection method according to an embodiment of the present invention, where the method is configured to detect a device, and the method includes the following steps.

Step 1501: Determine a voltage between a target wire and a device housing, where the target wire is configured to supply power to the device, the target wire is a live wire or a neutral wire, and the device housing is a housing of the device.

It should be noted that, either of the foregoing two detection circuits may be used for determining the voltage between the target wire and the device housing. Certainly, in actual application, another manner may alternatively be used for determining. This is not specifically limited in this embodiment of the present invention. In addition, the operation of using either of the foregoing two detection circuits to determine the voltage between the target wire and the device housing is already described in related parts of the two detection circuit embodiments. Details are not described herein again in this embodiment of the present invention.

Step 1502: Determine whether the voltage between the target wire and the device housing satisfies a specified condition, and when the voltage between the target wire and the device housing satisfies the specified condition, determine that a fault occurs in the device, where the specified condition is used to indicate that the fault occurs in the device, and the fault includes at least one of the following: the live wire and the neutral wire connected to the device are inversely connected, the device housing is not normally grounded, and the device housing is energized.

The operations of determining whether the voltage between the target wire and the device housing satisfies a specified condition may be performed in the following five manners.

Manner 1: When a power supply mode of the device is a single-phase power supply, and a metal core wire in the live wire is not in contact with the device housing, it is determined whether the voltage between the target wire and the device housing is less than or equal to a first specified voltage; and when the voltage between the target wire and the device housing is less than or equal to the first specified voltage, it is determined that the live wire and the neutral wire connected to the device are inversely connected, and it is determined that the voltage between the target wire and the device housing satisfies the specified condition.

It should be noted that, in this embodiment of the present invention, when the live wire and the neutral wire connected to the device are inversely connected, it may be determined that the voltage between the target wire and the device housing satisfies the specified condition, and in this case, it may be determined that the fault occurring in the device is that the live wire and the neutral wire connected to the device are inversely connected. In this case, a first prompt message may be generated. The first prompt message is used to prompt a user that the live wire and the neutral wire connected to the device are inversely connected, so that the user can learn a connection status of the live wire and the neutral wire in a timely manner. The connection status indicates whether the live wire and the neutral wire are correctly connected or inversely connected.

In addition, the first specified voltage is a voltage between the neutral wire and the device housing when the device housing is normally grounded and the metal core wire in the live wire is not in contact with the device housing. The first specified voltage is close to 0 V. In actual application, the first specified voltage may be a smaller one between a first preset voltage and a second preset voltage. The first preset voltage may be an average of voltages between the neutral wire and the device housing that are measured for a plurality of times when the device housing is normally grounded and the metal core wire in the live wire is not in contact with the device housing. The second preset voltage may be a product of a preset value and a supply voltage of the device, and the preset value may be set in advance. For example, the preset value may be greater than 0.01 and less than 0.1. This is not specifically limited in this embodiment of the present invention. In addition, because the first specified voltage may be set based on the first preset voltage and the second preset voltage, the first specified voltage may be flexibly selected based on different electricity scenarios in this embodiment of the present invention, to ensure that the first specified voltage satisfies a detection requirement.

When the voltage between the target wire and the device housing is less than or equal to the first specified voltage, the voltage between the target wire and the device housing is very low and is close to 0 V. Therefore, when the metal core wire in the live wire is not in contact with the device housing, it may be determined that the target wire is the neutral wire. In other words, it may be determined that the live wire and the neutral wire connected to the device are inversely connected. For example, the first specified voltage is 5 V. Assuming that the voltage between the target wire and the device housing is 3 V, because 3 V is less than 5 V, it may be determined that the live wire and the neutral wire connected to the device are inversely connected.

Manner 2, as claimed: When a power supply mode of the device is a single-phase power supply, and the metal core wire in the live wire is not in contact with the device housing, it is determined whether the voltage between the target wire and the device housing is greater than a first specified voltage and less than a second specified voltage; and when the voltage between the target wire and the device housing is greater than the first specified voltage and less than the second specified voltage, it is determined that the device housing is not normally grounded, and it is determined that the voltage between the target wire and the device housing satisfies the specified condition.

It should be noted that, in this embodiment of the present invention, when the device housing is not normally grounded, it may be determined that the voltage between the target wire and the device housing satisfies the specified condition, and in this case, it may be determined that the fault occurring in the device is that the device housing is not normally grounded. In this case, a second prompt message may be generated. The second prompt message is used to prompt a user that the device housing is not normally grounded, so that the user can learn a grounding status of the device housing in a timely manner. The grounding status indicates whether the device housing is normally grounded.

In addition, the second specified voltage is equal to the supply voltage minus the first specified voltage, the first specified voltage is less than the second specified voltage, and the second specified voltage is close to the supply voltage.

When the metal core wire in the live wire is not in contact with the device housing, if the device housing is not normally grounded, the voltage between the live wire or the neutral wire and the device housing should be near 1/2 of the supply voltage. Therefore, when the voltage between the target wire and the device housing is greater than the first specified voltage and less than the second specified voltage, it may be determined that the device housing is not normally grounded. For example, the supply voltage is 220 V, the first specified voltage is 5 V, and the second specified voltage is 215 V. Assuming that the voltage between the target wire and the device housing is 210 V, because 210 V is greater than 5 V and less than 215 V, it may be determined that the device housing is not normally grounded.

Further, when the power supply mode of the device is the single-phase power supply, and the metal core wire in the live wire is not in contact with the device housing, it may be further determined whether the voltage between the target wire and the device housing is less than or equal to the first specified voltage, or greater than or equal to the second specified voltage; and when the voltage between the target wire and the device housing is less than or equal to the first specified voltage, or greater than or equal to the second specified voltage, it is determined that the device housing is normally grounded.

When the device housing is normally grounded and the metal core wire in the live wire is not in contact with the device housing, if the target wire is the neutral wire, the voltage between the target wire and the device housing should be less than or equal to the first specified voltage. If the target wire is the live wire, the voltage between the target wire and the device housing should be greater than or equal to the second specified voltage. Therefore, when the voltage between the target wire and the device housing is less than or equal to the first specified voltage, or greater than or equal to the second specified voltage, it may be determined that the device housing is normally grounded. For example, the supply voltage is 220 V, the first specified voltage is 5 V, and the second specified voltage is 215 V. Assuming that the voltage between the target wire and the device housing is 3 V, because 3 V is less than 5 V, it may be determined that the device housing is normally grounded.

Manner 3: When a power supply mode of the device is a single-phase power supply, and the target wire is the live wire, it is determined whether the voltage between the target wire and the device housing is a first contacting voltage, where the first contacting voltage is a voltage between the target wire and the device housing when the metal core wire in the target wire is in contact with the device housing; and when the voltage between the target wire and the device housing is the first contacting voltage, it is determined that the device housing is energized, and it is determined that the voltage between the target wire and the device housing satisfies the specified condition; or when a power supply mode of the device is a single-phase power supply, and the target wire is the neutral wire, it is determined whether the voltage between the target wire and the device housing is a second contacting voltage, where the second contacting voltage is a voltage between the target wire and the device housing when a metal core wire in the live wire different from the target wire is in contact with the device housing; and when the voltage between the target wire and the device housing is the second contacting voltage, it is determined that the device housing is energized, and it is determined that the voltage between the target wire and the device housing satisfies the specified condition.

It should be noted that, in this embodiment of the present invention, when the device housing is energized, it may be determined that the voltage between the target wire and the device housing satisfies the specified condition, and in this case, it may be determined that the fault occurring in the device is that the device housing is energized. In this case, a third prompt message may be generated. The third prompt message is used to prompt a user that the device housing is energized, so that the user can learn an energizing status of the device housing in a timely manner. The energizing status indicates whether the device housing is energized.

In addition, when the power supply mode of the device is the single-phase power supply, and the target wire is the live wire, if the metal core wire in the target wire is in contact with the device housing and consequently, the device housing is energized, an electrical potential of the device housing is close to an electrical potential of the target wire. In this case, the voltage between the target wire and the device housing should be near 0 V. In other words, the first contacting voltage may be greater than or equal to 0 V and less than a third preset voltage, where the third preset voltage may be set in advance. For example, the third preset voltage may be 0.2 V, 0.3 V, or the like. This is not specifically limited in this embodiment of the present invention.

Further, when the power supply mode of the device is the single-phase power supply, and the target wire is the neutral wire, if the live wire different from the target wire is in contact with the device housing and consequently, the device housing is energized, an electrical potential of the device housing is close to an electrical potential of the live wire. In this case, the voltage between the target wire and the device housing should be near the supply voltage. In other words, the second contacting voltage may be greater than a fourth preset voltage and less than or equal to the supply voltage, where the fourth preset voltage may be set in advance. For example, when the supply voltage is 220 V, the fourth preset voltage may be 119 V, 119.5 V, or the like. This is not specifically limited in this embodiment of the present invention.

For example, the target wire is the live wire, and the first contacting voltage is greater than or equal to 0 V and less than 0.3 V. Assuming that the voltage between the target wire and the device housing is 0.2 V, the voltage between the target wire and the device housing is the first contacting voltage, and it may be determined that the device housing is energized.

For another example, the target wire is the neutral wire, the supply voltage is 220 V, and the second contacting voltage is greater than 119 V and less than or equal to 220 V. Assuming that the voltage between the target wire and the device housing is 119.5 V, the voltage between the target wire and the device housing is the second contacting voltage, and it may be determined that the device housing is energized.

It should be noted that, when the power supply mode of the device is the single-phase power supply, before it is determined whether the voltage between the target wire and the device housing satisfies the specified condition, it may be further determined whether the target wire is the live wire or the neutral wire. An operation of determining whether the target wire is the live wire or the neutral wire may be: When the metal core wire in the live wire is not in contact with the device housing, if the voltage between the target wire and the device housing is less than or equal to the first specified voltage, it is determined that the target wire is the neutral wire. When the metal core wire in the live wire is not in contact with the device housing, if the voltage between the target wire and the device housing is greater than or equal to the second specified voltage, it is determined that the target wire is the live wire.

It should be noted that the foregoing process of determining whether the target wire is the live wire or the neutral wire is a process of determining whether the live wire and the neutral wire connected to the device are correctly connected or inversely connected. In other words, when the target wire is the live wire, it may be determined that the live wire and the neutral wire connected to the device are correctly connected; or when the target wire is the neutral wire, it may be determined that the live wire and the neutral wire connected to the device are inversely connected.

When the voltage between the target wire and the device housing is less than or equal to the first specified voltage, the voltage between the target wire and the device housing is very low and is close to 0 V at a current time. Therefore, when the metal core wire in the live wire is not in contact with the device housing, it may be determined that the target wire is the neutral wire. However, when the voltage between the target wire and the device housing is greater than or equal to the second specified voltage, the voltage between the target wire and the device housing is very large and is close to the supply voltage. Therefore, when the metal core wire in the live wire is not in contact with the device housing, it may be determined that the target wire is the live wire.

For example, the supply voltage is 220 V, the first specified voltage is 5 V, and the second specified voltage is 215 V. Assuming that the voltage between the target wire and the device housing is 3 V, because 3 V is less than 5 V, it may be determined that the target wire is the neutral wire.

For another example, the supply voltage is 220 V, the first specified voltage is 5 V, and the second specified voltage is 215 V. Assuming that the voltage between the target wire and the device housing is 217 V, because 217 V is greater than 215 V, it may be determined that the target wire is the live wire.

When the power supply mode of the device is the single-phase power supply, during fault detection on the device, an operation of performing live detection on the device housing when the target wire is the live wire is different from an operation of performing live detection on the device when the target wire is the neutral wire. Therefore, before the live detection on the device housing is performed, it needs to first determine whether the target wire is the live wire or the neutral wire. Further, only when the metal core wire in the live wire is not in contact with the device housing and the device housing is normally grounded, it may be determined whether the target wire is the live wire or the neutral wire. Therefore, in actual application, when the device is initially installed, or initially powered on, or powered on for the first time after power-off, it can be ensured that the metal core wire in the live wire is not in contact with the device housing, and that the device housing is normally grounded, so that when the device is initially installed, or initially powered on, or powered on for the first time after power-off, it may be determined whether the target wire is the live wire or the neutral wire, thereby further ensuring that the live detection on the device housing can be effectively performed subsequently. In addition, because the connection status of the live wire and the neutral wire generally does not change during a running process of the device, whether the target wire is the live wire or the neutral wire may be determined only once when the device is initially installed, or initially powered on, or powered on for the first time after power-off. There is no need to perform determining again during subsequent detection, thereby saving processing resources.

It should be noted that, in actual application, in the foregoing manner 3, when the target wire is the live wire, the operation of determining whether the voltage between the target wire and the device housing is the first contacting voltage may be implemented by using a flag bit. Specifically, when the target wire is the live wire, if it is detected that the voltage between the target wire and the device housing hops, a voltage that is between the target wire and the device housing and prior to the hopping is obtained, and a first flag bit is determined based on the obtained voltage; and a voltage that is between the target wire and the device housing and after the hopping is obtained, and a second flag bit is determined based on the obtained voltage. When the first flag bit and the second flag bit satisfy a first condition, it is determined that the voltage between the target wire and the device housing is the first contacting voltage.

When the voltage that is between the target wire and the device housing and prior to the hopping is obtained, and the first flag bit is determined based on the obtained voltage, if the obtained voltage is a first normal voltage, the first flag bit is set to 0; or if the obtained voltage is the first contacting voltage, the first flag bit is set to 1.

It should be noted that the first normal voltage is a voltage between the target wire and the device housing when the metal core wire in the target wire is not in contact with the device housing. When the device housing is normally grounded, the first normal voltage may be greater than the fourth preset voltage and less than or equal to the supply voltage. When the device housing is not normally grounded, the first normal voltage may be greater than a fifth preset voltage and less than or equal to 1/2 of the supply voltage, where the fifth preset voltage may be set in advance. For example, when the supply voltage is 220 V, and 1/2 of the supply voltage is 110 V, the fifth preset voltage may be 108 V, 109 V, or the like. This is not specifically limited in this embodiment of the present invention.

For example, the target wire is the live wire, the supply voltage is 220 V, the first normal voltage is greater than 119 V and less than or equal to 220 V, or the first normal voltage is greater than 108 V and less than or equal to 110 V, and the first contacting voltage is greater than or equal to 0 V and less than 0.3 V. Assuming that the obtained voltage that is between the target wire and the device housing and prior to the hopping is 119.5 V, the obtained voltage is the first normal voltage. In this case, the first flag bit may be set to 0.

For another example, the target wire is the live wire, the supply voltage is 220 V, the first normal voltage is greater than 119 V and less than or equal to 220 V, or the first normal voltage is greater than 108 V and less than or equal to 110 V, and the first contacting voltage is greater than or equal to 0 V and less than 0.3 V. Assuming that the obtained voltage that is between the target wire and the device housing and prior to the hopping is 0.2 V, the obtained voltage is the first contacting voltage. In this case, the first flag bit may be set to 1.

An operation of obtaining the voltage that is between the target wire and the device housing and after the hopping and determining the second flag bit based on the obtained voltage is the same as the foregoing operation of determining the first flag bit based on the obtained voltage. Details are not described herein again in this embodiment of the present invention.

It should be noted that the first condition is used to indicate that the device housing hops from a de-energized state to an energized state. For example, the first condition may be that the first flag bit is 0 and the second flag bit is 1. When the first flag bit is 0 and the second flag bit is 1, it may be determined that the voltage between the target wire and the device housing hops from the first normal voltage to the first contacting voltage. Therefore, in this case, it may be determined that the voltage between the target wire and the device housing is the first contacting voltage.

It should be noted that, in actual application, in the foregoing manner 3, when the target wire is the neutral wire, the operation of determining whether the voltage between the target wire and the device housing is the second contacting voltage may be implemented by using a flag bit. Specifically, when the target wire is the neutral wire, if it is detected that the voltage between the target wire and the device housing hops, a voltage that is between the target wire and the device housing and prior to the hopping is obtained, and a third flag bit is determined based on the obtained voltage; and a voltage that is between the target wire and the device housing and after the hopping is obtained, and a fourth flag bit is determined based on the obtained voltage. When the third flag bit and the fourth flag bit satisfy a second condition, it is determined that the voltage between the target wire and the device housing is the second contacting voltage.

When the voltage that is between the target wire and the device housing and prior to the hopping is obtained, and the third flag bit is determined based on the obtained voltage, if the obtained voltage is a second normal voltage, the third flag bit is set to 0; or if the obtained voltage is the second contacting voltage, the third flag bit is set to 1.

It should be noted that the second normal voltage is the voltage between the target wire and the device housing when the metal core wire in the live wire different from the target wire is not in contact with the device housing. When the device housing is normally grounded, the second normal voltage may be greater than or equal to 0 V and less than the third preset voltage. When the device housing is not normally grounded, the second normal voltage may be greater than the fifth preset voltage and less than or equal to 1/2 of the supply voltage.

For example, the target wire is the neutral wire, the supply voltage is 220 V, the second normal voltage is greater than or equal to 0 V and less than 0.3 V, or the second normal voltage is greater than 108 V and less than or equal to 110 V, and the second contacting voltage is greater than 119 V and less than or equal to 220 V. Assuming that the obtained voltage that is between the target wire and the device housing and prior to the hopping is 0.2 V, the obtained voltage is the second normal voltage. In this case, the third flag bit may be set to 0.

For another example, the target wire is the neutral wire, the supply voltage is 220 V, the second normal voltage is greater than or equal to 0 V and less than 0.3 V, or the second normal voltage is greater than 108 V and less than or equal to 110 V, and the second contacting voltage is greater than 119 V and less than or equal to 220 V. Assuming that the obtained voltage that is between the target wire and the device housing and prior to the hopping is 119.5 V, the obtained voltage is the second contacting voltage. In this case, the third flag bit may be set to 1.

An operation of obtaining the voltage that is between the target wire and the device housing and after the hopping and determining the fourth flag bit based on the obtained voltage is the same as the foregoing operation of determining the third flag bit based on the obtained voltage. Details are not described herein again in this embodiment of the present invention.

It should be noted that the second condition is used to indicate that the device housing hops from a de-energized state to an energized state. For example, the second condition may be that the third flag bit is 0 and the fourth flag bit is 1. When the third flag bit is 0 and the fourth flag bit is 1, it may be determined that the voltage between the target wire and the device housing hops from the second normal voltage to the second contacting voltage. Therefore, in this case, it may be determined that the voltage between the target wire and the device housing is the second contacting voltage.

Manner 4: When a power supply mode of the device is a dual-live-wire power supply, it is determined whether the voltage between the target wire and the device housing is a first contacting voltage or a second contacting voltage; and when the voltage between the target wire and the device housing is the first contacting voltage or the second contacting voltage, it is determined that the device housing is energized, and it is determined that the voltage between the target wire and the device housing satisfies the specified condition.

It should be noted that, in this embodiment of the present invention, when the device housing is energized, it may be determined that the voltage between the target wire and the device housing satisfies the specified condition, and in this case, it may be determined that the fault occurring in the device is that the device housing is energized. In this case, the third prompt message may be generated. The third prompt message is used to prompt a user that the device housing is energized, so that the user can learn an energizing status of the device housing in a timely manner.

It should be noted that, when the power supply mode of the device is the dual-live-wire power supply, and if the metal core wire in the target wire is in contact with the device housing and consequently, the device housing is energized, an electrical potential of the device housing is close to an electrical potential of the target wire. In this case, the voltage between the target wire and the device housing should be near 0 V. In other words, in this case, the voltage between the target wire and the device housing should be the first contacting voltage. If the metal core wire in the live wire different from the target wire is in contact with the device housing and consequently, the device housing is energized, the electrical potential of the device housing is close to an electrical potential of the live wire. In this case, the voltage between the target wire and the device housing should be near the supply voltage. In other words, in this case, the voltage between the target wire and the device housing should be the second contacting voltage. Therefore, when the voltage between the target wire and the device housing is the first contacting voltage or the second contacting voltage, it may be determined that the device housing is energized.

For example, the supply voltage is 220 V, the first contacting voltage is greater than or equal to 0 V and less than 0.3 V, and the second contacting voltage is greater than 119 V and less than or equal to 220 V. Assuming that the voltage between the target wire and the device housing is 0.2 V, it may be determined that the voltage between the target wire and the device housing is the first contacting voltage, and it is determined that the device housing is energized.

It should be further noted that, in actual application, in the foregoing manner 4, the operation of determining whether the voltage between the target wire and the device housing is the first contacting voltage or the second contacting voltage may be implemented by using a flag bit. Specifically, if it is detected that the voltage between the target wire and the device housing hops, a voltage that is between the target wire and the device housing and prior to the hopping is obtained, and a fifth flag bit is determined based on the obtained voltage; and a voltage that is between the target wire and the device housing and after the hopping is obtained, and a sixth flag bit is determined based on the obtained voltage. When the fifth flag bit and the sixth flag bit satisfy a third condition, it is determined that the voltage between the target wire and the device housing is the first contacting voltage or the second contacting voltage.

When the voltage that is between the target wire and the device housing and prior to the hopping is obtained, and the fifth flag bit is determined based on the obtained voltage, if the obtained voltage is a third normal voltage, the fifth flag bit is set to 0; or if the obtained voltage is the first contacting voltage or the second contacting voltage, the fifth flag bit is set to 1.

It should be noted that the third normal voltage is a voltage between the target wire and the device housing when neither the target wire nor the metal core wire in the live wire different from the target wire is in contact with the device housing. The third normal voltage may be greater than the fifth preset voltage and less than or equal to 1/2 of the supply voltage.

For example, the supply voltage is 220 V, the third normal voltage is greater than 108 V and less than or equal to 110 V, the first contacting voltage is greater than or equal to 0 V and less than 0.3 V, and the second contacting voltage is greater than 119 V and less than or equal to 220 V. Assuming that the obtained voltage that is between the target wire and the device housing and prior to the hopping is 109 V, the obtained voltage is the third normal voltage. In this case, the fifth flag bit may be set to 0.

For example, the supply voltage is 220 V, the third normal voltage is greater than 108 V and less than or equal to 110 V, the first contacting voltage is greater than or equal to 0 V and less than 0.3 V, and the second contacting voltage is greater than 119 V and less than or equal to 220 V. Assuming that the obtained voltage that is between the target wire and the device housing and prior to the hopping is 0.2 V, the obtained voltage is the first contacting voltage. In this case, the fifth flag bit may be set to 1.

An operation of obtaining the voltage that is between the target wire and the device housing and after the hopping and determining the sixth flag bit based on the obtained voltage is the same as the foregoing operation of determining the fifth flag bit based on the obtained voltage. Details are not described herein again in this embodiment of the present invention.

It should be noted that the third condition is used to indicate that the device housing hops from a de-energized state to an energized state. For example, the third condition may be that the fifth flag bit is 0 and the sixth flag bit is 1. When the fifth flag bit is 0 and the sixth flag bit is 1, it may be determined that the voltage between the target wire and the device housing hops from the third normal voltage to the first contacting voltage, or hops from the third normal voltage to the second contacting voltage. Therefore, in this case, it may be determined that the voltage between the target wire and the device housing is the first contacting voltage or the second contacting voltage.

Manner 5: When a power supply mode of the device is a three-phase power supply, it is determined whether the voltage between the target wire and the device housing is a first contacting voltage or a third contacting voltage, where the third contacting voltage is a voltage between the target wire and the device housing when a metal core wire in any live wire different from the target wire is in contact with the device housing; and when the voltage between the target wire and the device housing is the first contacting voltage or the third contacting voltage, it is determined that the device housing is energized, and it is determined that the voltage between the target wire and the device housing satisfies the specified condition.

It should be noted that, in this embodiment of the present invention, when the device housing is energized, it may be determined that the voltage between the target wire and the device housing satisfies the specified condition, and in this case, it may be determined that the fault occurring in the device is that the device housing is energized. In this case, the third prompt message may be generated. The third prompt message is used to prompt a user that the device housing is energized, so that the user can learn an energizing status of the device housing in a timely manner.

It should be noted that, when the power supply mode of the device is the three-phase power supply, if the metal core wire in the target wire is in contact with the device housing and consequently, the device housing is energized, an electrical potential of the device housing is close to an electrical potential of the target wire. In this case, the voltage between the target wire and the device housing should be near 0 V. In other words, in this case, the voltage between the target wire and the device housing should be the first contacting voltage.

If the metal core wire in any live wire different from the target wire is in contact with the device housing and consequently, the device housing is energized, the electrical potential of the device housing is close to that of the live wire. In this case, the voltage between the target wire and the device housing should be near $\sqrt{3}$ times of the supply voltage. In other words, the third contacting voltage may be greater than a sixth preset voltage and less than or equal to $\sqrt{3}$ times of the supply voltage, where the sixth preset voltage may be set in advance. For example, when the supply voltage is 220 V, the sixth preset voltage may be 373 V, 374 V, or the like. This is not specifically limited in this embodiment of the present invention.

For example, the supply voltage is 220 V, the first contacting voltage is greater than or equal to 0 V and less than 0.3 V, and the third contacting voltage is greater than 373 V and less than or equal to $\sqrt{3} \times 220$ V. Assuming that the voltage between the target wire and the device housing is 0.2 V, it may be determined that the voltage between the target wire and the device housing is the first contacting voltage, and it is determined that the device housing is energized.

It should be further noted that, in actual application, in the foregoing manner 5, the operation of determining whether the voltage between the target wire and the device housing is the first contacting voltage or the third contacting voltage may be implemented by using a flag bit. Specifically, if it is detected that the voltage between the target wire and the device housing hops, a voltage that is between the target wire and the device housing and prior to the hopping is obtained, and a seventh flag bit is determined based on the obtained voltage; and a voltage that is between the target wire and the device housing and after the hopping is obtained, and an eighth flag bit is determined based on the obtained voltage. When the seventh flag bit and the eighth flag bit satisfy a fourth condition, it is determined that the voltage between the target wire and the device housing is the first contacting voltage or the third contacting voltage.

When the voltage that is between the target wire and the device housing and prior to the hopping is obtained, and the seventh flag bit is determined based on the obtained voltage, if the obtained voltage is a fourth normal voltage, the seventh flag bit is set to 0; or if the obtained voltage is the first contacting voltage or the third contacting voltage, the seventh flag bit is set to 1.

It should be noted that the fourth normal voltage is a voltage between the target wire and the device housing when neither the target wire nor the metal core wire in the live wire different from the target wire is in contact with the device housing. When the device is normally grounded, the fourth normal voltage may be greater than the fourth preset voltage and less than or equal to the supply voltage. When the device housing is not normally grounded, the fourth normal voltage may be greater than the fifth preset voltage and less than or equal to 1/2 of the supply voltage.

For example, the supply voltage is 220 V, the fourth normal voltage is greater than 119 V and less than or equal to 220 V, or the fourth normal voltage is greater than 108 V and less than or equal to 110 V, the first contacting voltage is greater than or equal to 0 V and less than 0.3 V, and the third contacting voltage is greater than 373 V and less than or equal to $\sqrt{3} \times 220$ V. Assuming that the obtained voltage that is between the target wire and the device housing and prior to the hopping is 119.5 V, the obtained voltage is the fourth normal voltage. In this case, the seventh flag bit may be set to 0.

For example, the supply voltage is 220 V, the fourth normal voltage is greater than 119 V and less than or equal to 220 V, or the fourth normal voltage is greater than 108 V and less than or equal to 110 V, the first contacting voltage is greater than or equal to 0 V and less than 0.3 V, and the third contacting voltage is greater than 373 V and less than or equal to $\sqrt{3} \times 220$ V. Assuming that the obtained voltage that is between the target wire and the device housing and prior to the hopping is 0.2 V, the obtained voltage is the first contacting voltage. In this case, the seventh flag bit may be set to 1.

An operation of obtaining the voltage that is between the target wire and the device housing and after the hopping and determining the eighth flag bit based on the obtained voltage is the same as the foregoing operation of determining the seventh flag bit based on the obtained voltage. Details are not described herein again in this embodiment of the present invention.

It should be noted that the fourth condition is used to indicate that the device housing hops from a de-energized state to an energized state. For example, the fourth condition may be that the seventh flag bit is 0 and the eighth flag bit is 1. When the seventh flag bit is 0 and the eighth flag bit is 1, it may be determined that the voltage between the target wire and the device housing hops from the fourth normal voltage to the first contacting voltage, or hops from the fourth normal voltage to the third contacting voltage. Therefore, in this case, it may be determined that the voltage between the target wire and the device housing is the first contacting voltage or the third contacting voltage.

Further, with reference to a logical determining list shown in Table 2, an overall description is given to fault detection operations in the foregoing manner 3, manner 4, and manner 5. $U_{X-E}$ is the voltage between the target wire and the device housing.

## Table 2

| Stage<br><br>$U_{X-E}$<br><br>Power supply mode | | Initial | Final | Determining basis | Conclusion |
|---|---|---|---|---|---|
| Single-phase power supply | Correctly connected | First normal voltage | First contacting voltage | First normal voltage → first contacting voltage | A device housing is energized. |
| | Inversely connected | Second normal voltage | Second contacting voltage | Second normal voltage → second contacting voltage | A device housing is energized. |
| Dual-live-wire power supply | | Third normal voltage | First contacting voltage | Third normal voltage → first contacting voltage | A device housing is energized. |
| | | | Second contacting voltage | Third normal voltage → second contacting voltage | A device housing is energized. |
| Three-phase power supply | | Fourth normal voltage | First contacting voltage | Fourth normal voltage → first contacting voltage | A device housing is energized. |
| | | | Third contacting voltage | Fourth normal voltage → third contacting voltage | A device housing is energized. |

It should be noted that, in this embodiment of the present invention, the logical determining list shown in the foregoing Table 2 is merely used as an example for description. The foregoing Table 2 does not constitute a limitation on this embodiment of the present invention.

As shown in Table 2, when the power supply mode of the device is the single-phase power supply, and the live wire and the neutral wire connected to the device are correctly connected, if it is detected that the voltage between the target wire and the device housing hops from the first normal voltage to the first contacting voltage, it may be determined that the device housing is energized. When the power supply mode of the device is the single-phase power supply, and the live wire and the neutral wire connected to the device are inversely connected, if it is detected that the voltage between the target wire and the device housing hops from the second normal voltage to the second contacting voltage, it may be determined that the device housing is energized.

When the power supply mode of the device is the dual-live-wire power supply, if it is detected that the voltage between the target wire and the device housing hops from the third normal voltage to the first contacting voltage, or it is detected that the voltage between the target wire and the device housing hops from the third normal voltage to the second contacting voltage, it may be determined that the device housing is energized.

When the power supply mode of the device is the three-phase power supply, if it is detected that the voltage between the target wire and the device housing hops from the fourth normal voltage to the first contacting voltage, or it is detected that the voltage between the target wire and the device housing hops from the fourth normal voltage to the third contacting voltage, it may be determined that the device housing is energized.

In this embodiment of the present invention, the voltage between the target wire and the device housing is determined, and it is determined whether the voltage between the target wire and the device housing satisfies the specified condition. When the voltage between the target wire and the device housing satisfies the specified condition, it is determined that the fault occurs in the device. The target wire may be either a live wire or a neutral wire. Therefore, fault detection can be performed on the device regardless of whether the live wire and the neutral wire connected to the device are correctly connected or inversely connected. In addition, the specified condition is used to indicate that the fault occurs in the device, and the fault includes at least one of the following: the live wire and the neutral wire connected to the device are inversely connected, the device housing is not normally grounded, and the device housing is energized. Therefore, detection on three types of faults can be simultaneously performed in this embodiment of the present invention, and a fault detection capability is relatively strong.

A person of ordinary skill in the art may understand that all or some of the steps of the embodiments may be implemented by hardware or a program instructing related hardware. The program may be stored in a computer-readable storage medium. The storage medium mentioned above may be a read-only memory, a magnetic disk, an optical disc, or the like.

The foregoing descriptions are merely example embodiments of the present invention, but are not intended to limit the present invention. The invention is defined by the claims.

**Claims**

1. A detection circuit, wherein the detection circuit is configured to detect a device, and the detection circuit comprises a first isolation module (1), a first resistor (R1), a second resistor (R2), a first signal collection module (2), and a signal processing module (3);

   the first isolation module comprises a first isolation unit (1A) and a second isolation unit (1B), and a resistance value of the first isolation unit is equal to that of the second isolation unit; an end of the first isolation unit is connected to a target wire (X), and an end of the second isolation unit is connected to a device housing (E); the first isolation module is configured to isolate the target wire from the device housing, and is configured to isolate a primary circuit from a secondary circuit, wherein the primary circuit comprises the target wire and a power supply of the device, and the secondary circuit comprises the first resistor, the second resistor, the first signal collection module, and the signal processing module; and the target wire is configured to supply power to the device, the target wire is a live wire or a neutral wire, and the device housing is a housing of the device; a first input end (2a) of the first signal collection module and an end of the first resistor are separately connected to the other end of the first isolation unit, a second input end (2b) of the first signal collection module and an end of the second resistor are separately connected to the other end of the second isolation unit, the other end of the first resistor and the other end of the second resistor are separately connected to a reference ground (GND), an output end (2c) of the first signal collection module is connected to an input end (3a) of the signal processing module, and a grounding end (3b) of the signal processing module is connected to the reference ground;
   the first resistor and the second resistor are configured to divide a voltage, and a resistance value of the first resistor is equal to that of the second resistor; the first signal collection module is configured to separately collect a voltage at both ends of the first resistor and a voltage at both ends of the second resistor, determine the collected voltage at both ends of the first resistor as a first voltage, determine the collected voltage at both ends of the second resistor as a second voltage, and multiply a voltage difference between the first voltage and the second voltage by a specified proportion, to obtain a third voltage within a detection range of the signal processing module, and input the third voltage to the signal processing module; and
   the signal processing module is configured to: perform reverse processing on the third voltage based on a process of processing a voltage between the target wire and the device housing by the first isolation module, the first resistor, the second resistor, and the first signal collection module, to obtain the voltage between the target wire and the device housing; and when the voltage between the target wire and the device housing satisfies a specified condition, determine that a fault occurs in the device, wherein the specified condition is used to indicate that the fault occurs in the device, and the fault comprises at least one of the following: the live wire and the neutral wire connected to the device are inversely connected, the device housing is not normally grounded, and the device housing is energized.

2. The detection circuit according to claim 1, wherein the detection circuit further comprises a signal conditioning module, an input end of the signal conditioning module is connected to the output end of the first signal collection module, and an output end of the signal conditioning module is connected to the input end of the signal processing module; and
the signal conditioning module is configured to condition the third voltage received from the first signal collection module to a voltage within an acceptable range of the signal processing module, and input the conditioned third voltage to the signal processing module.

3. The detection circuit according to claim 1 or 2, wherein the first isolation unit comprises N resistors in series, and a total resistance value of the N resistors in series is greater than or equal to a specified resistance value, wherein N is a natural number greater than or equal to 1, and the specified resistance value is a resistance value that satisfies reinforced insulation required by a security standard.

4. The detection circuit according to claim 1 or 2, wherein the second isolation unit comprises M resistors in series, and a total resistance value of the M resistors in series is greater than or equal to a specified resistance value, wherein M is a natural number greater than or equal to 1, and the specified resistance value is a resistance value that satisfies reinforced insulation required by a security standard.

5. The detection circuit according to claim 1, wherein the signal processing module is configured to:

when a power supply mode of the device is a single-phase power supply, and a metal core wire in the live wire is not in contact with the device housing, determine whether the voltage between the target wire and the device housing is less than or equal to a first specified voltage, wherein the first specified voltage is a voltage between the neutral wire and the device housing when the device housing is normally grounded and the metal core wire in the live wire is not in contact with the device housing; and
when the voltage between the target wire and the device housing is less than or equal to the first specified voltage, determine that the live wire and the neutral wire connected to the device are inversely connected, and determine that the voltage between the target wire and the device housing satisfies the specified condition.

6. The detection circuit according to claim 1, wherein the signal processing module is configured to:

when a power supply mode of the device is a single-phase power supply, and a metal core wire in the live wire is not in contact with the device housing, determine whether the voltage between the target wire and the device housing is greater than a first specified voltage and less than a second specified voltage, wherein the second specified voltage is equal to a supply voltage of the device minus the first specified voltage, and the first specified voltage is less than the second specified voltage; and
when the voltage between the target wire and the device housing is greater than the first specified voltage and less than the second specified voltage, determine that the device housing is not normally grounded, and determine that the voltage between the target wire and the device housing satisfies the specified condition.

7. The detection circuit according to claim 1, wherein the signal processing module is configured to:

when a power supply mode of the device is a single-phase power supply, and the target wire is the live wire, determine whether the voltage between the target wire and the device housing is a first contacting voltage, wherein the first contacting voltage is a voltage between the target wire and the device housing when a metal core wire in the target wire is in contact with the device housing; and when the voltage between the target wire and the device housing is the first contacting voltage, determine that the device housing is energized, and determine that the voltage between the target wire and the device housing satisfies the specified condition; or
when a power supply mode of the device is a single-phase power supply, and the target wire is the neutral wire, determine whether the voltage between the target wire and the device housing is a second contacting voltage, wherein the second contacting voltage is a voltage between the target wire and the device housing when a metal core wire in the live wire different from the target wire is in contact with the device housing; and when the voltage between the target wire and the device housing is the second contacting voltage, determine that the device housing is energized, and determine that the voltage between the target wire and the device housing satisfies the specified condition.

8. The detection circuit according to claim 7, wherein the signal processing module is further configured to:

when the metal core wire in the live wire is not in contact with the device housing, if the voltage between the target wire and the device housing is less than or equal to a first specified voltage, determine that the target wire is the neutral wire; or
when the metal core wire in the live wire is not in contact with the device housing, if the voltage between the target wire and the device housing is greater than or equal to a second specified voltage, determine that the target wire is the live wire.

9. The detection circuit according to claim 1, wherein the signal processing module is configured to:

when a power supply mode of the device is a dual-live-wire power supply, determine whether the voltage between the target wire and the device housing is a first contacting voltage or a second contacting voltage; and
when the voltage between the target wire and the device housing is the first contacting voltage or the second contacting voltage, determine that the device housing is energized, and determine that the voltage between the target wire and the device housing satisfies the specified condition.

10. The detection circuit according to claim 1, wherein the signal processing module is configured to:

when a power supply mode of the device is a three-phase power supply, determine whether the voltage between the target wire and the device housing is a first contacting voltage or a third contacting voltage, wherein the third contacting voltage is a voltage between the target wire and the device housing when a metal core wire in any live wire different from the target wire is in contact with the device housing; and
when the voltage between the target wire and the device housing is the first contacting voltage or the third contacting voltage, determine that the device housing is energized, and determine that the voltage between the target wire and the device housing satisfies the specified condition.

11. The detection circuit according to claim 1, wherein the signal processing module is further configured to:

when a power supply mode of the device is a single-phase power supply, and a metal core wire in the live wire is not in contact with the device housing, determine whether the voltage between the target wire and the device housing is less than or equal to a first specified voltage, or greater than or equal to a second specified voltage; and
when the voltage between the target wire and the device housing is less than or equal to the first specified voltage, or greater than or equal to the second specified voltage, determine that the device housing is normally grounded.

12. A detection circuit, wherein the detection circuit is configured to detect a device, and the detection circuit comprises a second isolation module (5), a tenth resistor (R10), a second signal collection module (6), and a signal processing module (3); and an end of the second isolation module is connected to a target wire (X), an input end (6a) of the second signal collection module and an end of the tenth resistor are separately connected to the other end of the second isolation module, the other end of the tenth resistor is connected to a reference ground (GND), the reference ground is connected to a device housing (E), an output end (6b) of the second signal collection module is connected to an input end (4a) of a signal conditioning module (4), and a grounding end (3b) of the signal processing module is connected to the reference ground; and

the target wire is configured to supply power to the device, the target wire is a live wire or a neutral wire, and the device housing is a housing of the device; the tenth resistor is configured to divide a voltage, the second isolation module is configured to isolate the target wire from the device housing, and is configured to isolate a primary circuit from a secondary circuit, wherein the primary circuit comprises the target wire and a power supply of the device, and the secondary circuit comprises the tenth resistor, the second signal collection module, and the signal processing module; and the second signal collection module is configured to collect a voltage at both ends of the tenth resistor, determine the collected voltage at both ends of the tenth resistor as a fourth voltage, and input the fourth voltage to the signal processing module; and
the signal processing module is configured to: perform reverse processing on the fourth voltage based on a process of processing a voltage between the target wire and the device housing by the second isolation module, the tenth resistor, and the second signal collection module, to obtain the voltage between the target wire and the device housing; and when the voltage between the target wire and the device housing satisfies a specified condition, determine that a fault occurs in the device, wherein the specified condition is used to indicate that the fault occurs in the device, and the fault comprises at least one of the following: the live wire and the neutral wire connected to the device are inversely connected, the device housing is not normally grounded, and the device housing is energized;

wherein an output end (4b) of the signal conditioning module is connected to an input end (3a) of the signal processing module; and

the signal conditioning module is configured to condition the fourth voltage received by the second signal collection module to a voltage within an acceptable range of the signal processing module, and input the conditioned fourth voltage to the signal processing module.

13. The detection circuit according to claim 12, wherein the second isolation module comprises N resistors in series, and a total resistance value of the N resistors in series is greater than or equal to a specified resistance value, wherein N is a natural number greater than or equal to 1, and the specified resistance value is a resistance value that satisfies reinforced insulation required by a security standard.

14. The detection circuit according to claim 12, wherein the signal processing module is configured to:

when a power supply mode of the device is a single-phase power supply, and a metal core wire in the live wire is not in contact with the device housing, determine whether the voltage between the target wire and the device housing is less than or equal to a first specified voltage, wherein the first specified voltage is a voltage between the neutral wire and the device housing when the device housing is normally grounded and the metal core wire in the live wire is not in contact with the device housing; and

when the voltage between the target wire and the device housing is less than or equal to the first specified voltage, determine that the live wire and the neutral wire connected to the device are inversely connected, and determine that the voltage between the target wire and the device housing satisfies the specified condition.

15. The detection circuit according to claim 12, wherein the signal processing module is configured to:

when a power supply mode of the device is a single-phase power supply, and a metal core wire in the live wire is not in contact with the device housing, determine whether the voltage between the target wire and the device housing is greater than a first specified voltage and less than a second specified voltage, wherein the second specified voltage is equal to a supply voltage of the device minus the first specified voltage, and the first specified voltage is less than the second specified voltage; and

when the voltage between the target wire and the device housing is greater than the first specified voltage and less than the second specified voltage, determine that the device housing is not normally grounded, and determine that the voltage between the target wire and the device housing satisfies the specified condition.

16. The detection circuit according to claim 12, wherein the signal processing module is configured to:

when a power supply mode of the device is a single-phase power supply, and the target wire is the live wire, determine whether the voltage between the target wire and the device housing is a first contacting voltage, wherein the first contacting voltage is a voltage between the target wire and the device housing when a metal core wire in the target wire is in contact with the device housing; and when the voltage between the target wire and the device housing is the first contacting voltage, determine that the device housing is energized, and determine that the voltage between the target wire and the device housing satisfies the specified condition; or

when a power supply mode of the device is a single-phase power supply, and the target wire is the neutral wire, determine whether the voltage between the target wire and the device housing is a second contacting voltage, wherein the second contacting voltage is a voltage between the target wire and the device housing when the metal core wire in the live wire different from the target wire is in contact with the device housing; and when the voltage between the target wire and the device housing is the second contacting voltage, determine that the device housing is energized, and determine that the voltage between the target wire and the device housing satisfies the specified condition.

17. The detection circuit according to claim 16, wherein the signal processing module is further configured to: when the metal core wire in the live wire is not in contact with the device housing, if the voltage between the target wire and the device housing is less than or equal to a first specified voltage, determine that the target wire is the neutral wire; or when the metal core wire in the live wire is not in contact with the device housing, if the voltage between the target wire and the device housing is greater than or equal to a second specified voltage, determine that the target wire is the live wire.

**18.** The detection circuit according to claim 12, wherein the signal processing module is configured to:

when a power supply mode of the device is a dual-live-wire power supply, determine whether the voltage between the target wire and the device housing is a first contacting voltage or a second contacting voltage; and when the voltage between the target wire and the device housing is the first contacting voltage or the second contacting voltage, determine that the device housing is energized, and determine that the voltage between the target wire and the device housing satisfies the specified condition.

**19.** The detection circuit according to claim 12, wherein the signal processing module is configured to:

when a power supply mode of the device is a three-phase power supply, determine whether the voltage between the target wire and the device housing is a first contacting voltage or a third contacting voltage, wherein the third contacting voltage is a voltage between the target wire and the device housing when a metal core wire in any live wire different from the target wire is in contact with the device housing; and when the voltage between the target wire and the device housing is the first contacting voltage or the third contacting voltage, determine that the device housing is energized, and determine that the voltage between the target wire and the device housing satisfies the specified condition.

**20.** The detection circuit according to claim 12, wherein the signal processing module is further configured to:

when a power supply mode of the device is a single-phase power supply, and a metal core wire in the live wire is not in contact with the device housing, determine whether the voltage between the target wire and the device housing is less than or equal to a first specified voltage, or greater than or equal to a second specified voltage; and when the voltage between the target wire and the device housing is less than or equal to the first specified voltage, or greater than or equal to the second specified voltage, determine that the device housing is normally grounded.

**21.** A detection method, wherein the method is used to detect a device, and the method comprises:

determining a voltage between a target wire and a device housing, wherein the target wire is configured to supply power to the device, the target wire is a live wire or a neutral wire, and the device housing is a housing of the device; determining whether the voltage between the target wire and the device housing satisfies a specified condition, wherein the specified condition is used to indicate that a fault occurs in the device, and the fault comprises at least one of the following: the live wire and the neutral wire connected to the device are inversely connected, the device housing is not normally grounded, and the device housing is energized; and when the voltage between the target wire and the device housing satisfies the specified condition, determining that the fault occurs in the device; wherein the determining whether the voltage between the target wire and the device housing satisfies a specified condition comprises:

when a power supply mode of the device is a single-phase power supply, and a metal core wire in the live wire is not in contact with the device housing, determining whether the voltage between the target wire and the device housing is greater than a first specified voltage and less than a second specified voltage, wherein the second specified voltage is equal to a supply voltage of the device minus the first specified voltage, and the first specified voltage is less than the second specified voltage; and when the voltage between the target wire and the device housing is greater than the first specified voltage and less than the second specified voltage, determining that the device housing is not normally grounded, and determining that the voltage between the target wire and the device housing satisfies the specified condition.

**22.** The method according to claim 21, wherein the determining whether the voltage between the target wire and the device housing satisfies a specified condition comprises:

when a power supply mode of the device is a single-phase power supply, and a metal core wire in the live wire is not in contact with the device housing, determining whether the voltage between the target wire and the device housing is less than or equal to a first specified voltage, wherein the first specified voltage is a voltage between the neutral wire and the device housing when the device housing is normally grounded and the metal core wire in the live wire is not in contact with the device housing; and
when the voltage between the target wire and the device housing is less than or equal to the first specified voltage, determining that the live wire and the neutral wire connected to the device are inversely connected, and determining that the voltage between the target wire and the device housing satisfies the specified condition.

23. The method according to claim 21, wherein the determining whether the voltage between the target wire and the device housing satisfies a specified condition comprises:

when a power supply mode of the device is a single-phase power supply, and the target wire is the live wire, determining whether the voltage between the target wire and the device housing is a first contacting voltage, wherein the first contacting voltage is a voltage between the target wire and the device housing when a metal core wire in the target wire is in contact with the device housing; and when the voltage between the target wire and the device housing is the first contacting voltage, determining that the device housing is energized, and determining that the voltage between the target wire and the device housing satisfies the specified condition; or when a power supply mode of the device is a single-phase power supply, and the target wire is the neutral wire, determining whether the voltage between the target wire and the device housing is a second contacting voltage, wherein the second contacting voltage is a voltage between the target wire and the device housing when the metal core wire in the live wire different from the target wire is in contact with the device housing; and when the voltage between the target wire and the device housing is the second contacting voltage, determining that the device housing is energized, and determining that the voltage between the target wire and the device housing satisfies the specified condition.

24. The method according to claim 23, before the determining whether the voltage between the target wire and the device housing satisfies a specified condition, further comprising:

when the metal core wire in the live wire is not in contact with the device housing, if the voltage between the target wire and the device housing is less than or equal to a first specified voltage, determining that the target wire is the neutral wire; or when the metal core wire in the live wire is not in contact with the device housing, if the voltage between the target wire and the device housing is greater than or equal to a second specified voltage, determining that the target wire is the live wire.

25. The method according to claim 21, wherein the determining whether the voltage between the target wire and the device housing satisfies a specified condition comprises:

when a power supply mode of the device is a dual-live-wire power supply, determining whether the voltage between the target wire and the device housing is a first contacting voltage or a second contacting voltage; and when the voltage between the target wire and the device housing is the first contacting voltage or the second contacting voltage, determining that the device housing is energized, and determining that the voltage between the target wire and the device housing satisfies the specified condition.

26. The method according to claim 21, wherein the determining whether the voltage between the target wire and the device housing satisfies a specified condition comprises:

when a power supply mode of the device is a three-phase power supply, determining whether the voltage between the target wire and the device housing is a first contacting voltage or a third contacting voltage, wherein the third contacting voltage is a voltage between the target wire and the device housing when a metal core wire in any live wire different from the target wire is in contact with the device housing; and when the voltage between the target wire and the device housing is the first contacting voltage or the third contacting voltage, determining that the device housing is energized, and determining that the voltage between the target wire and the device housing satisfies the specified condition.

27. The method according to any one of claims 21 to 25, wherein the method further comprises:

when the power supply mode of the device is the single-phase power supply, and the metal core wire in the live wire is not in contact with the device housing, determining whether the voltage between the target wire and the device housing is less than or equal to the first specified voltage, or greater than or equal to the second specified voltage; and

when the voltage between the target wire and the device housing is less than or equal to the first specified voltage, or greater than or equal to the second specified voltage, determining that the device housing is normally grounded.

**Patentansprüche**

1. Detektionsschaltung, wobei die Detektionsschaltung dazu konfiguriert ist, eine Vorrichtung zu detektieren, und

wobei die Detektionsschaltung ein erstes Isolationsmodul (1), einen ersten Widerstand (R1), einen zweiten Widerstand (R2), ein erstes
Signalaufnahmemodul (2) und ein Signalverarbeitungsmodul (3) umfasst;
wobei das erste Isolationsmodul eine erste Isolationseinheit (1A) und eine zweite Isolationseinheit (1B) umfasst, und ein Widerstandswert der ersten Isolationseinheit gleich jenem der zweiten Isolationseinheit ist; wobei ein Ende der ersten Isolationseinheit mit einem Zieldraht (X) verbunden ist und ein Ende der zweiten Isolationseinheit mit einem Vorrichtungsgehäuse (E) verbunden ist;
wobei das erste Isolationsmodul dazu konfiguriert ist, den Zieldraht von dem Vorrichtungsgehäuse zu isolieren, und dazu konfiguriert ist, eine primäre Schaltung von einer sekundären Schaltung zu isolieren, wobei die primäre Schaltung den Zieldraht und eine Stromversorgung der Vorrichtung umfasst und die sekundäre Schaltung den ersten Widerstand, den zweiten Widerstand, das erste Signalaufnahmemodul und das Signalverarbeitungsmodul umfasst; und wobei der Zieldraht dazu konfiguriert ist, die Vorrichtung mit Strom zu versorgen, wobei der Zieldraht ein stromführender Draht oder ein neutraler Draht ist und das Vorrichtungsgehäuse ein Gehäuse der Vorrichtung ist;
wobei ein erstes Eingangsende (2a)
des ersten Signalaufnahmemoduls und ein Ende des ersten Widerstands
separat mit dem anderen Ende der ersten Isolationseinheit verbunden sind, ein zweites Eingangsende (2b) des ersten Signalaufnahmemoduls und ein Ende des zweiten Widerstands separat mit dem anderen Ende der zweiten Isolationseinheit verbunden sind, wobei das andere Ende des ersten Widerstands und das andere Ende des zweiten Widerstands separat mit einer Referenzerdung (GND) verbunden sind, ein Ausgangsende (2c) des ersten
Signalaufnahmemoduls mit einem Eingangsende (3a)
des Signalverarbeitungsmoduls verbunden ist und ein Erdungsende (3b) des Signalverarbeitungsmoduls mit der Referenzerdung verbunden ist;
wobei der erste Widerstand und der zweite Widerstand dazu konfiguriert sind, eine Spannung aufzuteilen und ein Widerstandswert des ersten Widerstands gleich jenem des zweiten Widerstands ist; wobei das erste Signalaufnahmemodul dazu konfiguriert ist, eine Spannung an beiden Enden des ersten Widerstands und eine Spannung an beiden Enden des zweiten Widerstands separat zu aufzunehmen, die aufgenommene Spannung an beiden Enden des ersten Widerstands als eine erste Spannung zu bestimmen, die aufgenommene Spannung an beiden Enden des zweiten Widerstands als eine zweite Spannung zu bestimmen und eine Spannungsdifferenz zwischen der ersten Spannung und der zweiten Spannung mit einem festgelegten Verhältnis zu multiplizieren, um eine dritte Spannung innerhalb eines Detektionsbereichs des Signalverarbeitungsmoduls zu erhalten, und die dritte Spannung dem Signalverarbeitungsmodul zuzuführen; und
wobei das Signalverarbeitungsmodul zu Folgendem konfiguriert ist: Durchführen von Umkehrverarbeitung an der dritten Spannung basierend auf einem Prozess des Verarbeitens einer Spannung zwischen dem Zieldraht und dem Vorrichtungsgehäuse durch das erste Isolationsmodul, den ersten Widerstand, den zweiten Widerstand und das erste Signalaufnahmemodul, um die Spannung zwischen dem Zieldraht und dem Vorrichtungsgehäuse zu erhalten; und, wenn die Spannung zwischen dem Zieldraht und dem Vorrichtungsgehäuse eine festgelegte Bedingung erfüllt, Bestimmen, dass in der Vorrichtung ein Fehler auftritt, wobei die festgelegte Bedingung dazu verwendet wird, anzugeben, dass der Fehler in der Vorrichtung auftritt, und der Fehler mindestens eines des Folgenden umfasst: der stromführende Draht und der neutrale Draht, die mit der Vorrichtung verbunden sind, sind invers verbunden, das Vorrichtungsgehäuse ist nicht ordnungsgemäß geerdet und das Vorrichtungsgehäuse ist energetisiert.

2. Detektionsschaltung nach Anspruch 1, wobei die Detektionsschaltung ferner ein Signalkonditionierungsmodul umfasst, ein Eingangsende des Signalkonditionierungsmoduls mit dem Ausgangsende des ersten Signalaufnahmemoduls verbunden ist und ein Ausgangsende des Signalkonditionierungsmoduls mit dem Eingangsende des Signalverarbeitungsmoduls verbunden ist; und das Signalkonditionierungsmodul dazu konfiguriert ist, die von dem ersten Signalaufnahmemodul aufgenommene dritte Spannung in eine Spannung innerhalb eines akzeptablen Bereichs des Signalverarbeitungsmoduls zu konditionieren und die konditionierte dritte Spannung dem Signalverarbeitungsmodul zuzuführen.

3. Detektionsschaltung nach Anspruch 1 oder 2, wobei die erste Isolationseinheit N in Reihe geschaltete Widerstände umfasst und ein Gesamtwiderstandswert der N in Reihe geschalteten Widerstände größer oder gleich einem festgelegten Widerstandswert ist, wobei N eine natürliche Zahl größer oder gleich 1 ist und der festgelegte Widerstandswert ein Widerstandswert ist, der eine durch einen Sicherheitsstandard erforderliche verstärkte Isolation erfüllt.

4. Detektionsschaltung nach Anspruch 1 oder 2, wobei die zweite Isolationseinheit M in Reihe geschaltete Widerstände umfasst und ein Gesamtwiderstandswert der M in Reihe geschalteten Widerstände größer oder gleich einem festgelegten Widerstandswert ist, wobei M eine natürliche Zahl größer oder gleich 1 ist und der festgelegte Widerstandswert ein Widerstandswert ist, der eine nach einem Sicherheitsstandard erforderliche verstärkte Isolierung erfüllt.

5. Detektionsschaltung nach Anspruch 1, wobei das Signalverarbeitungsmodul zu Folgendem konfiguriert ist:

wenn ein Stromversorgungsmodus der Vorrichtung eine einphasige Stromversorgung ist und ein Metallkerndraht in dem stromführenden Draht nicht in Kontakt mit dem Vorrichtungsgehäuse steht, Bestimmen, ob die Spannung zwischen dem Zieldraht und dem Vorrichtungsgehäuse kleiner oder gleich einer ersten festgelegten Spannung ist, wobei die erste festgelegte Spannung eine Spannung zwischen dem neutralen Draht und dem Vorrichtungsgehäuse ist, wenn das Vorrichtungsgehäuse ordnungsgemäß geerdet ist und der Metallkerndraht in dem stromführenden Draht nicht in Kontakt mit dem Vorrichtungsgehäuse steht; und
wenn die Spannung zwischen dem Zieldraht und dem Vorrichtungsgehäuse kleiner oder gleich der ersten festgelegten Spannung ist, Bestimmen, dass der stromführende Draht und der neutrale Draht, die mit der Vorrichtung verbunden sind, invers verbunden sind, und Bestimmen, dass die Spannung zwischen dem Zieldraht und dem Vorrichtungsgehäuse die festgelegte Bedingung erfüllt.

6. Detektionsschaltung nach Anspruch 1, wobei das Signalverarbeitungsmodul zu Folgendem konfiguriert ist:

wenn ein Stromversorgungsmodus der Vorrichtung eine einphasige Stromversorgung ist und ein Metallkerndraht in dem stromführenden Draht nicht in Kontakt mit dem Vorrichtungsgehäuse steht, Bestimmen, ob die Spannung zwischen dem Zieldraht und dem Vorrichtungsgehäuse größer als eine erste festgelegte Spannung und kleiner als eine zweite festgelegte Spannung ist, wobei die zweite festgelegte Spannung gleich einer Versorgungsspannung der Vorrichtung minus der ersten festgelegten Spannung ist und die erste festgelegte Spannung kleiner als die zweite festgelegte Spannung ist; und
wenn die Spannung zwischen dem Zieldraht und dem Vorrichtungsgehäuse größer als die erste festgelegte Spannung und kleiner als die zweite festgelegte Spannung ist, Bestimmen, dass das Vorrichtungsgehäuse nicht ordnungsgemäß geerdet ist, und Bestimmen, dass die Spannung zwischen dem Zieldraht und dem Vorrichtungsgehäuse die festgelegte Bedingung erfüllt.

7. Detektionsschaltung nach Anspruch 1, wobei das Signalverarbeitungsmodul zu Folgendem konfiguriert ist:

wenn ein Stromversorgungsmodus der Vorrichtung eine einphasige Stromversorgung ist und der Zieldraht der stromführende Draht ist, Bestimmen, ob die Spannung zwischen dem Zieldraht und dem Vorrichtungsgehäuse eine erste Kontaktspannung ist, wobei die erste Kontaktspannung eine Spannung zwischen dem Zieldraht und dem Vorrichtungsgehäuse ist, wenn ein Metallkerndraht in dem Zieldraht in Kontakt mit dem Vorrichtungsgehäuse steht; und
wenn die Spannung zwischen dem Zieldraht und dem Vorrichtungsgehäuse die erste Kontaktspannung ist, Bestimmen, dass das Vorrichtungsgehäuse energetisiert ist, und Bestimmen, dass die Spannung zwischen dem Zieldraht und dem Vorrichtungsgehäuse die festgelegte Bedingung erfüllt; oder
wenn ein Stromversorgungsmodus der Vorrichtung eine einphasige Stromversorgung ist und der Zieldraht der neutrale Draht ist, Bestimmen, ob die Spannung zwischen dem Zieldraht und dem Vorrichtungsgehäuse eine zweite Kontaktspannung ist, wobei die zweite Kontaktspannung eine Spannung zwischen dem Zieldraht und dem Vorrichtungsgehäuse ist, wenn ein Metallkerndraht in dem stromführenden Draht, der nicht der Zieldraht ist, in Kontakt mit dem Vorrichtungsgehäuse steht; und wenn die Spannung zwischen dem Zieldraht und dem Vorrichtungsgehäuse die zweite Kontaktspannung ist, Bestimmen, dass das Vorrichtungsgehäuse energetisiert ist, und Bestimmen, dass die Spannung zwischen dem Zieldraht und dem Vorrichtungsgehäuse die festgelegte Bedingung erfüllt.

8. Detektionsschaltung nach Anspruch 7, wobei das Signalverarbeitungsmodul ferner zu Folgendem konfiguriert ist:

wenn der Metallkerndraht in dem stromführenden Draht nicht in Kontakt mit dem Vorrichtungsgehäuse steht und falls die Spannung zwischen dem Zieldraht und dem Vorrichtungsgehäuse kleiner oder gleich einer ersten festgelegten Spannung ist, Bestimmen, dass der Zieldraht der neutrale Draht ist; oder
wenn der Metallkerndraht in dem stromführenden Draht nicht in Kontakt mit dem Vorrichtungsgehäuse steht und falls die Spannung zwischen dem Zieldraht und dem Vorrichtungsgehäuse größer oder gleich einer zweiten festgelegten Spannung ist, Bestimmen, dass der Zieldraht der stromführende Draht ist.

9. Detektionsschaltung nach Anspruch 1, wobei das Signalverarbeitungsmodul zu Folgendem konfiguriert ist:

wenn ein Stromversorgungsmodus der Vorrichtung eine Stromversorgung mit zwei stromführenden Drähten ist, Bestimmen, ob die Spannung zwischen dem Zieldraht und dem Vorrichtungsgehäuse eine erste Kontaktspannung oder eine zweite Kontaktspannung ist; und
wenn die Spannung zwischen dem Zieldraht und dem Vorrichtungsgehäuse die erste Kontaktspannung oder die zweite Kontaktspannung ist, Bestimmen, dass das Vorrichtungsgehäuse energetisiert ist, und Bestimmen, dass die Spannung zwischen dem Zieldraht und dem Vorrichtungsgehäuse die festgelegte Bedingung erfüllt.

10. Detektionsschaltung nach Anspruch 1, wobei das Signalverarbeitungsmodul zu Folgendem konfiguriert ist:

wenn ein Stromversorgungsmodus der Vorrichtung eine dreiphasige Stromversorgung ist, Bestimmen, ob die Spannung zwischen dem Zieldraht und dem Vorrichtungsgehäuse eine erste Kontaktspannung oder eine dritte Kontaktspannung ist, wobei die dritte Kontaktspannung eine Spannung zwischen dem Zieldraht und dem Vorrichtungsgehäuse ist, wenn ein Metallkerndraht in einem beliebigen stromführenden Draht, der nicht der Zieldraht ist, in Kontakt mit dem Vorrichtungsgehäuse steht; und
wenn die Spannung zwischen dem Zieldraht und dem Vorrichtungsgehäuse die erste Kontaktspannung oder die dritte Kontaktspannung ist, Bestimmen, dass das Vorrichtungsgehäuse energetisiert ist, und Bestimmen, dass die Spannung zwischen dem Zieldraht und dem Vorrichtungsgehäuse die festgelegte Bedingung erfüllt.

11. Detektionsschaltung nach Anspruch 1, wobei das Signalverarbeitungsmodul ferner zu Folgendem konfiguriert ist:

wenn ein Stromversorgungsmodus der Vorrichtung eine einphasige Stromversorgung ist und ein Metallkerndraht in dem stromführenden Draht nicht in Kontakt mit dem Vorrichtungsgehäuse steht, Bestimmen, ob die Spannung zwischen dem Zieldraht und dem Vorrichtungsgehäuse kleiner oder gleich einer ersten festgelegten Spannung oder größer oder gleich einer zweiten festgelegten Spannung ist; und
wenn die Spannung zwischen dem Zieldraht und dem Vorrichtungsgehäuse kleiner oder gleich der ersten festgelegten Spannung oder größer oder gleich der zweiten festgelegten Spannung ist, Bestimmen, dass das Vorrichtungsgehäuse ordnungsgemäß geerdet ist.

12. Detektionschaltung, wobei die Detektionschaltung zum Detektieren einer Vorrichtung konfiguriert ist und die Detektionschaltung ein zweites Isolationsmodul (5), einen zehnten Widerstand (R10)

ein zweites
Signalaufnahmemodul (6) und ein Signalverarbeitungsmodul (3) umfasst;
und wobei ein Ende des zweiten Isolationsmoduls
mit einem Zieldraht (X) verbunden ist, ein Eingangsende (6a) des zweiten Signalaufnahmemoduls und eine Ende des zehnten Widerstands separat mit dem anderen Ende des zweiten Isolationsmoduls verbunden sind und das andere Ende des zehnten Widerstands mit einer Referenzerdung (GND) verbunden ist.
wobei die Referenzerdung
mit einem Vorrichtungsgehäuse (E) verbunden ist, ein Ausgangsende (6b)
des zweiten Signalaufnahmemoduls mit
mit einem Eingangsende (4a) eines Signalkonditionierungsmoduls (4) verbunden ist und ein Erdungsende (3b) des Signalverarbeitungsmoduls mit der Referenzerdung verbunden ist; und
wobei der Zieldraht dazu konfiguriert ist, die Vorrichtung mit Strom zu versorgen, der Zieldraht ein stromführender Draht oder ein neutraler Draht ist und das Vorrichtungsgehäuse ein Gehäuse der Vorrichtung ist; wobei der zehnte Widerstand dazu konfiguriert ist, eine Spannung aufzuteilen, das zweite Isolationsmodul dazu konfiguriert ist, den Zieldraht von dem Vorrichtungsgehäuse zu isolieren, und dazu konfiguriert ist, eine primäre Schaltung von einer sekundären Schaltung zu isolieren, wobei die primäre Schaltung den Zieldraht und eine Stromversorgung der Vorrichtung umfasst und die sekundäre Schaltung den zehnten Widerstand, das zweite Signalaufnahmemodul und das Signalverarbeitungsmodul umfasst;

und wobei das zweite Signalaufnahmemodul dazu konfiguriert ist, eine Spannung an beiden Enden des zehnten Widerstands aufzunehmen, die an beiden Enden des zehnten Widerstands aufgenommen Spannung als eine vierte Spannung zu bestimmen und die vierte Spannung dem Signalverarbeitungsmodul zuzuführen; und wobei das Signalverarbeitungsmodul zu Folgendem konfiguriert ist: Durchführen von Umkehrverarbeitung an der vierten Spannung basierend auf einem Prozess des Verarbeitens einer Spannung zwischen dem Zieldraht und dem Vorrichtungsgehäuse durch das zweite Isolationsmodul, den zehnten Widerstand und das zweite Signalaufnahmemodul, um die Spannung zwischen dem Zieldraht und dem Vorrichtungsgehäuse zu erhalten; und, wenn die Spannung zwischen dem Zieldraht und dem Vorrichtungsgehäuse eine festgelegte Bedingung erfüllt, Bestimmen, dass in der Vorrichtung ein Fehler auftritt, wobei die festgelegte Bedingung dazu verwendet wird, anzugeben, dass der Fehler in der Vorrichtung auftritt, und der Fehler mindestens eines des Folgenden umfasst: der stromführende Draht und der neutrale Draht, die mit der Vorrichtung verbunden sind, sind invers verbunden, das Vorrichtungsgehäuse ist nicht ordnungsgemäß geerdet und das Vorrichtungsgehäuse ist energetisiert;

wobei

ein Ausgangsende (4b) des Signalkonditionierungsmoduls mit einem Eingangsende (3a) des Signalverarbeitungsmoduls verbunden ist; und

das Signalkonditionierungsmodul dazu konfiguriert ist, die von dem zweiten Signalaufnahmemodul aufgenommene vierte Spannung in eine Spannung innerhalb eines akzeptablen Bereichs des Signalverarbeitungsmoduls zu konditionieren und die konditionierte vierte Spannung dem Signalverarbeitungsmodul zuzuführen.

13. Detektionsschaltung nach Anspruch 12, wobei die zweite Isolationseinheit N in Reihe geschaltete Widerstände umfasst und ein Gesamtwiderstandswert der N in Reihe geschalteten Widerstände größer oder gleich einem festgelegten Widerstandswert ist, wobei N eine natürliche Zahl größer oder gleich 1 ist und der festgelegte Widerstandswert ein Widerstandswert ist, der eine nach einem Sicherheitsstandard erforderliche verstärkte Isolierung erfüllt.

14. Detektionsschaltung nach Anspruch 12, wobei das Signalverarbeitungsmodul zu Folgendem konfiguriert ist:

wenn ein Stromversorgungsmodus der Vorrichtung eine einphasige Stromversorgung ist und ein Metallkerndraht in dem stromführenden Draht nicht in Kontakt mit dem Vorrichtungsgehäuse steht, Bestimmen, ob die Spannung zwischen dem Zieldraht und dem Vorrichtungsgehäuse kleiner oder gleich einer ersten festgelegten Spannung ist, wobei die erste festgelegte Spannung eine Spannung zwischen dem neutralen Draht und dem Vorrichtungsgehäuse ist, wenn das Vorrichtungsgehäuse ordnungsgemäß geerdet ist und der Metallkerndraht in dem stromführenden Draht nicht in Kontakt mit dem Vorrichtungsgehäuse steht; und wenn die Spannung zwischen dem Zieldraht und dem Vorrichtungsgehäuse kleiner oder gleich der ersten festgelegten Spannung ist, Bestimmen, dass der stromführende Draht und der neutrale Draht, die mit der Vorrichtung verbunden sind, invers verbunden sind, und Bestimmen, dass die Spannung zwischen dem Zieldraht und dem Vorrichtungsgehäuse die festgelegte Bedingung erfüllt.

15. Detektionsschaltung nach Anspruch 12, wobei das Signalverarbeitungsmodul zu Folgendem konfiguriert ist:

wenn ein Stromversorgungsmodus der Vorrichtung eine einphasiges Stromversorgung ist und ein Metallkerndraht in dem stromführenden Draht nicht in Kontakt mit dem Vorrichtungsgehäuse steht, Bestimmen, ob die Spannung zwischen dem Zieldraht und dem Vorrichtungsgehäuse größer als eine erste festgelegte Spannung und kleiner als eine zweite festgelegte Spannung ist, wobei die zweite festgelegte Spannung gleich einer Versorgungsspannung der Vorrichtung minus der ersten festgelegten Spannung ist und die erste festgelegte Spannung kleiner als die zweite festgelegte Spannung ist; und wenn die Spannung zwischen dem Zieldraht und dem Vorrichtungsgehäuse größer als die erste festgelegte Spannung und kleiner als die zweite festgelegte Spannung ist, Bestimmen, dass das Vorrichtungsgehäuse nicht ordnungsgemäß geerdet ist, und Bestimmen, dass die Spannung zwischen dem Zieldraht und dem Vorrichtungsgehäuse die festgelegte Bedingung erfüllt.

16. Detektionsschaltung nach Anspruch 12, wobei das Signalverarbeitungsmodul zu Folgendem konfiguriert ist:

wenn ein Stromversorgungsmodus der Vorrichtung eine einphasige Stromversorgung ist und der Zieldraht der stromführende Draht ist, Bestimmen, ob die Spannung zwischen dem Zieldraht und dem Vorrichtungsgehäuse eine erste Kontaktspannung ist, wobei die erste Kontaktspannung eine Spannung zwischen dem Zieldraht und dem Vorrichtungsgehäuse ist, wenn ein Metallkerndraht in dem Zieldraht in Kontakt mit dem Vorrichtungsgehäuse steht; und

wenn die Spannung zwischen dem Zieldraht und dem Vorrichtungsgehäuse die erste Kontaktspannung ist, Bestimmen, dass das Vorrichtungsgehäuse energetisiert ist, und Bestimmen, dass die Spannung zwischen dem Zieldraht und dem Vorrichtungsgehäuse die festgelegte Bedingung erfüllt; oder

wenn ein Stromversorgungsmodus der Vorrichtung eine einphasige Stromversorgung ist und der Zieldraht der neutrale Draht ist, Bestimmen, ob die Spannung zwischen dem Zieldraht und dem Vorrichtungsgehäuse eine zweite Kontaktspannung ist, wobei die zweite Kontaktspannung eine Spannung zwischen dem Zieldraht und dem Vorrichtungsgehäuse ist, wenn der Metallkerndraht in dem stromführenden Draht, der nicht der Zieldraht ist, in Kontakt mit dem Vorrichtungsgehäuse steht; und wenn die Spannung zwischen dem Zieldraht und dem Vorrichtungsgehäuse die zweite Kontaktspannung ist, Bestimmen, dass das Vorrichtungsgehäuse energetisiert ist, und Bestimmen, dass die Spannung zwischen dem Zieldraht und dem Vorrichtungsgehäuse die festgelegte Bedingung erfüllt.

17. Detektionsschaltung nach Anspruch 16, wobei das Signalverarbeitungsmodul ferner zu Folgendem konfiguriert ist:

wenn der Metallkerndraht in dem stromführenden Draht nicht in Kontakt mit dem Vorrichtungsgehäuse steht und falls die Spannung zwischen dem Zieldraht und dem Vorrichtungsgehäuse kleiner oder gleich einer ersten festgelegten Spannung ist, Bestimmen, dass der Zieldraht der neutrale Draht ist; oder

wenn der Metallkerndraht in dem stromführenden Draht nicht in Kontakt mit dem Vorrichtungsgehäuse steht und falls die Spannung zwischen dem Zieldraht und dem Vorrichtungsgehäuse größer oder gleich einer zweiten festgelegten Spannung ist, Bestimmen, dass der Zieldraht der stromführende Draht ist.

18. Detektionsschaltung nach Anspruch 12, wobei das Signalverarbeitungsmodul zu Folgendem konfiguriert ist:

wenn ein Stromversorgungsmodus der Vorrichtung eine Stromversorgung mit zwei stromführenden Drähten ist, Bestimmen, ob die Spannung zwischen dem Zieldraht und dem Vorrichtungsgehäuse eine erste Kontaktspannung oder eine zweite Kontaktspannung ist; und

wenn die Spannung zwischen dem Zieldraht und dem Vorrichtungsgehäuse die erste Kontaktspannung oder die zweite Kontaktspannung ist, Bestimmen, dass das Vorrichtungsgehäuse energetisiert ist, und Bestimmen, dass die Spannung zwischen dem Zieldraht und dem Vorrichtungsgehäuse die festgelegte Bedingung erfüllt.

19. Detektionsschaltung nach Anspruch 12, wobei das Signalverarbeitungsmodul zu Folgendem konfiguriert ist:

wenn ein Stromversorgungsmodus der Vorrichtung eine dreiphasige Stromversorgung ist, Bestimmen, ob die Spannung zwischen dem Zieldraht und dem Vorrichtungsgehäuse eine erste Kontaktspannung oder eine dritte Kontaktspannung ist, wobei die dritte Kontaktspannung eine Spannung zwischen dem Zieldraht und dem Vorrichtungsgehäuse ist, wenn ein Metallkerndraht in einem beliebigen stromführenden Draht, der nicht der Zieldraht ist, in Kontakt mit dem Vorrichtungsgehäuse steht; und

wenn die Spannung zwischen dem Zieldraht und dem Vorrichtungsgehäuse die erste Kontaktspannung oder die dritte Kontaktspannung ist, Bestimmen, dass das Vorrichtungsgehäuse energetisiert ist, und Bestimmen, dass die Spannung zwischen dem Zieldraht und dem Vorrichtungsgehäuse die festgelegte Bedingung erfüllt.

20. Detektionsschaltung nach Anspruch 12, wobei das Signalverarbeitungsmodul ferner zu Folgendem konfiguriert ist:

wenn ein Stromversorgungsmodus der Vorrichtung eine einphasige Stromversorgung ist und ein Metallkerndraht in dem stromführenden Draht nicht in Kontakt mit dem Vorrichtungsgehäuse steht, Bestimmen, ob die Spannung zwischen dem Zieldraht und dem Vorrichtungsgehäuse kleiner oder gleich einer ersten festgelegten Spannung oder größer oder gleich einer zweiten festgelegten Spannung ist; und

wenn die Spannung zwischen dem Zieldraht und dem Vorrichtungsgehäuse kleiner oder gleich der ersten festgelegten Spannung oder größer oder gleich der zweiten festgelegten Spannung ist, Bestimmen, dass das Vorrichtungsgehäuse ordnungsgemäß geerdet ist.

21. Detektionsverfahren, wobei das Verfahren zum Detektieren einer Vorrichtung verwendet wird und das Verfahren Folgendes umfasst:

Bestimmen einer Spannung zwischen einem Zieldraht und einem Vorrichtungsgehäuse, wobei der Zieldraht dazu konfiguriert ist, die Vorrichtung mit Strom zu versorgen, und wobei der Zieldraht ein stromführender Draht oder ein neutraler Draht ist und das Vorrichtungsgehäuse ein Gehäuse der Vorrichtung ist;

Bestimmen, ob die Spannung zwischen dem Zieldraht und dem Vorrichtungsgehäuse eine festgelegte Bedingung erfüllt, wobei die festgelegte Bedingung dazu verwendet wird, anzugeben, dass in der Vorrichtung ein Fehler auftritt, und der Fehler mindestens eines des Folgenden umfasst: der stromführende Draht und der neutrale Draht, die mit der Vorrichtung verbunden sind, sind invers verbunden, das Vorrichtungsgehäuse ist nicht ordnungsgemäß geerdet und das Vorrichtungsgehäuse ist energetisiert; und

wenn die Spannung zwischen dem Zieldraht und dem Vorrichtungsgehäuse die festgelegte Bedingung erfüllt, Bestimmen, dass der Fehler in der Vorrichtung auftritt;

wobei das Bestimmen, ob die Spannung zwischen dem Zieldraht und dem Vorrichtungsgehäuse eine festgelegte Bedingung erfüllt, Folgendes umfasst:

wenn ein Stromversorgungsmodus der Vorrichtung eine einphasige Stromversorgung ist und ein Metallkerndraht in dem stromführenden Draht nicht in Kontakt mit dem Vorrichtungsgehäuse steht, Bestimmen, ob die Spannung zwischen dem Zieldraht und dem Vorrichtungsgehäuse größer als eine erste festgelegte Spannung und kleiner als eine zweite festgelegte Spannung ist, wobei die zweite festgelegte Spannung gleich einer Versorgungsspannung der Vorrichtung minus der ersten festgelegten Spannung ist und die erste festgelegte Spannung kleiner als die zweite festgelegte Spannung ist; und

wenn die Spannung zwischen dem Zieldraht und dem Vorrichtungsgehäuse größer als die erste festgelegte Spannung und kleiner als die zweite festgelegte zweite Spannung ist, Bestimmen, dass das Vorrichtungsgehäuse nicht ordnungsgemäß geerdet ist, und Bestimmen, dass die Spannung zwischen dem Zieldraht und dem Vorrichtungsgehäuse die festgelegte Bedingung erfüllt.

22. Verfahren nach Anspruch 21, wobei das Bestimmen, ob die Spannung zwischen dem Zieldraht und dem Vorrichtungsgehäuse eine festgelegte Bedingung erfüllt, Folgendes umfasst:

wenn ein Stromversorgungsmodus der Vorrichtung eine einphasige Stromversorgung ist und ein Metallkerndraht in dem stromführenden Draht nicht in Kontakt mit dem Vorrichtungsgehäuse steht, Bestimmen, ob die Spannung zwischen dem Zieldraht und dem Vorrichtungsgehäuse kleiner oder gleich einer ersten festgelegten Spannung ist, wobei die erste festgelegte Spannung eine Spannung zwischen dem neutralen Draht und dem Vorrichtungsgehäuse ist, wenn das Vorrichtungsgehäuse ordnungsgemäß geerdet ist und der Metallkerndraht in dem stromführenden Draht nicht in Kontakt mit dem Vorrichtungsgehäuse steht; und

wenn die Spannung zwischen dem Zieldraht und dem Vorrichtungsgehäuse kleiner oder gleich der ersten festgelegten Spannung ist, Bestimmen, dass der stromführende Draht und der neutrale Draht, die mit der Vorrichtung verbunden sind, invers verbunden sind, und Bestimmen, dass die Spannung zwischen dem Zieldraht und dem Vorrichtungsgehäuse die festgelegte Bedingung erfüllt.

23. Verfahren nach Anspruch 21, wobei das Bestimmen, ob die Spannung zwischen dem Zieldraht und dem Vorrichtungsgehäuse eine festgelegte Bedingung erfüllt, Folgendes umfasst:

wenn ein Stromversorgungsmodus der Vorrichtung eine einphasige Stromversorgung ist und der Zieldraht der stromführende Draht ist, Bestimmen, ob die Spannung zwischen dem Zieldraht und dem Vorrichtungsgehäuse eine erste Kontaktspannung ist, wobei die erste Kontaktspannung eine Spannung zwischen dem Zieldraht und dem Vorrichtungsgehäuse ist, wenn ein Metallkerndraht in dem Zieldraht in Kontakt mit dem Vorrichtungsgehäuse steht; und

wenn die Spannung zwischen dem Zieldraht und dem Vorrichtungsgehäuse die erste Kontaktspannung ist, Bestimmen, dass das Vorrichtungsgehäuse energetisiert ist, und Bestimmen, dass die Spannung zwischen dem Zieldraht und dem Vorrichtungsgehäuse die festgelegte Bedingung erfüllt; oder

wenn ein Stromversorgungsmodus der Vorrichtung eine einphasige Stromversorgung ist und der Zieldraht der neutrale Draht ist, Bestimmen, ob die Spannung zwischen dem Zieldraht und dem Vorrichtungsgehäuse eine zweite Kontaktspannung ist, wobei die zweite Kontaktspannung eine Spannung zwischen dem Zieldraht und dem Vorrichtungsgehäuse ist, wenn ein Metallkerndraht in dem stromführenden Draht, der nicht der Zieldraht ist, in Kontakt mit dem Vorrichtungsgehäuse steht; und wenn die Spannung zwischen dem Zieldraht und dem Vorrichtungsgehäuse die zweite Kontaktspannung ist, Bestimmen, dass das Vorrichtungsgehäuse energetisiert ist, und Bestimmen, dass die Spannung zwischen dem Zieldraht und dem Vorrichtungsgehäuse die festgelegte Bedingung erfüllt.

**24.** Verfahren nach Anspruch 23, das

vor dem Bestimmen, ob die Spannung
zwischen dem Zieldraht und dem Vorrichtungsgehäuse eine festgelegte Bedingung erfüllt, ferner Folgendes umfasst:

wenn der Metallkerndraht in dem stromführenden Draht nicht in Kontakt mit dem Vorrichtungsgehäuse steht und falls die Spannung zwischen dem Zieldraht und dem Vorrichtungsgehäuse kleiner oder gleich einer ersten festgelegten Spannung ist, Bestimmen, dass der Zieldraht der neutrale Draht ist; oder wenn der Metallkerndraht in dem stromführenden Draht nicht in Kontakt mit dem Vorrichtungsgehäuse steht und falls die Spannung zwischen dem Zieldraht und dem Vorrichtungsgehäuse größer oder gleich einer zweiten festgelegten Spannung ist, Bestimmen, dass der Zieldraht der stromführende Draht ist.

**25.** Verfahren nach Anspruch 21, wobei das Bestimmen, ob die Spannung zwischen dem Zieldraht und dem Vorrichtungsgehäuse eine festgelegte Bedingung erfüllt, Folgendes umfasst:

wenn ein Stromversorgungsmodus der Vorrichtung eine Stromversorgung mit zwei stromführenden Drähten ist, Bestimmen, ob die Spannung zwischen dem Zieldraht und dem Vorrichtungsgehäuse eine erste Kontaktspannung oder eine zweite Kontaktspannung ist; und wenn die Spannung zwischen dem Zieldraht und dem Vorrichtungsgehäuse die erste Kontaktspannung oder die zweite Kontaktspannung ist, Bestimmen, dass das Vorrichtungsgehäuse energetisiert ist, und Bestimmen, dass die Spannung zwischen dem Zieldraht und dem Vorrichtungsgehäuse die festgelegte Bedingung erfüllt.

**26.** Verfahren nach Anspruch 21, wobei das Bestimmen, ob die Spannung zwischen dem Zieldraht und dem Vorrichtungsgehäuse eine festgelegte Bedingung erfüllt, Folgendes umfasst:

wenn ein Stromversorgungsmodus der Vorrichtung eine dreiphasige Stromversorgung ist, Bestimmen, ob die Spannung zwischen dem Zieldraht und dem Vorrichtungsgehäuse eine erste Kontaktspannung oder eine dritte Kontaktspannung ist, wobei die dritte Kontaktspannung eine Spannung zwischen dem Zieldraht und dem Vorrichtungsgehäuse ist, wenn ein Metallkerndraht in einem beliebigen stromführenden Draht, der nicht der Zieldraht ist, in Kontakt mit dem Vorrichtungsgehäuse steht; und wenn die Spannung zwischen dem Zieldraht und dem Vorrichtungsgehäuse die erste Kontaktspannung oder die dritte Kontaktspannung ist, Bestimmen, dass das Vorrichtungsgehäuse energetisiert ist, und Bestimmen, dass die Spannung zwischen dem Zieldraht und dem Vorrichtungsgehäuse die festgelegte Bedingung erfüllt.

**27.** Verfahren nach einem der Ansprüche 21 bis 25, wobei das Verfahren ferner Folgendes umfasst:

wenn die Stromversorgungsmodus der Vorrichtung die einphasige Stromversorgung ist und der Metallkerndraht in dem stromführenden Draht nicht in Kontakt mit dem Vorrichtungsgehäuse steht, Bestimmen, ob die Spannung zwischen dem Zieldraht und dem Vorrichtungsgehäuse kleiner oder gleich der ersten festgelegten Spannung oder größer oder gleich der zweiten festgelegten Spannung ist; und wenn die Spannung zwischen dem Zieldraht und dem Vorrichtungsgehäuse kleiner oder gleich der ersten festgelegten Spannung oder größer oder gleich der zweiten festgelegten Spannung ist, Bestimmen, dass das Vorrichtungsgehäuse ordnungsgemäß geerdet ist.

**Revendications**

**1.** Circuit de détection, dans lequel le circuit de détection est conçu pour détecter un dispositif, et le circuit de détection comprend un premier module d'isolement (1), une première résistance (R1), une seconde résistance (R2), un premier module de collecte de signaux (2) et un module de traitement de signaux (3) ;

le premier module d'isolement comprend une première unité d'isolement (1A) et une seconde unité d'isolement (1B), et

une valeur de résistance de la première unité d'isolement est égale à celle de la seconde unité d'isolement ; une extrémité de la première unité d'isolement est reliée à un fil cible (X), et une extrémité de la seconde unité d'isolement est reliée à un boîtier de dispositif (E) ;

le premier module d'isolement est conçu pour isoler le fil cible du boîtier de dispositif, et est conçu pour isoler un circuit principal d'un circuit secondaire, dans lequel le circuit principal comprend le fil cible et une alimentation électrique du dispositif, et le circuit secondaire comprend la première résistance, la seconde résistance, le premier module de collecte de signaux et le module de traitement de signaux ; et le fil cible est conçu pour fournir une alimentation électrique au dispositif, le fil cible est un fil sous tension ou un fil neutre, et le boîtier de dispositif est un boîtier du dispositif ;

une première extrémité d'entrée (2a) du premier module de collecte de signaux et une extrémité de la première résistance sont reliées séparément à l'autre extrémité de la première unité d'isolement, une seconde extrémité d'entrée (2b) du premier module de collecte de signaux et une extrémité de la seconde résistance sont reliées séparément à l'autre extrémité de la seconde unité d'isolement, l'autre extrémité de la première résistance et l'autre extrémité de la seconde résistance sont reliées séparément à une terre de référence (GND), une extrémité de sortie (2c) du premier module de collecte de signaux est reliée à une extrémité d'entrée (3a) du module de traitement du signal, et une extrémité de mise à la terre (3b) du module de traitement de signaux est reliée à la terre de référence ;

la première résistance et la seconde résistance sont conçues pour diviser une tension, et une valeur de résistance de la première résistance est égale à celle de la seconde résistance ; le premier module de collecte de signaux est conçu pour collecter séparément une tension aux deux extrémités de la première résistance et une tension aux deux extrémités de la seconde résistance, déterminer la tension collectée aux deux extrémités de la première résistance en tant que première tension, déterminer la tension collectée aux deux extrémités de la seconde résistance en tant que deuxième tension, et multiplier une différence de tension entre la première tension et la deuxième tension par une proportion spécifiée, pour obtenir une troisième tension dans une plage de détection du module de traitement de signaux, et entrer la troisième tension dans le module de traitement de signaux ; et le module de traitement de signaux est conçu pour : effectuer un traitement inverse sur la troisième tension sur la base d'un processus de traitement d'une tension entre le fil cible et le boîtier de dispositif par le premier module d'isolement, la première résistance, la seconde résistance et le premier module de collecte de signaux, pour obtenir la tension entre le fil cible et le boîtier de dispositif ; et lorsque la tension entre le fil cible et le boîtier de dispositif satisfait à une condition spécifiée, déterminer qu'un défaut se produit dans le dispositif, dans lequel la condition spécifiée est utilisée pour indiquer que le défaut se produit dans le dispositif, et le défaut comprend au moins l'un parmi ce qui suit : le fil sous tension et le fil neutre reliés au dispositif sont reliés de manière inversée, le boîtier de dispositif n'est pas mis à la terre normalement et le boîtier de dispositif est allumé.

2. Circuit de détection selon la revendication 1, dans lequel le circuit de détection comprend en outre un module de conditionnement de signaux, une extrémité d'entrée du module de conditionnement de signaux est reliée à l'extrémité de sortie du premier module de collecte de signaux, et une extrémité de sortie du module de conditionnement de signaux est reliée à l'extrémité d'entrée du module de traitement de signaux ; et le module de conditionnement de signaux est conçu pour conditionner la troisième tension reçue du premier module de collecte de signaux à une tension dans une plage acceptable du module de traitement de signaux, et entrer la troisième tension conditionnée dans le module de traitement de signaux.

3. Circuit de détection selon la revendication 1 ou 2, dans lequel la première unité d'isolement comprend N résistances en série, et une valeur de résistance totale des N résistances en série est supérieure ou égale à une valeur de résistance spécifiée, où N est un nombre naturel supérieur ou égal à 1, et la valeur de résistance spécifiée est une valeur de résistance qui satisfait à l'isolement renforcé requis par une norme de sécurité.

4. Circuit de détection selon la revendication 1 ou 2, dans lequel la seconde unité d'isolement comprend M résistances en série, et une valeur de résistance totale des M résistances en série est supérieure ou égale à une valeur de résistance spécifiée, où M est un nombre naturel supérieur ou égal à 1, et la valeur de résistance spécifiée est une valeur de résistance qui satisfait à l'isolement renforcé requis par une norme de sécurité.

5. Circuit de détection selon la revendication 1, dans lequel le module de traitement de signaux est conçu pour :

lorsqu'un mode d'alimentation électrique du dispositif est une alimentation électrique monophasée et qu'un fil à âme métallique dans le fil sous tension n'est pas en contact avec le boîtier de dispositif, déterminer si la tension entre le fil cible et le boîtier de dispositif est inférieure ou égale à une première tension spécifiée, dans lequel la première tension spécifiée est une tension entre le fil neutre et le boîtier de dispositif lorsque le boîtier de dispositif est mis à la terre normalement et que le fil à âme métallique dans le fil sous tension n'est pas en contact avec le boîtier de dispositif ; et lorsque la tension entre le fil cible et le boîtier de dispositif est inférieure ou égale à la première tension spécifiée, déterminer que le fil sous tension et le fil neutre reliés au dispositif sont reliés de manière inversée, et déterminer que la tension entre le fil cible et le boîtier de dispositif satisfait à la condition spécifiée.

**6.** Circuit de détection selon la revendication 1, dans lequel le module de traitement de signaux est conçu pour :

lorsqu'un mode d'alimentation électrique du dispositif est une alimentation électrique monophasée et qu'un fil à âme métallique dans le fil sous tension n'est pas en contact avec le boîtier de dispositif, déterminer si la tension entre le fil cible et le boîtier de dispositif est supérieure à une première tension spécifiée et inférieure à une deuxième tension spécifiée, dans lequel la deuxième tension spécifiée est égale à une tension d'alimentation du dispositif moins la première tension spécifiée, et la première tension spécifiée est inférieure à la deuxième tension spécifiée ; et

lorsque la tension entre le fil cible et le boîtier de dispositif est supérieure à la première tension spécifiée et inférieure à la deuxième tension spécifiée, déterminer que le boîtier de dispositif n'est pas mis à la terre normalement, et déterminer que la tension entre le fil cible et le boîtier de dispositif satisfait à la condition spécifiée.

**7.** Circuit de détection selon la revendication 1, dans lequel le module de traitement de signaux est conçu pour :

lorsqu'un mode d'alimentation électrique du dispositif est une alimentation électrique monophasée et que le fil cible est le fil sous tension, déterminer si la tension entre le fil cible et le boîtier de dispositif est une première tension de contact, dans lequel la première tension de contact est une tension entre le fil cible et le boîtier de dispositif lorsqu'un fil à âme métallique dans le fil cible est en contact avec le boîtier de dispositif ; et lorsque la tension entre le fil cible et le boîtier de dispositif est la première tension de contact, déterminer que le boîtier de dispositif est allumé, et déterminer que la tension entre le fil cible et le boîtier de dispositif satisfait à la condition spécifiée ; ou

lorsqu'un mode d'alimentation électrique du dispositif est une alimentation électrique monophasée et que le fil cible est le fil neutre, déterminer si la tension entre le fil cible et le boîtier de dispositif est une deuxième tension de contact, dans lequel la deuxième tension de contact est une tension entre le fil cible et le boîtier de dispositif lorsqu'un fil à âme métallique dans le fil sous tension différent du fil cible est en contact avec le boîtier de dispositif ; et lorsque la tension entre le fil cible et le boîtier de dispositif est la deuxième tension de contact, déterminer que le boîtier de dispositif est allumé, et déterminer que la tension entre le fil cible et le boîtier de dispositif satisfait à la condition spécifiée.

**8.** Circuit de détection selon la revendication 7, dans lequel le module de traitement de signaux est en outre conçu pour :

lorsque le fil à âme métallique dans le fil sous tension n'est pas en contact avec le boîtier de dispositif, si la tension entre le fil cible et le boîtier de dispositif est inférieure ou égale à une première tension spécifiée, déterminer que le fil cible est le fil neutre ; ou

lorsque le fil à âme métallique dans le fil sous tension n'est pas en contact avec le boîtier de dispositif, si la tension entre le fil cible et le boîtier de dispositif est supérieure ou égale à une deuxième tension spécifiée, déterminer que le fil cible est le fil sous tension.

**9.** Circuit de détection selon la revendication 1, dans lequel le module de traitement de signaux est conçu pour :

lorsqu'un mode d'alimentation électrique du dispositif est une alimentation électrique à deux fils sous tension, déterminer si la tension entre le fil cible et le boîtier de dispositif est une première tension de contact ou une deuxième tension de contact ; et

lorsque la tension entre le fil cible et le boîtier de dispositif est la première tension de contact ou la deuxième tension de contact, déterminer que le boîtier de dispositif est allumé, et déterminer que la tension entre le fil cible et le boîtier de dispositif satisfait à la condition spécifiée.

**10.** Circuit de détection selon la revendication 1, dans lequel le module de traitement de signaux est conçu pour :

lorsqu'un mode d'alimentation électrique du dispositif est une alimentation électrique triphasée, déterminer si la tension entre le fil cible et le boîtier de dispositif est une première tension de contact ou une troisième tension de contact, dans lequel la troisième tension de contact est une tension entre le fil cible et le boîtier de dispositif lorsqu'un fil à âme métallique dans un fil sous tension différent du fil cible est en contact avec le boîtier de dispositif ; et

lorsque la tension entre le fil cible et le boîtier de dispositif est la première tension de contact ou la troisième tension de contact, déterminer que le boîtier de dispositif est allumé, et déterminer que la tension entre le fil cible et le boîtier de dispositif satisfait à la condition spécifiée.

**11.** Circuit de détection selon la revendication 1, dans lequel le module de traitement de signaux est en outre conçu pour :

lorsqu'un mode d'alimentation électrique du dispositif est une alimentation électrique monophasée et qu'un fil à âme métallique dans le fil sous tension n'est pas en contact avec le boîtier de dispositif, déterminer si la tension entre le fil cible et le boîtier de dispositif est inférieure ou égale à une première tension spécifiée, ou supérieure ou égale à une deuxième tension spécifiée ; et
lorsque la tension entre le fil cible et le boîtier de dispositif est inférieure ou égale à la première tension spécifiée, ou supérieure ou égale à la deuxième tension spécifiée, déterminer que le boîtier de dispositif est mis à la terre normalement.

**12.** Circuit de détection, dans lequel le circuit de détection est conçu pour détecter un dispositif, et le circuit de détection comprend un second module d'isolement (5), une dixième résistance (R10), un second module de collecte de signaux (6), et un module de traitement de signaux (3) ;

et une extrémité du second module d'isolement est reliée à un fil cible (X), une extrémité d'entrée (6a) du second module de collecte de signaux et une extrémité de la dixième résistance sont reliées séparément à l'autre extrémité du second module d'isolement, l'autre extrémité de la dixième résistance est reliée à une terre de référence (GND), la terre de référence est
reliée à un boîtier de dispositif (E), une extrémité de sortie (6b) du second module de collecte de signaux est reliée à une extrémité d'entrée (4a) d'un module de conditionnement de signaux (4), et une extrémité de mise à la terre (3b) du module de traitement de signaux est reliée à la terre de référence ; et
le fil cible est conçu pour alimenter électriquement le dispositif, le fil cible est un fil sous tension ou un fil neutre, et le boîtier de dispositif est un boîtier du dispositif ; la dixième résistance est conçue pour diviser une tension, le second module d'isolement est conçu pour isoler le fil cible du boîtier de dispositif, et est conçu pour isoler un circuit principal d'un circuit secondaire, dans lequel le circuit principal comprend le fil cible et une alimentation électrique du dispositif, et le circuit secondaire comprend la dixième résistance, le second module de collecte de signaux et le module de traitement de signaux ; et le second module de collecte de signaux est conçu pour collecter une tension aux deux extrémités de la dixième résistance, déterminer la tension collectée aux deux extrémités de la dixième résistance en tant que quatrième tension, et entrer la quatrième tension dans le module de traitement de signaux ; et
le module de traitement de signaux est conçu pour : effectuer un traitement inverse sur la quatrième tension sur la base d'un processus de traitement d'une tension entre le fil cible et le boîtier de dispositif par le second module d'isolement, la dixième résistance et le second module de collecte de signaux, pour obtenir la tension entre le fil cible et le boîtier de dispositif ; et lorsque la tension entre le fil cible et le boîtier de dispositif satisfait à une condition spécifiée, déterminer qu'un défaut se produit dans le dispositif, dans lequel la condition spécifiée est utilisée pour indiquer que le défaut se produit dans le dispositif, et le défaut comprend au moins l'un parmi ce qui suit : le fil sous tension et le fil neutre reliés au dispositif sont reliés de manière inversée, le boîtier de dispositif n'est pas mis à la terre normalement et le boîtier de dispositif est allumé ; dans lequel
une extrémité de sortie (4b) du module de conditionnement de signaux est reliée à une extrémité d'entrée (3a) du module de traitement de signaux ; et
le module de conditionnement de signaux est conçu pour conditionner la quatrième tension reçue par le second module de collecte de signaux à une tension dans une plage acceptable du module de traitement de signaux, et entrer la quatrième tension conditionnée dans le module de traitement de signaux.

**13.** Circuit de détection selon la revendication 12, dans lequel le second module d'isolement comprend N résistances en série, et une valeur de résistance totale des N résistances en série est supérieure ou égale à une valeur de résistance spécifiée, où N est un nombre naturel supérieur ou égal à 1, et la valeur de résistance spécifiée est une valeur de résistance qui satisfait à l'isolement renforcé requis par une norme de sécurité.

**14.** Circuit de détection selon la revendication 12, dans lequel le module de traitement de signaux est conçu pour :

lorsqu'un mode d'alimentation électrique du dispositif est une alimentation électrique monophasée et qu'un fil à âme métallique dans le fil sous tension n'est pas en contact avec le boîtier de dispositif, déterminer si la tension entre le fil cible et le boîtier de dispositif est inférieure ou égale à une première tension spécifiée, dans lequel la première tension spécifiée est une tension entre le fil neutre et le boîtier de dispositif lorsque le boîtier de dispositif est mis à la terre normalement et que le fil à âme métallique dans le fil sous tension n'est pas en contact avec le boîtier de dispositif ; et

lorsque la tension entre le fil cible et le boîtier de dispositif est inférieure ou égale à la première tension spécifiée, déterminer que le fil sous tension et le fil neutre reliés au dispositif sont reliés de manière inversée, et déterminer que la tension entre le fil cible et le boîtier de dispositif satisfait à la condition spécifiée.

**15.** Circuit de détection selon la revendication 12, dans lequel le module de traitement de signaux est conçu pour :

lorsqu'un mode d'alimentation électrique du dispositif est une alimentation électrique monophasée et qu'un fil à âme métallique dans le fil sous tension n'est pas en contact avec le boîtier de dispositif, déterminer si la tension entre le fil cible et le boîtier de dispositif est supérieure à une première tension spécifiée et inférieure à une deuxième tension spécifiée, dans lequel la deuxième tension spécifiée est égale à une tension d'alimentation du dispositif moins la première tension spécifiée, et la première tension spécifiée est inférieure à la deuxième tension spécifiée ; et

lorsque la tension entre le fil cible et le boîtier de dispositif est supérieure à la première tension spécifiée et inférieure à la deuxième tension spécifiée, déterminer que le boîtier de dispositif n'est pas mis à la terre normalement, et déterminer que la tension entre le fil cible et le boîtier de dispositif satisfait à la condition spécifiée.

**16.** Circuit de détection selon la revendication 12, dans lequel le module de traitement de signaux est conçu pour :

lorsqu'un mode d'alimentation électrique du dispositif est une alimentation électrique monophasée et que le fil cible est le fil sous tension, déterminer si la tension entre le fil cible et le boîtier de dispositif est une première tension de contact, dans lequel la première tension de contact est une tension entre le fil cible et le boîtier de dispositif lorsqu'un fil à âme métallique dans le fil cible est en contact avec le boîtier de dispositif ; et lorsque la tension entre le fil cible et le boîtier de dispositif est la première tension de contact, déterminer que le boîtier de dispositif est allumé, et déterminer que la tension entre le fil cible et le boîtier de dispositif satisfait à la condition spécifiée ; ou

lorsqu'un mode d'alimentation électrique du dispositif est une alimentation électrique monophasée et que le fil cible est le fil neutre, déterminer si la tension entre le fil cible et le boîtier de dispositif est une deuxième tension de contact, dans lequel la deuxième tension de contact est une tension entre le fil cible et le boîtier de dispositif lorsque le fil à âme métallique dans le fil sous tension différent du fil cible est en contact avec le boîtier de dispositif ; et lorsque la tension entre le fil cible et le boîtier de dispositif est la deuxième tension de contact, déterminer que le boîtier de dispositif est allumé, et déterminer que la tension entre le fil cible et le boîtier de dispositif satisfait à la condition spécifiée.

**17.** Circuit de détection selon la revendication 16, dans lequel le module de traitement de signaux est en outre conçu pour : lorsque le fil à âme métallique dans le fil sous tension n'est pas en contact avec le boîtier de dispositif, si la tension entre le fil cible et le boîtier de dispositif est inférieure ou égale à une première tension spécifiée, déterminer que le fil cible est le fil neutre ; ou

lorsque le fil à âme métallique dans le fil sous tension n'est pas en contact avec le boîtier de dispositif, si la tension entre le fil cible et le boîtier de dispositif est supérieure ou égale à une deuxième tension spécifiée, déterminer que le fil cible est le fil sous tension.

**18.** Circuit de détection selon la revendication 12, dans lequel le module de traitement de signaux est conçu pour :

lorsqu'un mode d'alimentation électrique du dispositif est une alimentation électrique à deux fils sous tension, déterminer si la tension entre le fil cible et le boîtier de dispositif est une première tension de contact ou une deuxième tension de contact ; et

lorsque la tension entre le fil cible et le boîtier de dispositif est la première tension de contact ou la deuxième tension de contact, déterminer que le boîtier de dispositif est allumé, et déterminer que la tension entre le fil cible et le boîtier de dispositif satisfait à la condition spécifiée.

**19.** Circuit de détection selon la revendication 12, dans lequel le module de traitement de signaux est conçu pour :

lorsqu'un mode d'alimentation électrique du dispositif est une alimentation électrique triphasée, déterminer si la tension entre le fil cible et le boîtier de dispositif est une première tension de contact ou une troisième tension de contact, dans lequel la troisième tension de contact est une tension entre le fil cible et le boîtier de dispositif lorsqu'un fil à âme métallique dans un fil sous tension différent du fil cible est en contact avec le boîtier de dispositif ; et

lorsque la tension entre le fil cible et le boîtier de dispositif est la première tension de contact ou la troisième tension de contact, déterminer que le boîtier de dispositif est allumé, et

déterminer que la tension entre le fil cible et le boîtier de dispositif satisfait à la condition spécifiée.

20. Circuit de détection selon la revendication 12, dans lequel le module de traitement de signaux est en outre conçu pour :

lorsqu'un mode d'alimentation électrique du dispositif est une alimentation électrique monophasée et qu'un fil à âme métallique dans le fil sous tension n'est pas en contact avec le boîtier de dispositif, déterminer si la tension entre le fil cible et le boîtier de dispositif est inférieure ou égale à une première tension spécifiée, ou supérieure ou égale à une deuxième tension spécifiée ; et

lorsque la tension entre le fil cible et le boîtier de dispositif est inférieure ou égale à la première tension spécifiée, ou supérieure ou égale à la deuxième tension spécifiée, déterminer que le boîtier de dispositif est mis à la terre normalement.

21. Procédé de détection, dans lequel le procédé est utilisé pour détecter un dispositif, et le procédé comprend :

la détermination d'une tension entre un fil cible et un boîtier de dispositif, dans lequel le fil cible est conçu pour alimenter électriquement le dispositif, le fil cible est un fil sous tension ou un fil neutre, et le boîtier de dispositif est un boîtier du dispositif ;

le fait de déterminer si la tension entre le fil cible et le boîtier de dispositif satisfait à une condition spécifiée, dans lequel la condition spécifiée est utilisée pour indiquer qu'un défaut se produit dans le dispositif, et le défaut comprend au moins l'un parmi ce qui suit : le fil sous tension et le fil neutre reliés au dispositif sont reliés de manière inversée, le boîtier de dispositif n'est pas mis à la terre normalement et le boîtier de dispositif est allumé ; et

lorsque la tension entre le fil cible et le boîtier de dispositif satisfait à la condition spécifiée, le fait de déterminer que le défaut se produit dans le dispositif ;

dans lequel le fait de déterminer si la tension entre le fil cible et le boîtier de dispositif satisfait à une condition spécifiée comprend :

lorsqu'un mode d'alimentation électrique du dispositif est une alimentation électrique monophasée et qu'un fil à âme métallique dans le fil sous tension n'est pas en contact avec le boîtier de dispositif, le fait de déterminer si la tension entre le fil cible et le boîtier de dispositif est supérieure à une première tension spécifiée et inférieure à une deuxième tension spécifiée, dans lequel la deuxième tension spécifiée est égale à une tension d'alimentation du dispositif moins la première tension spécifiée, et la première tension spécifiée est inférieure à la deuxième tension spécifiée ; et

lorsque la tension entre le fil cible et le boîtier de dispositif est supérieure à la première tension spécifiée et inférieure à la deuxième tension spécifiée, le fait de déterminer que le boîtier de dispositif n'est pas mis à la terre normalement, et le fait de déterminer que la tension entre le fil cible et le boîtier de dispositif satisfait à la condition spécifiée.

22. Procédé selon la revendication 21, dans lequel le fait de déterminer si la tension entre le fil cible et le boîtier de dispositif satisfait à une condition spécifiée comprend :

lorsqu'un mode d'alimentation électrique du dispositif est une alimentation électrique monophasée et qu'un fil à âme métallique dans le fil sous tension n'est pas en contact avec le boîtier de dispositif, le fait de déterminer si la tension entre le fil cible et le boîtier de dispositif est inférieure ou égale à une première tension spécifiée, dans lequel la première tension spécifiée est une tension entre le fil neutre et le boîtier de dispositif lorsque le boîtier de dispositif est mis à la terre normalement et que le fil à âme métallique dans le fil sous tension n'est pas en contact avec le boîtier de dispositif ; et

lorsque la tension entre le fil cible et le boîtier de dispositif est inférieure ou égale à la première tension spécifiée, le fait de déterminer que le fil sous tension et le fil neutre reliés au dispositif sont reliés de manière inversée, et le fait de déterminer que la tension entre le fil cible et le boîtier de dispositif satisfait à la condition spécifiée.

23. Procédé selon la revendication 21, dans lequel le fait de déterminer si la tension entre le fil cible et le boîtier de dispositif satisfait à une condition spécifiée comprend :

lorsqu'un mode d'alimentation électrique du dispositif est une alimentation électrique monophasée et que le fil cible est le fil sous tension, le fait de déterminer si la tension entre le fil cible et le boîtier de dispositif est une première tension de contact, dans lequel la première tension de contact est une tension entre le fil cible et le boîtier de dispositif lorsqu'un fil à âme métallique dans le fil cible est en contact avec le boîtier de dispositif ; et

lorsque la tension entre le fil cible et le boîtier de dispositif est la première tension de contact, le fait de déterminer que le boîtier de dispositif est allumé, et le fait de déterminer que la tension entre le fil cible et le boîtier de dispositif satisfait à la condition spécifiée ; ou

lorsqu'un mode d'alimentation électrique du dispositif est une alimentation électrique monophasée et que le fil cible est le fil neutre, le fait de déterminer si la tension entre le fil cible et le boîtier de dispositif est une deuxième tension de contact, dans lequel la deuxième tension de contact est une tension entre le fil cible et le boîtier de dispositif lorsque le fil à âme métallique dans le fil sous tension différent du fil cible est en contact avec le boîtier de dispositif ; et

lorsque la tension entre le fil cible et le boîtier de dispositif est la deuxième tension de contact, le fait de déterminer que le boîtier de dispositif est allumé, et le fait de déterminer que la tension entre le fil cible et le boîtier de dispositif satisfait à la condition spécifiée.

24. Procédé selon la revendication 23,
avant le fait de déterminer si la tension entre le fil cible et le boîtier de dispositif satisfait à une condition spécifiée, comprenant en outre :

lorsque le fil à âme métallique dans le fil sous tension n'est pas en contact avec le boîtier de dispositif, si la tension entre le fil cible et le boîtier de dispositif est inférieure ou égale à une première tension spécifiée, le fait de déterminer que le fil cible est le fil neutre ; ou

lorsque le fil à âme métallique dans le fil sous tension n'est pas en contact avec le boîtier de dispositif, si la tension entre le fil cible et le boîtier de dispositif est supérieure ou égale à une deuxième tension spécifiée, le fait de déterminer que le fil cible est le fil sous tension.

25. Procédé selon la revendication 21, dans lequel le fait de déterminer si la tension entre le fil cible et le boîtier de dispositif satisfait à une condition spécifiée comprend :

lorsqu'un mode d'alimentation électrique du dispositif est une alimentation électrique à deux fils sous tension, le fait de déterminer si la tension entre le fil cible et le boîtier de dispositif est une première tension de contact ou une deuxième tension de contact ; et

lorsque la tension entre le fil cible et le boîtier de dispositif est la première tension de contact ou la deuxième tension de contact, le fait de déterminer que le boîtier de dispositif est allumé, et le fait de déterminer que la tension entre le fil cible et le boîtier de dispositif satisfait à la condition spécifiée.

26. Procédé selon la revendication 21, dans lequel le fait de déterminer si la tension entre le fil cible et le boîtier de dispositif satisfait à une condition spécifiée comprend :

lorsqu'un mode d'alimentation électrique du dispositif est une alimentation électrique triphasée, le fait de déterminer si la tension entre le fil cible et le boîtier de dispositif est une première tension de contact ou une troisième tension de contact, dans lequel la troisième tension de contact est une tension entre le fil cible et le boîtier de dispositif lorsqu'un fil à âme métallique dans un fil sous tension différent du fil cible est en contact avec le boîtier de dispositif ; et

lorsque la tension entre le fil cible et le boîtier de dispositif est la première tension de contact ou la troisième tension de contact, le fait de déterminer que le boîtier de dispositif est allumé, et le fait de déterminer que la tension entre le fil cible et le boîtier de dispositif satisfait à la condition spécifiée.

27. Procédé selon l'une quelconque des revendications 21 à 25, dans lequel le procédé comprend en outre :

lorsque le mode d'alimentation électrique du dispositif est l'alimentation électrique monophasée et que le fil à âme métallique dans le fil sous tension n'est pas en contact avec le boîtier de dispositif, le fait de déterminer si la tension entre le fil cible et le boîtier de dispositif est inférieure ou égale à la première tension spécifiée, ou supérieure ou égale à la deuxième tension spécifiée ; et

lorsque la tension entre le fil cible et le boîtier de dispositif est inférieure ou égale à la première tension spécifiée, ou supérieure ou égale à la deuxième tension spécifiée, le fait de déterminer que le boîtier de dispositif est mis à la terre normalement.

FIG. 1

FIG. 2

FIG. 3

FIG. 4

FIG. 5

FIG. 6

FIG. 7

FIG. 8

FIG. 9

FIG. 10

FIG. 11

FIG. 12

FIG. 13

FIG. 14

Determine a voltage between a target wire and a device housing, where the target wire is configured to supply power to a device, the target wire is a live wire or a neutral wire, and the device housing is a housing of the device ⌇ 1501

Determine whether the voltage between the target wire and the device housing satisfies a specified condition, and when the voltage between the target wire and the device housing satisfies the specified condition, determine that a fault occurs in the device, where the specified condition is used to indicate that the fault occurs in the device, and the fault includes at least one of the following: the live wire and the neutral wire connected to the device are inversely connected, the device housing is not normally grounded, and the device housing is energized ⌇ 1502

FIG. 15

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2007223155 A1
- US 2015226779 A1

- CN 1851484 A